# EUROPEAN PATENT APPLICATION

(11) **EP 4 474 523 A1**
(43) Date of publication of application: **11.12.2024**
(21) Application number: 23747161.0
(22) Date of filing: 30.01.2023
(51) Int. Cl.: C23C 14/04, H05B 33/10, H10K 50/00

(54) **VAPOR DEPOSITION MASK, VAPOR DEPOSITION MASK WITH FRAME, METHOD FOR MANUFACTURING VAPOR DEPOSITION MASK, METHOD FOR MANUFACTURING ORGANIC DEVICE, AND METHOD FOR MANUFACTURING VAPOR DEPOSITION MASK WITH FRAME**

(30) Priority: 31.01.2022 JP 2022013734
(71) Applicant: Dai Nippon Printing Co., Ltd., Tokyo 162-8001 (JP)
(72) Inventor: IKENAGA, Chikao, Tokyo 162-8001 (JP)
(74) Representative: Müller-Boré & Partner Patentanwälte PartG mbB
(86) International application number: PCT/JP2023/002944
(87) International publication number: WO 2023/145951

(57) **Abstract**

A vapor deposition mask according to the present disclosure includes a mask substrate that contains silicon, a mask layer that includes a first surface and a second surface that is located opposite the first surface and that faces the mask substrate, a through-hole that extends through the mask layer. The mask substrate includes a substrate opening. The through-hole is located in the substrate opening in a plan view. The mask layer includes a mask body layer that forms the first surface and a mask intermediate layer that is located between the mask body layer and the mask substrate. The mask body layer contains a metal material.

## Description

### TECHNICAL FIELD

The present disclosure relates to a vapor deposition mask, a framed vapor deposition mask, a method of manufacturing a vapor deposition mask, a method of manufacturing an organic device, and a framed vapor deposition mask.

### BACKGROUND ART

Display devices that are used by mobile devices such as smart phones or tablets are preferably high definition devices, and pixel density, for example, is preferably 400 ppi or more. The mobile devices are increasingly demanded so as to be compatible with ultra-high definition (UHD). In this case, for example, the pixel density of the display devices is preferably 800 ppi or more.

Attention is paid to an organic EL display device as an example of an organic device among the display devices because of good responsiveness, low power consumption, and high contrast. A method of forming pixels in a desired pattern by using a vapor deposition mask that includes through-holes that are arranged in a desired pattern is known as a method of forming the pixels of the organic EL display device. Specifically, the vapor deposition mask is first combined with a vapor deposition substrate for the organic EL display device. Subsequently, a vapor deposition material that contains an organic material is deposited on the vapor deposition substrate via the through-holes of the vapor deposition mask. Consequently, a vapor deposition layer (or a light-emitting layer of the organic EL display device) that contains the vapor deposition material can be formed as the pixels on the vapor deposition substrate in the same pattern as that of the through-holes of the vapor deposition mask (see, for example, PTL 1 to PTL 3).

A method of forming through-holes in a metal plate by performing an etching process in which a photolithography technique is used is known as an example of a method of manufacturing the vapor deposition mask.
PTL 1: Japanese Patent No. 5382259
PTL 2: Korean patent 10-1812772
PTL 3: Japanese Unexamined Patent Application Publication No. 2010-116579

### SUMMARY

It is an object of the present disclosure to provide a vapor deposition mask, a framed vapor deposition mask, a method of manufacturing a vapor deposition mask, a method of manufacturing an organic device, and a method of manufacturing a framed vapor deposition mask that can improve definition.

A vapor deposition mask according to the present disclosure includes a mask substrate that contains silicon, a mask layer that includes a first surface and a second surface that is located opposite the first surface and that faces the mask substrate, a through-hole that extends through the mask layer. The mask substrate includes a substrate opening. The through-hole is located in the substrate opening in a plan view. The mask layer includes a mask body layer that forms the first surface and a mask intermediate layer that is located between the mask body layer and the mask substrate. The mask body layer contains a metal material.

A framed vapor deposition mask according to the present disclosure includes the vapor deposition mask described above and a frame that supports the mask substrate of the vapor deposition mask.

A method of manufacturing a vapor deposition mask according to the present disclosure includes a substrate preparation step of preparing a mask substrate that contains silicon, a mask layer formation step, a substrate opening formation step, and a through-hole formation step. At the mask layer formation step, a mask layer that includes a first surface and a second surface that is located opposite the first surface and that faces the mask substrate on the mask substrate is formed. At the substrate opening formation step, a substrate opening in the mask substrate is formed. At the through-hole formation step, a through-hole that extends through the mask layer is formed. The through-hole is located in the substrate opening in a plan view. The mask layer formation step includes a mask intermediate layer formation step of forming a mask intermediate layer on a surface of the mask substrate facing the mask layer and a mask body layer formation step of forming a mask body layer on a surface of the mask intermediate layer opposite the mask substrate. The mask body layer contains a metal material.

A method of manufacturing a vapor deposition mask according to the present disclosure includes a substrate preparation step of preparing a mask substrate that contains silicon, a mask layer formation step, a substrate opening formation step, and a mask layer opening formation step. At the mask layer formation step, a mask layer that includes a first surface and a second surface that is located opposite the first surface and that faces the mask substrate on the mask substrate is formed. At the substrate opening formation step, a substrate opening in the mask substrate is formed. At the mask layer opening formation step, a mask layer opening in the mask layer along the substrate opening in a plan view is formed. The mask layer formation step includes a mask intermediate layer formation step of forming a mask intermediate layer on a surface of the mask substrate facing the mask layer and a mask body layer formation step of forming a mask body layer on a surface of the mask intermediate layer opposite the mask substrate and of forming a through-hole that extends through the mask body layer. At the mask layer opening formation step, the mask layer opening is formed in the mask intermediate layer. The through-hole is located in the substrate opening in a plan view. The mask body layer contains a metal material.

A method of manufacturing an organic EL device according to the present disclosure includes a vapor deposition mask preparation step of preparing the vapor deposition mask by using the method of manufacturing the vapor deposition mask described above, a close contact step, and a vapor deposition step. At the close contact step, the first surface of a metal layer of the vapor deposition mask is caused to come into close contact with a vapor deposition substrate. At the vapor deposition step, a vapor deposition layer is formed in a manner in which a vapor deposition material is deposited on the vapor deposition substrate via the through-hole of the vapor deposition mask.

A method of manufacturing a framed vapor deposition mask according to the present disclosure includes a vapor deposition mask preparation step of preparing the vapor deposition mask by using the method of manufacturing the vapor deposition mask described above, and a frame attachment step of attaching a frame to the mask substrate of the vapor deposition mask.

According to the present disclosure, definition can be improved.

### BRIEF DESCRIPTION OF DRAWINGS

Fig. 1 illustrates a vapor deposition apparatus that includes a vapor deposition mask according to an embodiment of the present disclosure.
Fig. 2 illustrates a plan view of the vapor deposition mask according to the embodiment of the present disclosure.
Fig. 3 schematically illustrates a section taken along a line A-A in Fig. 2.
Fig. 4 illustrates an enlarged plan view of a portion of the vapor deposition mask in Fig. 2.
Fig. 5A illustrates an enlarged plan view of a portion of a through-hole group of the vapor deposition mask in Fig. 4.
Fig. 5B illustrates an enlarged plan view of a portion of a modification to the through-hole group in Fig. 5A.
Fig. 6 illustrates a substrate preparation step in a method of manufacturing the vapor deposition mask according to the embodiment of the present disclosure.
Fig. 7 illustrates a second metal layer formation step in the method of manufacturing the vapor deposition mask according to the embodiment of the present disclosure.
Fig. 8 illustrates a first metal layer formation step in the method of manufacturing the vapor deposition mask according to the embodiment of the present disclosure.
Fig. 9 illustrates a resist layer formation step at a substrate opening formation step in the method of manufacturing the vapor deposition mask according to the embodiment of the present disclosure.
Fig. 10 illustrates a substrate etching step at the substrate opening formation step in the method of manufacturing the vapor deposition mask according to the embodiment of the present disclosure.
Fig. 11A illustrates a step of forming a first recessed portion at the substrate etching step in Fig. 10.
Fig. 11B illustrates a step of forming a first protection layer at the substrate etching step in Fig. 10.
Fig. 11C illustrates a step of forming a second recessed portion at the substrate etching step in Fig. 10.
Fig. 11D illustrates a step of forming a second protection layer at the substrate etching step in Fig. 10.
Fig. 11E illustrates a step of forming a fourth recessed portion at the substrate etching step in Fig. 10.
Fig. 12 illustrates a resist layer removal step at the substrate opening formation step in the method of manufacturing the vapor deposition mask according to the embodiment of the present disclosure.
Fig. 13A illustrates a state in which a metal layer is irradiated with laser light at a through-hole formation step, in the method of manufacturing the vapor deposition mask according to the embodiment of the present disclosure.
Fig. 13B illustrates a modification to Fig. 13A.
Fig. 13C schematically illustrates laser light generation device in Fig. 13B.
Fig. 14 illustrates a state in which the through-hole is formed at the through-hole formation step, in the method of manufacturing the vapor deposition mask according to the embodiment of the present disclosure.
Fig. 15A illustrates a plan view of an example of an organic EL display device that is manufactured by using the vapor deposition mask according to the embodiment of the present disclosure and illustrates an organic layer that is deposited at a vapor deposition step.
Fig. 15B illustrates a sectional view of the organic EL display device in Fig. 15A viewed in a B-B direction.
Fig. 16 schematically illustrates a section of a modification to the vapor deposition mask illustrated in Fig. 3.
Fig. 17 illustrates the resist layer formation step in the method of manufacturing the vapor deposition mask illustrated in Fig. 16.
Fig. 18 illustrates a first metal layer formation step in the method of manufacturing the vapor deposition mask illustrated in Fig. 16.
Fig. 19 illustrates the resist layer removal step in the method of manufacturing the vapor deposition mask illustrated in Fig. 16.
Fig. 20 illustrates the substrate opening formation step in the method of manufacturing the vapor deposition mask illustrated in Fig. 16.
Fig. 21 illustrates a mask layer opening formation step in the method of manufacturing the vapor deposition mask illustrated in Fig. 16.
Fig. 22A schematically illustrates a modification to the vapor deposition mask illustrated in Fig. 3.
Fig. 22B schematically illustrates another modification to the vapor deposition mask illustrated in Fig. 3.
Fig. 23 illustrates a plan view of a modification to the vapor deposition mask illustrated in Fig. 2.
Fig. 24 illustrates an enlarged plan view of a portion of a modification to the vapor deposition mask illustrated in Fig. 4.
Fig. 25 illustrates a plan view of a modification to the vapor deposition mask illustrated in Fig. 2.
Fig. 26 schematically illustrates a section taken along a line C-C in Fig. 25.
Fig. 27 illustrates a plan view of a modification to the vapor deposition mask illustrated in Fig. 25.
Fig. 28 illustrates a plan view of a modification to the vapor deposition mask illustrated in Fig. 25.
Fig. 29 illustrates an enlarged plan view of a modification to the substrate opening of the vapor deposition mask according to the embodiment of the present disclosure.
Fig. 30 illustrates an enlarged plan view of another modification to the substrate opening of the vapor deposition mask according to the embodiment of the present disclosure.
Fig. 31 illustrates an enlarged plan view of another modification to the substrate opening of the vapor deposition mask according to the embodiment of the present disclosure.
Fig. 32 illustrates a plan view of a modification to the vapor deposition mask illustrated in Fig. 25.
Fig. 33 schematically illustrates a section taken along a line D-D in Fig. 32.
Fig. 34 schematically illustrates a section of another modification to the vapor deposition mask illustrated in Fig. 3.
Fig. 35 illustrates a plan view of another modification to the vapor deposition mask illustrated in Fig. 25.
Fig. 36 schematically illustrates a section taken along a line E-E in Fig. 35.
Fig. 37 illustrates a plan view of another modification to the vapor deposition mask illustrated in Fig. 25.
Fig. 38 schematically illustrates a section taken along a line F-F in Fig. 37.
Fig. 39 illustrates an insulating layer formation step in the method of manufacturing the vapor deposition mask illustrated in Fig. 38.
Fig. 40 illustrates an insulating opening formation step in the method of manufacturing the vapor deposition mask illustrated in Fig. 38.
Fig. 41 illustrates the first metal layer formation step in the method of manufacturing the vapor deposition mask illustrated in Fig. 38.
Fig. 42 illustrates a polishing step in the method of manufacturing the vapor deposition mask illustrated in Fig. 38.
Fig. 43 illustrates a first mask protection layer formation step in the method of manufacturing the vapor deposition mask illustrated in Fig. 38.
Fig. 44 illustrates an insulating layer removal step in the method of manufacturing the vapor deposition mask illustrated in Fig. 38.
Fig. 45 illustrates a second mask protection layer formation step in the method of manufacturing the vapor deposition mask illustrated in Fig. 38.
Fig. 46 illustrates the substrate opening formation step in the method of manufacturing the vapor deposition mask illustrated in Fig. 38.
Fig. 47 illustrates the mask layer opening formation step in the method of manufacturing the vapor deposition mask illustrated in Fig. 38.
Fig. 48 illustrates a second protection layer removal step in the method of manufacturing the vapor deposition mask illustrated in Fig. 38.
Fig. 49 illustrates an enlarged plan view of a modification to the first metal layer of the vapor deposition mask according to the embodiment of the present disclosure.
Fig. 50 illustrates a plan view of another modification to the vapor deposition mask illustrated in Fig. 25.
Fig. 51 schematically illustrates a section taken along a line G-G in Fig. 50.

### DESCRIPTION OF EMBODIMENTS

In the present specification and the drawings, words that mean substances on which components such as a "substrate", a "base material", a "plate", a "sheet", and a "film" are based are not distinguished from each other only based on different names unless there is a particular description.

In the present specification and the drawings, words such as "parallel" and "perpendicular" and the values of a length and an angle that specify shapes, geometrical conditions, and the degree of these, for example, are not limited by strict meaning but are interpreted to an extent that the same function can be expected unless there is a particular description.

In some cases where a component such as a member or a region is "on" or "under", "on an upper side of" or "on a lower side of", or "above" or "below" another component such as another member or another region in the present specification and the drawings, the cases include a case where the component is in direct contact with the other component unless there is a particular description. The cases also include a case where another component is between the component and the other component, that is, a case where the component and the other component are indirectly connected to each other. As for the words "on", "upper side", and "above", or "under", "lower side", and "below", an up-down direction may be reversed unless there is a particular description.

A state in which a surface of an element A "faces" a surface of an element B includes not only the case where the surface of the element A is in contact with the surface of the element B but also the case where an element C is located between the surface of the element A and the surface of the element B in the present specification and the drawings unless there is a particular description. That is, the term "face" represents the directions of two surfaces.

In the present specification and the drawings, like portions or portions that have the same function are designated by like reference characters or similar reference characters unless there is a particular description, and a duplicated description for these is omitted in some cases. For convenience of description, the ratio of dimensions in the drawings differs from an actual ratio, and an illustration of a portion of a component is omitted in the drawings in some cases.

In the present specification and the drawings, a combination with another embodiment or a modification can be used without contradiction unless there is a particular description. Other embodiments can be combined with each other, and another embodiment and a modification can be combined with each other without contradiction. Modifications can be combined with each other without contradiction.

In the case where multiple steps related to a method such as a manufacturing method are disclosed in the present specification and the drawings, another step that is not disclosed may be performed between the disclosed steps unless there is a particular description. The order of the disclosed steps is freely determined without contradiction.

In the present specification and the drawings, a numerical range that is represented by the character "to" includes numerals placed in front of and behind the character "to" unless there is a particular description. For example, the numerical range that is defined as the expression "34 mass% to 38 mass%" is the same as the numerical range that is defined as the expression "34 mass% or more and 38 mass% or less".

According to an embodiment in the present specification, a vapor deposition mask that is used for patterning an organic material on a substrate in a desired pattern when an organic device is manufactured and a method of manufacturing the vapor deposition mask will be described by way of example in the present specification and the drawings unless there is a particular description. However, the present embodiment is not limited to such use but can be used for vapor deposition masks that are used in various ways.

An embodiment of the present disclosure will now be described in detail with reference to the drawings. The embodiment described below is an example of an embodiment of the present disclosure, and the present disclosure is not interpreted so as to be limited only to the embodiment.

According to a first aspect of the present disclosure, a vapor deposition mask includes a mask substrate that contains silicon, a mask layer that includes a first surface and a second surface that is located opposite the first surface and that faces the mask substrate, and a through-hole that extends through the mask layer, the mask substrate includes a substrate opening, the through-hole is located in the substrate opening in a plan view, the mask layer includes a mask body layer that forms the first surface and a mask intermediate layer that is located between the mask body layer and the mask substrate, and the mask body layer contains a metal material.

According to a second aspect of the present disclosure, a thickness of the mask intermediate layer may be less than a thickness of the mask body layer, as for the vapor deposition mask according to the first aspect described above.

According to a third aspect of the present disclosure, the mask intermediate layer may include a substrate-facing layer that contains gold, aluminum, chromium, nickel, titanium, titanium nitride, an aluminum alloy that contains neodymium, a silicon oxide, or a silicon dioxide, and the substrate-facing layer may be in contact with the mask body layer and is in contact with the mask substrate, as for the vapor deposition mask according to the first aspect described above or the second aspect described above.

According to a fourth aspect of the present disclosure, the mask intermediate layer may include a body-facing layer that faces the mask body layer and a substrate-facing layer that faces the mask substrate, and the body-facing layer and the substrate-facing layer may be composed of different metal materials, as for the vapor deposition mask according to the first aspect described above or the second aspect described above.

According to a fifth aspect of the present disclosure, the substrate-facing layer may contain gold, aluminum, chromium, nickel, titanium, titanium nitride, an aluminum alloy that contains neodymium, a silicon oxide, or a silicon dioxide, as for the vapor deposition mask according to the fourth aspect described above.

According to a sixth aspect of the present disclosure, the body-facing layer may contain titanium, copper, nickel, or gold, as for the vapor deposition mask according to the fourth aspect described above or the fifth aspect described above.

According to a seventh aspect of the present disclosure, the mask intermediate layer may include an intermediate layer that is located between the substrate-facing layer and the body-facing layer, and the intermediate layer may be composed of a metal material that differs from those of the body-facing layer and the substrate-facing layer, as for the vapor deposition mask according to any one of the fourth aspect described above to the sixth aspect described above.

According to an eighth aspect of the present disclosure, the intermediate layer may contain titanium, titanium nitride, aluminum, an aluminum alloy that contains neodymium, a silicon oxide, a silicon dioxide, nickel, copper, chromium, or gold, as for the vapor deposition mask according to the seventh aspect described above.

As for a ninth aspect of the present disclosure, the metal material of the mask body layer may be a magnetic metal material, as for the vapor deposition mask according to any one of the first aspect described above to the eighth aspect described above.

As for a tenth aspect of the present disclosure, the mask substrate may include a substrate body that defines the substrate opening, the mask intermediate layer may include a body region portion that is located between the mask body layer and the substrate body and an opening region portion that is located in the substrate opening in a plan view, and the through-hole may extend through the mask body layer and the opening region portion, as for the vapor deposition mask according to any one of the first aspect described above to the ninth aspect described above.

According to an eleventh aspect of the present disclosure, an opening dimension of the through-hole in a predetermined direction at the second surface may be larger than an opening dimension of the through-hole in the predetermined direction at the first surface, as for the vapor deposition mask according to the tenth aspect described above.

According to a twelfth aspect of the present disclosure, the mask substrate may include a substrate body that defines the substrate opening, the mask intermediate layer may include a body region portion that is located between the mask body layer and the substrate body and a mask layer opening that is formed along the substrate opening in a plan view, and the through-hole may extend through the mask body layer, as for the vapor deposition mask according to any one of the first aspect described above to the ninth aspect described above.

According to a thirteenth aspect of the present disclosure, an opening dimension of the through-hole in a predetermined direction at a surface of the mask body layer facing the mask substrate may be larger than an opening dimension of the through-hole in the predetermined direction at the first surface, as for the vapor deposition mask according to the twelfth aspect described above.

According to a fourteenth aspect of the present disclosure, the mask layer may include two or more of the through-holes, and the two or more of the through-holes may be located in the substrate opening in a plan view, as for the vapor deposition mask according to any one of the first aspect described above to the thirteenth aspect described above.

According to a fifteenth aspect of the present disclosure, the mask layer may include two or more through-hole groups that are formed by the two or more of the through-holes, and the two or more through-hole groups may be located in the substrate opening in a plan view, as for the vapor deposition mask according to the fourteenth aspect described above.

According to a sixteenth aspect of the present disclosure, the mask substrate may include two or more of the substrate openings, the mask layer may include two or more through-hole groups that are formed by the two or more of the through-holes, and the two or more through-hole groups may be located in each substrate opening in a plan view, as for the vapor deposition mask according to the fourteenth aspect described above.

According to a seventeenth aspect of the present disclosure, the mask substrate may include two or more of the substrate openings, the mask layer may include two or more through-hole groups that are formed by the two or more of the through-holes, and a corresponding one of the through-hole groups may be located in each substrate opening in a plan view, as for the vapor deposition mask according to the fourteenth aspect described above.

According to an eighteenth aspect of the present disclosure, the substrate opening may have a rectangular shape in a plan view, and curved portions may be provided at four corners of a contour of the substrate opening in a plan view, as for the vapor deposition mask according to any one of the first aspect described above to the seventeenth aspect described above.

According to a nineteenth aspect of the present disclosure, a first alignment mark may be provided on a surface of the mask substrate opposite the mask layer, as for the vapor deposition mask according to any one of the first aspect described above to the ninth aspect described above.

According to a twentieth aspect of the present disclosure, the mask substrate may include a substrate body that defines the substrate opening and an inner projecting portion that projects inward from the substrate body in a plan view, and the first alignment mark may be located on the inner projecting portion, as for the vapor deposition mask according to the nineteenth aspect described above.

According to a twenty-first of the present disclosure, a second alignment mark may be provided at a position nearer than the first alignment mark to the through-hole, as for the vapor deposition mask according to the nineteenth aspect described above or the twentieth aspect described above.

According to a twenty-second aspect of the present disclosure, the mask layer may include two or more of the through-holes, two or more through-hole groups that are formed by the two or more of the through-holes and a mask sash bar that is provided between the through-hole groups adjacent to each other, and the second alignment mark may be located on the mask sash bar, as for the vapor deposition mask according to the twenty-first described above.

According to a twenty-third aspect of the present disclosure, the mask sash bar may include a first mask sash bar and a second mask sash bar that extend in respective directions perpendicular to each other in a plan view, and the second alignment mark may be located at an intersecting portion at which the first mask sash bar and the second mask sash bar intersect with each other, as for the vapor deposition mask according to the twenty-second aspect described above.

According to a twenty-fourth aspect of the present disclosure, an outer edge of the mask body layer may be located inside an outer edge of the mask intermediate layer in a plan view, as for the vapor deposition mask according to any one of the first aspect described above to the twenty-third aspect described above.

According to a twenty-fifth aspect of the present disclosure, the mask body layer may include two or more body islands, and a groove that extends through the mask body layer may be located between two of the body islands adjacent to each other, as for the vapor deposition mask according to any one of the first aspect described above to the twenty-fourth aspect described above.

According to a twenty-sixth aspect of the present disclosure, the mask layer may include a mask insulating layer that forms the first surface, the mask body layer may include two or more body islands, and the mask insulating layer may be located between two of the body islands adjacent to each other, as for the vapor deposition mask according to any one of the first aspect described above to the twenty-fifth aspect described above.

According to a twenty-seventh of the present disclosure, the mask layer may include two or more through-hole groups that are formed by the two or more of the through-holes, the mask layer may include a mask insulating layer that forms the first surface, and the mask insulating layer may be located between two of the through-hole groups adjacent to each other, as for the vapor deposition mask according to any one of the first aspect described above to the twenty-sixth aspect described above.

According to a twenty-eighth aspect of the present disclosure, the mask body layer may include a dummy body island that does not overlap the substrate opening in a plan view, as for the vapor deposition mask according to any one of the first aspect described above to the twenty-seventh aspect described above.

According to a twenty-ninth aspect of the present disclosure, a framed vapor deposition mask includes the vapor deposition mask according to any one of the first aspect described above to the twenty-eighth aspect described above, and a frame that supports the mask substrate of the vapor deposition mask.

According to a thirtieth aspect of the present disclosure, a method of manufacturing a vapor deposition mask includes a substrate preparation step of preparing a mask substrate that contains silicon, a mask layer formation step of forming a mask layer that includes a first surface and a second surface that is located opposite the first surface and that faces the mask substrate on the mask substrate, a substrate opening formation step of forming a substrate opening in the mask substrate, and a through-hole formation step of forming a through-hole that extends through the mask layer. The through-hole is located in the substrate opening in a plan view, the mask layer formation step includes a mask intermediate layer formation step of forming a mask intermediate layer on a surface of the mask substrate facing the mask layer and a mask body layer formation step of forming a mask body layer on a surface of the mask intermediate layer opposite the mask substrate, and the mask body layer contains a metal material.

According to a thirty-first aspect of the present disclosure, at the through-hole formation step, the through-hole may be formed by irradiating the mask layer with laser light, as for the method of manufacturing the vapor deposition mask according to the thirtieth aspect described above.

According to a thirty-second aspect of the present disclosure, the through-hole formation step may be performed after the substrate opening formation step, and the second surface of the mask layer may be irradiated with the laser light via the substrate opening, as for the method of manufacturing the vapor deposition mask according to the thirty-first aspect described above.

According to a thirty-third aspect of the present disclosure, the laser light may be femtosecond laser light, as for the method of manufacturing the vapor deposition mask according to the thirty-first aspect described above or the thirty-third aspect described above.

According to a thirty-fourth aspect of the present disclosure, at the through-hole formation step, the mask layer may be irradiated with the laser light via a mask hole that corresponds to the through-hole of a photo mask, as for the method of manufacturing the vapor deposition mask according to any one of the thirty-first aspect described above to the thirty-second aspect described above.

According to a thirty-fifth aspect of the present disclosure, the photo mask may include a plurality of the mask holes, and at the through-hole formation step, the mask layer may be irradiated with the laser light via the plurality of the mask holes of the photo mask, as for the method of manufacturing the vapor deposition mask according to the thirty-fourth aspect described above.

According to a thirty-sixth aspect of the present disclosure, the mask substrate may include a substrate body that defines the substrate opening, the mask intermediate layer may include a body region portion that is located between the mask body layer and the substrate body and an opening region portion that is located in the substrate opening in a plan view, and at the through-hole formation step, the through-hole may be formed so as to extend through the mask body layer and the opening region portion, as for the method of manufacturing the vapor deposition mask according to any one of the thirtieth aspect described above to the thirty-fifth aspect described above.

According to a thirty-seventh aspect of the present disclosure, an opening dimension of the through-hole in a predetermined direction at the second surface may be larger than an opening dimension of the through-hole in the predetermined direction at the first surface, as for the method of manufacturing the vapor deposition mask according to the thirty-sixth aspect described above.

According to a thirty-eighth aspect of the present disclosure, a mask layer opening formation step of forming a mask layer opening in the mask intermediate layer along the substrate opening in a plan view after the substrate opening formation step may be further included, and at the through-hole formation step, the through-hole may be formed so as to extend through the mask body layer, as for the method of manufacturing the vapor deposition mask according to any one of the thirtieth aspect described above to the thirty-fifth aspect described above.

According to a thirty-ninth aspect of the present disclosure, an opening dimension of the through-hole in a predetermined direction at a surface of the mask body layer facing the mask substrate may be larger than an opening dimension of the through-hole in the predetermined direction at the first surface, as for the method of manufacturing the vapor deposition mask according to the thirty-eighth aspect described above.

According to a fortieth aspect of the present disclosure, a method of manufacturing a vapor deposition mask includes a substrate preparation step of preparing a mask substrate that contains silicon, a mask layer formation step of forming a mask layer that includes a first surface and a second surface that is located opposite the first surface and that faces the mask substrate on the mask substrate, a substrate opening formation step of forming a substrate opening in the mask substrate, and a mask layer opening formation step of forming a mask layer opening in the mask layer along the substrate opening in a plan view. The mask layer formation step includes a mask intermediate layer formation step of forming a mask intermediate layer on a surface of the mask substrate facing the mask layer and a mask body layer formation step of forming a mask body layer on a surface of the mask intermediate layer opposite the mask substrate and of forming a through-hole that extends through the mask body layer. At the mask layer opening formation step, the mask layer opening is formed in the mask intermediate layer, the through-hole is located in the substrate opening in a plan view, and the mask body layer contains a metal material.

According to a forty-first aspect of the present disclosure, at the mask body layer formation step, a resist layer may be patterned on the surface of the mask intermediate layer opposite the mask substrate so as to correspond to the through-hole, as for the method of manufacturing the vapor deposition mask according to the fortieth aspect described above.

According to a forty-second aspect of the present disclosure, an opening dimension of the through-hole in a predetermined direction at a surface of the mask body layer facing the mask substrate may be larger than an opening dimension of the through-hole in the predetermined direction at the first surface, as for the method of manufacturing the vapor deposition mask according to the fortieth aspect described above or the forty-first aspect described above.

According to a forty-third aspect of the present disclosure, at the mask body layer formation step, a mask insulating layer may be patterned on the surface of the mask intermediate layer opposite the mask substrate so as to correspond to the through-hole, the mask body layer may include two or more body islands, and the mask insulating layer may be located between two of the body islands adjacent to each other, as for the method of manufacturing the vapor deposition mask according to any one of the fortieth aspect described above to the forty-second aspect described above.

According to a forty-fourth aspect of the present disclosure, the metal material of the mask body layer may be a magnetic metal material, as for the method of manufacturing the vapor deposition mask according to any one of the thirtieth aspect described above to the forty-third aspect described above.

According to a forty-fifth aspect of the present disclosure, a thickness of the mask intermediate layer may be less than a thickness of the mask body layer, as for the method of manufacturing the vapor deposition mask according to any one of the thirtieth aspect described above to the forty-fourth aspect described above.

According to a forty-sixth aspect of the present disclosure, the substrate opening formation step may include a resist layer formation step of forming a resist layer that includes a resist opening on a surface of the mask substrate opposite the mask layer and a substrate etching step of forming the substrate opening by etching the mask substrate through the resist opening, as for the method of manufacturing the vapor deposition mask according to any one of the thirtieth aspect described above to the forty-fifth aspect described above.

According to a forty-seventh aspect of the present disclosure, the mask intermediate layer may include a substrate-facing layer containing a material that is capable of ensuring adhesion to the mask substrate and that has resistance against an etching medium that is used at the substrate etching step, as for the method of manufacturing the vapor deposition mask according to the forty-sixth aspect described above.

According to a forty-eighth aspect of the present disclosure, the mask intermediate layer may include a body-facing layer that faces the mask body layer and that contains a material that is capable of ensuring adhesion to the mask body layer, as for the method of manufacturing the vapor deposition mask according to the forty-seventh aspect described above.

According to a forty-ninth aspect of the present disclosure, at the mask layer formation step, the mask body layer may be formed by performing a plating process, and the mask intermediate layer may include an intermediate layer that is located between the substrate-facing layer and the body-facing layer and that contains a material that is capable of protecting the substrate-facing layer from a plating solution for forming the mask body layer, as for the method of manufacturing the vapor deposition mask according to the forty-eighth aspect described above.

According to a fiftieth aspect of the present disclosure, the substrate-facing layer may be in contact with the mask body layer and may be in contact with the mask substrate, as for the method of manufacturing the vapor deposition mask according to the forty-seventh aspect described above.

According to a fifty-first aspect of the present disclosure, at the mask layer formation step, the mask intermediate layer may be formed by performing a sputtering process, as for the method of manufacturing the vapor deposition mask according to any one of the thirtieth aspect described above to the fiftieth aspect described above.

According to a fifty-second aspect of the present disclosure, at the mask layer formation step, the mask intermediate layer may be formed by performing a vapor deposition process, as for the method of manufacturing the vapor deposition mask according to any one of the thirtieth aspect described above to the fiftieth aspect described above.

According to a fifty-third aspect of the present disclosure, the mask layer may include two or more of the through-holes, and the two or more of the through-holes may be located in the substrate opening in a plan view, as for the method of manufacturing the vapor deposition mask according to any one of the thirtieth aspect described above to the fifty-second aspect described above.

According to a fifty-fourth aspect of the present disclosure, the mask layer may include two or more through-hole groups that are formed by the two or more of the through-holes, and the two or more through-hole groups may be located in the substrate opening in a plan view, as for the method of manufacturing the vapor deposition mask according to the fifty-third aspect described above.

According to a fifty-fifth aspect of the present disclosure, the mask substrate may include two or more of the substrate openings, the mask layer may include two or more through-hole groups that are formed by the two or more of the through-holes, and the two or more through-hole groups may be located in each substrate opening in a plan view, as for the method of manufacturing the vapor deposition mask according to the fifty-third aspect described above.

A fifty-sixth aspect of the present disclosure, the mask substrate may include two or more of the substrate openings, the mask layer may include two or more through-hole groups that are formed by the two or more of the through-holes, and a corresponding one of the through-hole groups may be located in each substrate opening in a plan view, as for the method of manufacturing the vapor deposition mask according to the fifty-third aspect described above.

According to a fifty-seventh aspect of the present disclosure, the substrate opening may have a rectangular shape in a plan view, and curved portions may be provided at four corners of a contour of the substrate opening in a plan view, as for the method of manufacturing the vapor deposition mask according to any one of the thirtieth aspect described above to the fifty-sixth aspect described above.

According to a fifty-eighth aspect of the present disclosure, a step of forming a first alignment mark on a surface of the mask substrate opposite the mask layer may be further included, as for the method of manufacturing the vapor deposition mask according to any one of the thirtieth aspect described above to the fifty-seventh aspect described above.

According to a fifty-ninth aspect of the present disclosure, the mask substrate may include a substrate body that defines the substrate opening and an inner projecting portion that projects inward from the substrate body in a plan view, and the first alignment mark may be located on the inner projecting portion, as for the method of manufacturing the vapor deposition mask according to the fifty-eighth aspect described above.

According to a sixtieth aspect of the present disclosure, a step of forming a second alignment mark at a position nearer than the first alignment mark to the through-hole may be further included, as for the method of manufacturing the vapor deposition mask according to the fifty-eighth aspect described above or the fifty-ninth aspect described above.

According to a sixty-first aspect of the present disclosure, the mask layer may include two or more of the through-holes, two or more through-hole groups that are formed by the two or more of the through-holes and a mask sash bar that is provided between the through-hole groups adjacent to each other, and the second alignment mark may be located on the mask sash bar, as for the method of manufacturing the vapor deposition mask according to the sixtieth aspect described above.

According to a sixty-second aspect of the present disclosure, the mask sash bar may include a first mask sash bar and a second mask sash bar that extend in respective directions perpendicular to each other in a plan view, and the second alignment mark may be located at an intersecting portion at which the first mask sash bar and the second mask sash bar intersect with each other, as for the method of manufacturing the vapor deposition mask according to the sixty-first aspect described above.

According to a sixty-third aspect of the present disclosure, an outer edge of the mask body layer may be located inside an outer edge of the mask intermediate layer in a plan view, as for the method of manufacturing the vapor deposition mask according to any one of the thirtieth aspect described above to the sixty-second aspect described above.

According to a sixty-fourth aspect of the present disclosure, the mask body layer may include two or more body islands, and a groove that extends through the mask body layer may be located between two of the body islands adjacent to each other, as for the method of manufacturing the vapor deposition mask according to any one of the thirtieth aspect described above to the sixty-third aspect described above.

According to a sixty-fifth aspect of the present disclosure, the mask layer may include two or more through-hole groups that are formed by the two or more of the through-holes, the mask layer may include a mask insulating layer that forms the first surface, and the mask insulating layer may be located between two of the through-hole groups adjacent to each other, as for the method of manufacturing the vapor deposition mask according to any one of the thirtieth aspect described above to the sixty-fourth aspect described above.

According to a sixty-sixth aspect of the present disclosure, the mask body layer may include a dummy body island that does not overlap the substrate opening in a plan view, as for the method of manufacturing the vapor deposition mask according to any one of the thirtieth aspect described above to the sixty-fifth aspect described above.

The thirtieth aspect described above to the sixty-sixth aspect described above may be the vapor deposition masks that are manufactured by using the methods of manufacturing the vapor deposition masks according to the thirtieth aspect to the sixty-sixth aspect.

According to a sixty-seven aspect of the present disclosure, a method of manufacturing an organic device includes a vapor deposition mask preparation step of preparing the vapor deposition mask by using the method of manufacturing the vapor deposition mask according to any one of the thirtieth aspect described above to the sixty-sixth aspect described above, a close contact step of causing the first surface of the mask layer of the vapor deposition mask to come into close contact with a vapor deposition substrate, and a vapor deposition step of forming a vapor deposition layer in a manner in which a vapor deposition material is deposited on the vapor deposition substrate via the through-hole of the vapor deposition mask.

The sixty-seventh aspect described above may be the organic device that is manufactured by using the method of manufacturing the organic device according to the sixty-seventh aspect.

According to a sixty-eighth aspect of the present disclosure, a method of manufacturing a framed vapor deposition mask includes a vapor deposition mask preparation step of preparing the vapor deposition mask by using the method of manufacturing the vapor deposition mask according to any one of the thirtieth aspect described above to the sixty-sixth aspect described above, and a frame attachment step of attaching a frame to the mask substrate of the vapor deposition mask.

The sixty-eighth aspect described above may be the framed vapor deposition mask that is manufactured by using the method of manufacturing the framed vapor deposition mask according to the sixty-eighth aspect.

An embodiment of the present disclosure will now be described in detail with reference to the drawings. The embodiment described below is an example of the embodiment of the present disclosure, and the present disclosure is not limited only to the embodiment.

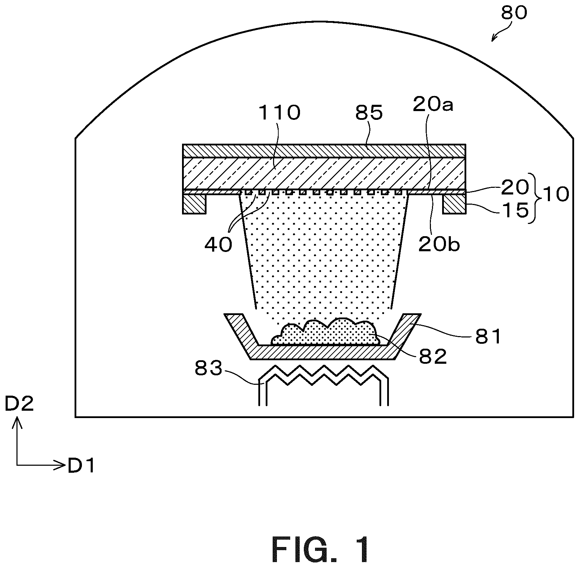

A vapor deposition apparatus 80 for performing a vapor deposition process in which a vapor deposition material is deposited on an object will be described with reference to Fig. 1. As illustrated in Fig. 1, the vapor deposition apparatus 80 may include a vapor deposition source (such as a crucible 81), a heater 83, and a vapor deposition mask 10. The vapor deposition apparatus 80 may further include an exhaust means (not illustrated). The exhaust means can reduce pressure in the vapor deposition apparatus 80 to that in a vacuum atmosphere. The crucible 81 is provided in the vapor deposition apparatus 80 and is configured to contain a vapor deposition material 82 such as an organic light-emitting material. The heater 83 is configured to heat the crucible 81. The crucible 81 is heated in the vacuum atmosphere, and consequently, the vapor deposition material 82 is vaporized.

The vapor deposition mask 10 is disposed in the vapor deposition apparatus 80 so as to face the crucible 81. The vapor deposition mask 10 may be disposed above the crucible 81. A vapor deposition substrate 110 is disposed so as to face the vapor deposition mask 10. The vapor deposition substrate 110 is an object to which the vapor deposition material 82 is attached. The vapor deposition substrate 110 may be disposed above the vapor deposition mask 10. The vapor deposition material that comes from the crucible 81 passes through through-holes 40 of the vapor deposition mask 10 described later and is attached to the vapor deposition substrate 110.

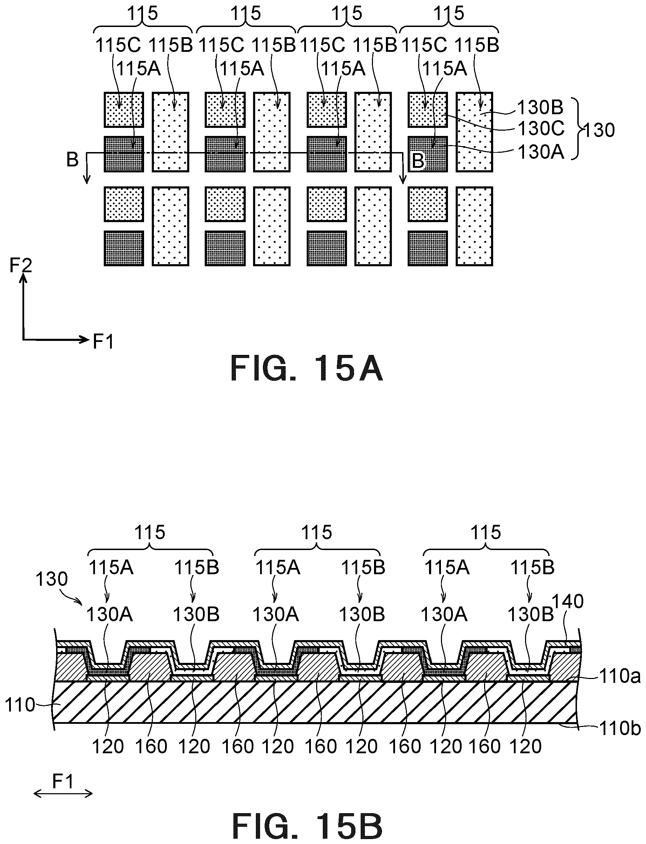

As illustrated in Fig. 1, the vapor deposition apparatus 80 may include a magnet 85 that is disposed on a surface of the vapor deposition substrate 110 opposite the vapor deposition mask 10. The magnetic force of the magnet 85 enables the vapor deposition mask 10 to be attracted toward the magnet 85, and the vapor deposition mask 10 can be brought into close contact with the vapor deposition substrate 110. This enables shadow (described later) to be inhibited from occurring at a vapor deposition step. For this reason, the precision of the shape and the precision of the position of a vapor deposition layer (or organic layers 130A, 130B, and 130C of an organic device 100 described later, see Fig. 15A and Fig. 15B) that is formed by using the vapor deposition material 82 that is attached to the vapor deposition substrate 110 can be improved. A cooling plate (not illustrated) that cools the vapor deposition substrate 110 during vapor deposition may be interposed between the vapor deposition substrate 110 and the magnet 85.

The vapor deposition mask 10 according to the present embodiment will now be described in more detail with reference to Fig. 1 to Fig. 5B.

As illustrated in Fig. 1 to Fig. 3, the vapor deposition mask 10 may include a mask layer 20 that includes the through-holes 40 described later and a mask substrate 15 that supports the mask layer 20. The mask substrate 15 may be located on a second surface 20b of the mask layer 20 described later.

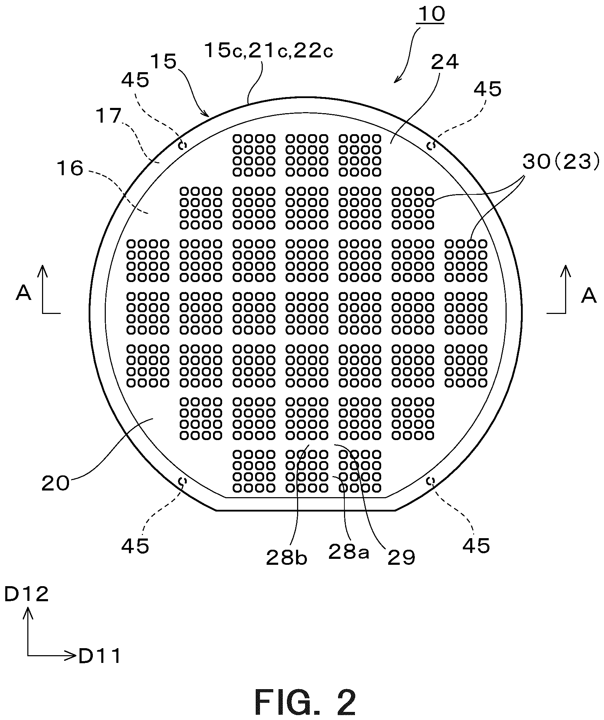

As illustrated in Fig. 2, the vapor deposition mask 10 according to the present embodiment may have the same planar shape as a silicon wafer that is used for manufacturing semiconductor when viewed in a direction perpendicular to a first surface 20a described later (referred to below as "in a plan view"). In this case, both of the mask layer 20 and the mask substrate 15 may have the same shape as the silicon wafer. The silicon wafer may have a planar shape (see Fig. 2) obtained by linearly cutting a portion of a circle, which is called an orientation flat as in a typical wafer shape. Alternatively, the silicon wafer may have a planar shape obtained by cutting a portion of a circle in a recessed shape, which is called a notch.

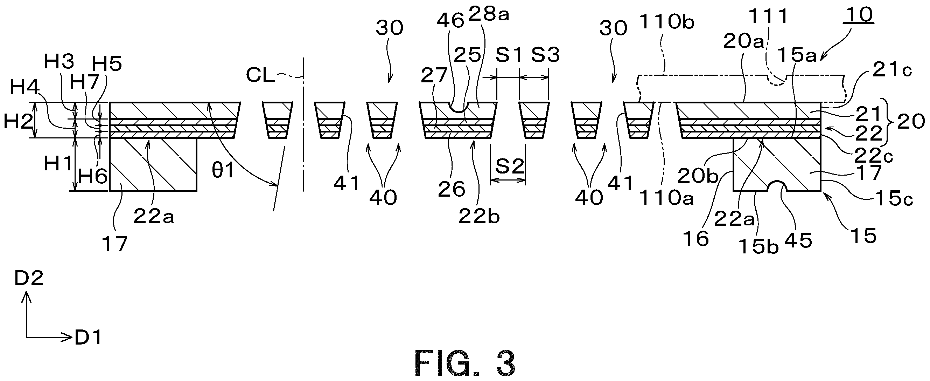

As illustrated in Fig. 3, the mask substrate 15 may include a first substrate surface 15a that faces the mask layer 20 and a second substrate surface 15b that is located opposite the first substrate surface 15a. The mask layer 20 (more specifically, a substrate-facing layer 26 described later) may be attached or fixed to the first substrate surface 15a. The mask layer 20 and the mask substrate 15 may be attached to each other by using a layer (such as a second metal layer 22 described later) that is formed by performing, for example, a sputtering process or a vapor deposition process described later such that the mask layer 20 is not separatable. Fig. 3 schematically illustrates a section taken along a line A-A in Fig. 2 where the number of through-hole groups 30 and the number of the through-holes 40 are reduced to make the figure easy to understand.

As illustrated in Fig. 2 and Fig. 3, the mask substrate 15 may include a substrate opening 16 from which the through-holes 40 of the mask layer 20 are exposed. The substrate opening 16 extends from the first substrate surface 15a to the second substrate surface 15b through the mask substrate 15. In a plan view, a through-hole 40 may be located in the substrate opening 16, or the multiple through-holes 40 may be located therein. According to an embodiment, the mask substrate 15 may have a frame shape in a plan view. As illustrated in Fig. 2, the mask substrate 15 may include a substrate frame body 17 that is located outside the through-hole groups 30 and that has a planar shape that extends along an outer edge 15c of the mask substrate 15. The substrate frame body 17 is an example of a substrate body. The substrate opening 16 may be defined inside the substrate frame body 17. As illustrated in Fig. 2, the substrate opening 16 may have a contour similar to the outer edge 15c of the mask substrate 15 or a circular contour in a plan view.

The diameter of the mask substrate 15 is not particularly limited but may be, for example, 150 mm (6 inches), 200 mm (8 inches), 300 mm (12 inches), or 450 mm (18 inches).

The thickness H1 of the mask substrate 15 is not particularly limited but may be 0.625 mm in the case where the diameter is 150 mm or may be 0.725 mm in the case where the diameter is 200 mm. The thickness H1 may be 0.775 mm in the case where the diameter is 300 mm.

The mask substrate 15 may contain silicon. For example, in the case where the vapor deposition substrate 110 is a glass substrate, the thermal expansion coefficient of the mask substrate 15 can be adjusted to a value equal or close to that of the glass substrate. In some cases, the precision of the shapes and the precision of the positions of the organic layers 130A, 130B, and 130C that are formed on the vapor deposition substrate 110 reduces due to a difference in thermal expansion coefficient between the vapor deposition mask 10 that includes the mask layer 20 and the vapor deposition substrate 110 at the vapor deposition step. The reduction is referred to below as precision reduction in some cases. The thermal expansion coefficient of the mask substrate 15 is adjusted to a value equal or close to that of the glass substrate, and consequently, the precision reduction can be inhibited from being made. In the case where the vapor deposition substrate 110 is a silicon substrate, the mask substrate 15 can be composed of the same kind of material or the same material as that of the vapor deposition substrate 110. In this case, the difference between the thermal expansion coefficient of the mask substrate 15 and the thermal expansion coefficient of the vapor deposition substrate 110 can be reduced. In addition, the thermal expansion coefficient of the mask substrate 15 and the thermal expansion coefficient of the vapor deposition substrate 110 can be equal to each other. This enables the precision reduction to be further inhibited from being made.

As illustrated in Fig. 3, the mask layer 20 may include the first surface 20a and the second surface 20b that is located opposite the first surface 20a and that faces the mask substrate 15. The first surface 20a may come into close contact with the vapor deposition substrate 110 during vapor deposition. The second surface 20b may be attached to the mask substrate 15.

For example, the thickness H2 of the mask layer 20 may be 2 µm or more, may be 3 µm or more, may be 4 µm or more, or may be 5 µm or more. When the thickness H2 is 2 µm or more, the mechanical strength of the mask layer 20 can be ensured, and deformation or damage can be reduced during handing. For example, the thickness H2 may be 6 µm or less, may be 7 µm or less, may be 8 µm or less, or may be 9 µm or less. When the thickness H2 is 9 µm or less, shadow can be inhibited from occurring. The range of the thickness H2 may be determined by using a first group consisting of 2 µm, 3 µm, 4 µm, and 5 µm and/or a second group consisting of 6 µm, 7 µm, 8 µm, and 9 µm. The range of the thickness H2 may be determined by using a combination of a freely selected one of values in the first group described above and a freely selected one of values in the second group described above. The range of the thickness H2 may be determined by using a combination of freely selected two of values in the first group described above. The range of the thickness H2 may be determined by using a combination of freely selected two of values in the second group described above. For example, the range may be 2 µm or more and 9 µm or less, may be 2 µm or more and 8 µm or less, may be 2 µm or more and 7 µm or less, may be 2 µm or more and 6 µm or less, may be 2 µm or more and 5 µm or less, may be 2 µm or more and 4 µm or less, may be 2 µm or more and 3 µm or less, may be 3 µm or more and 9 µm or less, may be 3 µm or more and 8 µm or less, may be 3 µm or more and 7 µm or less, may be 3 µm or more and 6 µm or less, may be 3 µm or more and 5 µm or less, may be 3 µm or more and 4 µm or less, may be 4 µm or more and 9 µm or less, may be 4 µm or more and 8 µm or less, may be 4 µm or more and 7 µm or less, may be 4 µm or more and 6 µm or less, may be 4 µm or more and 5 µm or less, may be 5 µm or more and 9 µm or less, may be 5 µm or more and 8 µm or less, may be 5 µm or more and 7 µm or less, may be 5 µm or more and 6 µm or less, may be 6 µm or more and 9 µm or less, may be 6 µm or more and 8 µm or less, may be 6 µm or more and 7 µm or less, may be 7 µm or more and 9 µm or less, may be 7 µm or more and 8 µm or less, or may be 8 µm or more and 9 µm or less.

According to an embodiment, the mask layer 20 may include a first metal layer 21 that is near the first surface 20a and the second metal layer 22 that is nearer than the first metal layer 21 to the second surface 20b. The first metal layer 21 may form the first surface 20a. The first metal layer 21 is an example of a mask body layer and may be referred to as a metal body layer. The first metal layer 21 may be attached to and stacked on the second metal layer 22. The second metal layer 22 is an example of a mask intermediate layer and may be referred to as a metal intermediate layer. The second metal layer 22 is located between the first metal layer 21 and the mask substrate 15. The thickness H4 of the second metal layer 22 may be less than the thickness H3 of the first metal layer 21. The first metal layer 21 may be formed by performing a plating process as described later. The second metal layer 22 may be formed by performing a sputtering process as described later.

The second metal layer 22 may include a body region portion 22a that is located between the first metal layer 21 and the substrate frame body 17 and an opening region portion 22b that is located in the substrate opening 16 in a plan view. In an example illustrated in Fig. 3, the second metal layer 22 is formed on the entire surface of the first metal layer 21 facing the mask substrate 15. The body region portion 22a and the opening region portion 22b may be formed by a body-facing layer 25, the substrate-facing layer 26, and an intermediate layer 27 described later.

As illustrated in Fig. 3, at least a portion of an outer edge 21c of the first metal layer 21 may overlap an outer edge 22c of the second metal layer 22 in a plan view. The outer edge 21c of the first metal layer 21 may entirely overlap the outer edge 22c of the second metal layer 22. An outer edge of the body-facing layer 25, an outer edge of the substrate-facing layer 26, and an outer edge of the intermediate layer 27 described later may overlap in a plan view and may form the outer edge 22c of the second metal layer 22. At least a portion of the outer edge 21c of the first metal layer 21 and at least a portion of the outer edge 22c of the second metal layer 22 may overlap the outer edge 15c of the mask substrate 15 described above in a plan view. The outer edge 21c of the first metal layer 21 and the outer edge 22c of the second metal layer 22 may entirely overlap the outer edge 15c of the mask substrate 15.

The second metal layer 22 may include the body-facing layer 25 that is near the first metal layer 21 and the substrate-facing layer 26 that is nearer than the body-facing layer 25 to the mask substrate 15. The body-facing layer 25 may be nearer than the substrate-facing layer 26 to the first metal layer 21. The body-facing layer 25 may face the first metal layer 21. The substrate-facing layer 26 may face the mask substrate 15. A surface of the substrate-facing layer 26 facing the mask substrate 15 may form the second surface 20b described above. The intermediate layer 27 may be located between the body-facing layer 25 and the substrate-facing layer 26. The second metal layer 22 may have a three-layer structure.

The body-facing layer 25, the substrate-facing layer 26, and the intermediate layer 27 may be composed of different materials. The body-facing layer 25, the substrate-facing layer 26, and the intermediate layer 27 may be composed of different metal materials. The body-facing layer 25, the substrate-facing layer 26, and the intermediate layer 27 may have an inherent purpose. For example, the body-facing layer 25 may be capable of ensuring adhesion to the first metal layer 21. For example, the substrate-facing layer 26 may be capable of ensuring adhesion to the mask substrate 15. The substrate-facing layer 26 may have resistance against an etching medium that is used at a substrate etching step described later. More specifically, the substrate-facing layer 26 may be capable of reducing the erosion of an etching medium. For example, the intermediate layer 27 may be capable of protecting the substrate-facing layer 26 from a plating solution that is used at a first metal layer formation step. More specifically, in the case where the body-facing layer 25 is composed of copper as described later, and the thickness H5 (described later) of the body-facing layer 25 has a small value, the body-facing layer 25 can be porous. In this case, the plating solution can reach the intermediate layer 27 via the body-facing layer 25, and accordingly, the intermediate layer 27 may have resistance against the plating solution. For example, in the case where the body-facing layer 25 is composed of copper, and the substrate-facing layer 26 is composed of an aluminum alloy that contains neodymium, the intermediate layer 27 may be capable of ensuring adhesion between the body-facing layer 25 and the substrate-facing layer 26.

For example, the thickness H3 of the first metal layer 21 may be 0.5 µm or more, may be 1.0 µm or more, may be 1.5 µm or more, or may be 2.0 µm or more. When the thickness H3 is 0.5 µm or more, the mechanical strength can be ensured, deformation or damage can be reduced during handling, and a defect such as a pinhole can be reduced. For example, the thickness H3 may be 10.0 µm or less, may be 15.0 µm or less, may be 20.0 µm or less, or may be 25.0 µm or less. When the thickness H3 is 25.0 µm or less, shadow can be inhibited from occurring. The range of the thickness H3 may be determined by using a first group consisting of 0.5 µm, 1.0 µm, 1.5 µm, and 2.0 µm and/or a second group consisting of 10.0 µm, 15.0 µm, 20.0 µm, and 25.0 µm. The range of the thickness H3 may be determined by using a combination of a freely selected one of values in the first group described above and a freely selected one of values in the second group described above. The range of the thickness H3 may be determined by using a combination of freely selected two of values in the first group described above. The range of the thickness H3 may be determined by using a combination of freely selected two of values in the second group described above. For example, the range may be 0.5 µm or more and 25.0 µm or less, may be 0.5 µm or more and 20.0 µm or less, may be 0.5 µm or more and 15.0 µm or less, may be 0.5 µm or more and 10.0 µm or less, may be 0.5 µm or more and 2.0 µm or less, may be 0.5 µm or more and 1.5 µm or less, may be 0.5 µm or more and 1.0 µm or less, may be 1.0 µm or more and 25.0 µm or less, may be 1.0 µm or more and 20.0 µm or less, may be 1.0 µm or more and 15.0 µm or less, may be 1.0 µm or more and 10.0 µm or less, may be 1.0 µm or more and 2.0 µm or less, may be 1.0 µm or more and 1.5 µm or less, may be 1.5 µm or more and 25.0 µm or less, may be 1.5 µm or more and 20.0 µm or less, may be 1.5 µm or more and 15.0 µm or less, may be 1.5 µm or more and 10.0 µm or less, may be 1.5 µm or more and 2.0 µm or less, may be 2.0 µm or more and 25.0 µm or less, may be 2.0 µm or more and 20.0 µm or less, may be 2.0 µm or more and 15.0 µm or less, may be 2.0 µm or more and 10.0 µm or less, may be 10.0 µm or more and 25.0 µm or less, may be 10.0 µm or more and 20.0 µm or less, may be 10.0 µm or more and 15.0 µm or less, may be 15.0 µm or more and 25.0 µm or less, may be 15.0 µm or more and 20.0 µm or less, or may be 20.0 µm or more and 25.0 µm or less.

Alternatively, for example, the thickness H3 of the first metal layer 21 may be 3.2 µm or more, may be 3.4 µm or more, may be 3.6 µm or more, or may be 3.8 µm or more. When the thickness H3 is 3.2 µm or more, the first metal layer 21 that is capable of ensuring the mechanical strength and that is capable of reducing deformation or damage during handling can be stably formed by performing the plating process described later. For example, the thickness H3 may be 4.2 µm or less, may be 4.4 µm or less, may be 4.6 µm or less, or may be 4.8 µm or less. When the thickness H3 is 4.8 µm or less, the first metal layer 21 can be efficiently formed. The range of the thickness H3 may be determined by using a first group consisting of 3.2 µm, 3.4 µm, 3.6 µm, and 3.8 µm and/or a second group consisting of 4.2 µm, 4.4 µm, 4.6 µm, and 4.8 µm. The range of the thickness H3 may be determined by using a combination of a freely selected one of values in the first group described above and a freely selected one of values in the second group described above. The range of the thickness H3 may be determined by using a combination of freely selected two of values in the first group described above. The range of the thickness H3 may be determined by using a combination of freely selected two of values in the second group described above. For example, the range may be 3.2 µm or more and 4.8 µm or less, may be 3.2 µm or more and 4.6 µm or less, may be 3.2 µm or more and 4.4 µm or less, may be 3.2 µm or more and 4.2 µm or less, may be 3.2 µm or more and 3.8 µm or less, may be 3.2 µm or more and 3.6 µm or less, may be 3.2 µm or more and 3.4 µm or less, may be 3.4 µm or more and 4.8 µm or less, may be 3.4 µm or more and 4.6 µm or less, may be 3.4 µm or more and 4.4 µm or less, may be 3.4 µm or more and 4.2 µm or less, may be 3.4 µm or more and 3.8 µm or less, may be 3.4 µm or more and 3.6 µm or less, may be 3.6 µm or more and 4.8 µm or less, may be 3.6 µm or more and 4.6 µm or less, may be 3.6 µm or more and 4.4 µm or less, may be 3.6 µm or more and 4.2 µm or less, may be 3.6 µm or more and 3.8 µm or less, may be 3.8 µm or more and 4.8 µm or less, may be 3.8 µm or more and 4.6 µm or less, may be 3.8 µm or more and 4.4 µm or less, may be 3.8 µm or more and 4.2 µm or less, may be 4.2 µm or more and 4.8 µm or less, may be 4.2 µm or more and 4.6 µm or less, may be 4.2 µm or more and 4.4 µm or less, may be 4.4 µm or more and 4.8 µm or less, may be 4.4 µm or more and 4.6 µm or less, or may be 4.6 µm or more and 4.8 µm or less.

For example, the thickness H4 of the second metal layer 22 may be 100 nm or more, may be 200 nm or more, may be 300 nm or more, or may be 400 nm or more. When the thickness H4 is 100 nm or more, the second metal layer 22 can be stably formed by performing the sputtering process described later. For example, the thickness H4 may be 800 nm or less, may be 1000 nm or less, may be 1200 nm or less, or may be 1500 nm or less. When the thickness H4 is 1500 nm or less, the second metal layer 22 can be efficiently formed. The range of the thickness H4 may be determined by using a first group consisting of 100 nm, 200 nm, 300 nm, and 400 nm and/or a second group consisting of 800 nm, 1000 nm, 1200 nm, and 1500 nm. The range of the thickness H4 may be determined by using a combination of a freely selected one of values in the first group described above and a freely selected one of values in the second group described above. The range of the thickness H4 may be determined by using a combination of freely selected two of values in the first group described above. The range of the thickness H4 may be determined by using a combination of freely selected two of values in the second group described above. For example, the range may be 100 nm or more and 1500 nm or less, may be 100 nm or more and 1200 nm or less, may be 100 nm or more and 1000 nm or less, may be 100 nm or more and 800 nm or less, may be 100 nm or more and 400 nm or less, may be 100 nm or more and 300 nm or less, may be 100 nm or more and 200 nm or less, may be 200 nm or more and 1500 nm or less, may be 200 nm or more and 1200 nm or less, may be 200 nm or more and 1000 nm or less, may be 200 nm or more and 800 nm or less, may be 200 nm or more and 400 nm or less, may be 200 nm or more and 300 nm or less, may be 300 nm or more and 1500 nm or less, may be 300 nm or more and 1200 nm or less, may be 300 nm or more and 1000 nm or less, may be 300 nm or more and 800 nm or less, may be 300 nm or more and 400 nm or less, may be 400 nm or more and 1500 nm or less, may be 400 nm or more and 1200 nm or less, may be 400 nm or more and 1000 nm or less, may be 400 nm or more and 800 nm or less, may be 800 nm or more and 1500 nm or less, may be 800 nm or more and 1200 nm or less, may be 800 nm or more and 1000 nm or less, may be 1000 nm or more and 1500 nm or less, may be 1000 nm or more and 1200 nm or less, or may be 1200 nm or more and 1500 nm or less.

Alternatively, for example, the thickness H4 of the second metal layer 22 may be 100 nm or more, may be 200 nm or more, may be 300 nm or more, or may be 400 nm or more. When the thickness H4 is 100 nm or more, the second metal layer 22 can be stably formed by performing the sputtering process described later. For example, the thickness H4 may be 500 nm or less, may be 600 nm or less, may be 700 nm or less, or may be 800 nm or less. When the thickness H4 is 800 nm or less, the second metal layer 22 can be more efficiently formed. The range of the thickness H4 may be determined by using the first group consisting of 100 nm, 200 nm, 300 nm, and 400 nm and/or a second group consisting of 500 nm, 600 nm, 700 nm, and 800 nm. The range of the thickness H4 may be determined by using a combination of a freely selected one of values in the first group described above and a freely selected one of values in the second group described above. The range of the thickness H4 may be determined by using a combination of freely selected two of values in the first group described above. The range of the thickness H4 may be determined by using a combination of freely selected two of values in the second group described above. For example, the range may be 100 nm or more and 800 nm or less, may be 100 nm or more and 700 nm or less, may be 100 nm or more and 600 nm or less, may be 100 nm or more and 500 nm or less, may be 100 nm or more and 400 nm or less, may be 100 nm or more and 300 nm or less, may be 100 nm or more and 200 nm or less, may be 200 nm or more and 800 nm or less, may be 200 nm or more and 700 nm or less, may be 200 nm or more and 600 nm or less, may be 200 nm or more and 500 nm or less, may be 200 nm or more and 400 nm or less, may be 200 nm or more and 300 nm or less, may be 300 nm or more and 800 nm or less, may be 300 nm or more and 700 nm or less, may be 300 nm or more and 600 nm or less, may be 300 nm or more and 500 nm or less, may be 300 nm or more and 400 nm or less, may be 400 nm or more and 800 nm or less, may be 400 nm or more and 700 nm or less, may be 400 nm or more and 600 nm or less, may be 400 nm or more and 500 nm or less, may be 500 nm or more and 800 nm or less, may be 500 nm or more and 700 nm or less, may be 500 nm or more and 600 nm or less, may be 600 nm or more and 800 nm or less, may be 600 nm or more and 700 nm or less, or may be 700 nm or more and 800 nm or less.

For example, the thickness H5 of the body-facing layer 25 may be 180 nm or more, may be 185 nm or more, 190 nm or more, or may be 195 nm or more. When the thickness H5 is 180 nm or more, the body-facing layer 25 can be stably formed by performing the sputtering process described later. For example, the thickness H5 may be 800 nm or less, may be 1000 nm or less, may be 1200 nm or less, or may be 1500 nm or less. When the thickness H5 is 1500 nm or less, the body-facing layer 25 can be efficiently formed by performing the sputtering process described later. The range of the thickness H5 may be determined by using a first group consisting of 180 nm, 185 nm, 190 nm, and 195 nm and/or the second group consisting of 800 nm, 1000 nm, 1200 nm, and 1500 nm. The range of the thickness H5 may be determined by using a combination of a freely selected one of values in the first group described above and a freely selected one of values in the second group described above. The range of the thickness H5 may be determined by using a combination of freely selected two of values in the first group described above. The range of the thickness H5 may be determined by using a combination of freely selected two of values in the second group described above. For example, the range may be 180 nm or more and 1500 nm or less, may be 180 nm or more and 1200 nm or less, may be 180 nm or more and 1000 nm or less, may be 180 nm or more and 800 nm or less, may be 180 nm or more and 195 nm or less, may be 180 nm or more and 190 nm or less, may be 180 nm or more and 185 nm or less, may be 185 nm or more and 1500 nm or less, may be 185 nm or more and 1200 nm or less, may be 185 nm or more and 1000 nm or less, may be 185 nm or more and 800 nm or less, may be 185 nm or more and 195 nm or less, may be 185 nm or more and 190 nm or less, may be 190 nm or more and 1500 nm or less, may be 190 nm or more and 1200 nm or less, may be 190 nm or more and 1000 nm or less, may be 190 nm or more and 800 nm or less, may be 190 nm or more and 195 nm or less, may be 195 nm or more and 1500 nm or less, may be 195 nm or more and 1200 nm or less, may be 195 nm or more and 1000 nm or less, may be 195 nm or more and 800 nm or less, may be 800 nm or more and 1500 nm or less, may be 800 nm or more and 1200 nm or less, may be 800 nm or more and 1000 nm or less, may be 1000 nm or more and 1500 nm or less, may be 1000 nm or more and 1200 nm or less, or may be 1200 nm or more and 1500 nm or less.

Alternatively, for example, the thickness H5 of the body-facing layer 25 may be 180 nm or more, may be 185 nm or more, may be 190 nm or more, or may be 195 nm or more. When the thickness H5 is 180 nm or more, the body-facing layer 25 can be stably formed by performing the sputtering process described later. For example, the thickness H5 may be 205 nm or less, may be 210 nm or less, may be 215 nm or less, or may be 220 nm or less. When the thickness H5 is 220 nm or less, the body-facing layer 25 can be more efficiently formed by performing the sputtering process described later. The range of the thickness H5 may be determined by using the first group consisting of 180 nm, 185 nm, 190 nm, and 195 nm and/or a second group consisting of 205 nm, 210 nm, 215 nm, and 220 nm. The range of the thickness H5 may be determined by using a combination of a freely selected one of values in the first group described above and a freely selected one of values in the second group described above. The range of the thickness H5 may be determined by using a combination of freely selected two of values in the first group described above. The range of the thickness H5 may be determined by using a combination of freely selected two of values in the second group described above. For example, the range may be 180 nm or more and 220 nm or less, may be 180 nm or more and 215 nm or less, may be 180 nm or more and 210 nm or less, may be 180 nm or more and 205 nm or less, may be 180 nm or more and 195 nm or less, may be 180 nm or more and 190 nm or less, may be 180 nm or more and 185 nm or less, may be 185 nm or more and 220 nm or less, may be 185 nm or more and 215 nm or less, may be 185 nm or more and 210 nm or less, may be 185 nm or more and 205 nm or less, may be 185 nm or more and 195 nm or less, may be 185 nm or more and 190 nm or less, may be 190 nm or more and 220 nm or less, may be 190 nm or more and 215 nm or less, may be 190 nm or more and 210 nm or less, may be 190 nm or more and 205 nm or less, may be 190 nm or more and 195 nm or less, may be 195 nm or more and 220 nm or less, may be 195 nm or more and 215 nm or less, may be 195 nm or more and 210 nm or less, may be 195 nm or more and 205 nm or less, may be 205 nm or more and 220 nm or less, may be 205 nm or more and 215 nm or less, may be 205 nm or more and 210 nm or less, may be 210 nm or more and 220 nm or less, may be 210 nm or more and 215 nm or less, or may be 215 nm or more and 220 nm or less.

For example, the thickness H6 of the substrate-facing layer 26 may be 90 nm or more, 92 nm or more, may be 94 nm or more, or may be 96 nm or more. When the thickness H6 is 90 nm or more, the substrate-facing layer 26 can be stably formed by performing the sputtering process described later. For example, the thickness H6 may be 104 nm or less, may be 106 nm or less, may be 108 nm or less, or may be 110 nm or less. When the thickness H6 is 110 nm or less, the substrate-facing layer 26 can be efficiently formed. The range of the thickness H6 may be determined by using a first group consisting of 90 nm, 92 nm, 94 nm, and 96 nm and/or a second group consisting of 104 nm, 106 nm, 108 nm, and 110 nm. The range of the thickness H6 may be determined by using a combination of a freely selected one of values in the first group described above and a freely selected one of values in the second group described above. The range of the thickness H6 may be determined by using a combination of freely selected two of values in the first group described above. The range of the thickness H6 may be determined by using a combination of freely selected two of values in the second group described above. For example, the range may be 90 nm or more and 110 nm or less, may be 90 nm or more and 108 nm or less, may be 90 nm or more and 106 nm or less, may be 90 nm or more and 104 nm or less, may be 90 nm or more and 96 nm or less, may be 90 nm or more and 94 nm or less, may be 90 nm or more and 92 nm or less, may be 92 nm or more and 110 nm or less, may be 92 nm or more and 108 nm or less, may be 92 nm or more and 106 nm or less, may be 92 nm or more and 104 nm or less, may be 92 nm or more and 96 nm or less, may be 92 nm or more and 94 nm or less, may be 94 nm or more and 110 nm or less, may be 94 nm or more and 108 nm or less, may be 94 nm or more and 106 nm or less, may be 94 nm or more and 104 nm or less, may be 94 nm or more and 96 nm or less, may be 96 nm or more and 110 nm or less, may be 96 nm or more and 108 nm or less, may be 96 nm or more and 106 nm or less, may be 96 nm or more and 104 nm or less, may be 104 nm or more and 110 nm or less, may be 104 nm or more and 108 nm or less, may be 104 nm or more and 106 nm or less, may be 106 nm or more and 110 nm or less, may be 106 nm or more and 108 nm or less, or may be 108 nm or more and 110 nm or less.

For example, the thickness H7 of the intermediate layer 27 may be 45 nm or more, may be 50 nm or more, may be 55 nm or more, or may be 65 nm or more. When the thickness H7 is 45 nm or more, the intermediate layer 27 can be stably formed by performing the sputtering process described later. For example, the thickness H7 may be 80 nm or less, may be 90 nm or less, may be 100 nm or less, or may be 110 nm or less. When the thickness H7 is 110 nm or less, the intermediate layer 27 can be efficiently formed. The range of the thickness H7 may be determined by using a first group consisting of 45 nm, 50 nm, 55 nm, and 65 nm and/or a second group consisting of 80 nm, 90 nm, 100 nm, and 110 nm. The range of the thickness H7 may be determined by using a combination of a freely selected one of values in the first group described above and a freely selected one of values in the second group described above. The range of the thickness H7 may be determined by using a combination of freely selected two of values in the first group described above. The range of the thickness H7 may be determined by using a combination of freely selected two of values in the second group described above. For example, the range may be 45 nm or more and 110 nm or less, may be 45 nm or more and 100 nm or less, may be 45 nm or more and 90 nm or less, may be 45 nm or more and 80 nm or less, may be 45 nm or more and 65 nm or less, may be 45 nm or more and 55 nm or less, may be 45 nm or more and 50 nm or less, may be 50 nm or more and 110 nm or less, may be 50 nm or more and 100 nm or less, may be 50 nm or more and 90 nm or less, may be 50 nm or more and 80 nm or less, may be 50 nm or more and 65 nm or less, may be 50 nm or more and 55 nm or less, may be 55 nm or more and 110 nm or less, may be 55 nm or more and 100 nm or less, may be 55 nm or more and 90 nm or less, may be 55 nm or more and 80 nm or less, may be 55 nm or more and 65 nm or less, may be 65 nm or more and 110 nm or less, may be 65 nm or more and 100 nm or less, may be 65 nm or more and 90 nm or less, may be 65 nm or more and 80 nm or less, may be 80 nm or more and 110 nm or less, may be 80 nm or more and 100 nm or less, may be 80 nm or more and 90 nm or less, may be 90 nm or more and 110 nm or less, may be 90 nm or more and 100 nm or less, or may be 100 nm or more and 110 nm or less.

Alternatively, for example, the thickness H7 of the intermediate layer 27 may be 45 nm or more, may be 46 nm or more, may be 47 nm or more, or may be 48 nm or more. When the thickness H7 is 45 nm or more, the intermediate layer 27 can be stably formed by performing the sputtering process described later. For example, the thickness H7 may be 52 nm or less, may be 53 nm or less, may be 54 nm or less, or may be 55 nm or less. When the thickness H7 is 55 nm or less, the intermediate layer 27 can be efficiently formed. The range of the thickness H7 may be determined by using a first group consisting of 45 nm, 46 nm, 47 nm, and 48 nm and/or a second group consisting of 52 nm, 53 nm, 54 nm, and 55 nm. The range of the thickness H7 may be determined by using a combination of a freely selected one of values in the first group described above and a freely selected one of values in the second group described above. The range of the thickness H7 may be determined by using a combination of freely selected two of values in the first group described above. The range of the thickness H7 may be determined by using a combination of freely selected two of values in the second group described above. For example, the range may be 45 nm or more and 55 nm or less, may be 45 nm or more and 54 nm or less, may be 45 nm or more and 53 nm or less, may be 45 nm or more and 52 nm or less, may be 45 nm or more and 48 nm or less, may be 45 nm or more and 47 nm or less, may be 45 nm or more and 46 nm or less, may be 46 nm or more and 55 nm or less, may be 46 nm or more and 54 nm or less, may be 46 nm or more and 53 nm or less, may be 46 nm or more and 52 nm or less, may be 46 nm or more and 48 nm or less, may be 46 nm or more and 47 nm or less, may be 47 nm or more and 55 nm or less, may be 47 nm or more and 54 nm or less, may be 47 nm or more and 53 nm or less, may be 47 nm or more and 52 nm or less, may be 47 nm or more and 48 nm or less, may be 48 nm or more and 55 nm or less, may be 48 nm or more and 54 nm or less, may be 48 nm or more and 53 nm or less, may be 48 nm or more and 52 nm or less, may be 52 nm or more and 55 nm or less, may be 52 nm or more and 54 nm or less, may be 52 nm or more and 53 nm or less, may be 53 nm or more and 55 nm or less, may be 53 nm or more and 54 nm or less, or may be 54 nm or more and 55 nm or less.

The first metal layer 21 may contain a metal material. The metal material may be a magnetic metal material. An example of the material of the first metal layer 21 may be an iron alloy that contains nickel. The iron alloy may contain cobalt in addition to nickel. For example, the material of the first metal layer 21 may be an iron alloy in which the amount of nickel and cobalt is 30 mass% or more and 54 mass% or less in total, and the amount of cobalt is 0 mass% or more and 6 mass% or less. The iron alloy that contains nickel may be an invar material that contains nickel in an amount of 34 mass% or more and 38 mass% or less or a Fe-Ni plating alloy that contains nickel in an amount of 38 mass% or more and 54 mass% or less and that has a low thermal expansion coefficient. The iron alloy that contains nickel and cobalt may be a super invar material that contains cobalt in addition to nickel in an amount of 30 mass% or more and 34 mass% or less. The use of the iron alloy enables the thermal expansion coefficient of the first metal layer 21 to be reduced. For example, in the case where the vapor deposition substrate 110 is a glass substrate, the thermal expansion coefficient of the mask layer 20 can be adjusted to a value equal or close to that of the glass substrate. This enables the precision reduction to be inhibited from being made.

For example, the material of the first metal layer 21 may be nickel or a nickel alloy that contains cobalt instead of the iron alloy that contains nickel described above. In the case where the nickel alloy that contains cobalt is used, the material of the first metal layer 21 may be a nickel alloy that contains cobalt in an amount of 8 mass% or more and 10 mass% or less. In the case where the nickel or the nickel alloy described above is used, a plating solution that is used at the first metal layer formation step described later can be inhibited from decomposing, and the stability of the plating solution can be improved.

The material of the body-facing layer 25 is not particularly limited provided that the material is capable of ensuring the adhesion to the first metal layer 21. The material of the body-facing layer 25 may be capable of functioning as a seed layer in the case where the first metal layer 21 is formed by performing an electroplating process or an electroless plating process. In the case where the electroplating process is performed, the material of the body-facing layer 25 may have low electric resistance and may have plating solution resistance. For example, in the case where the electroplating process is performed, the body-facing layer 25 may contain titanium (Ti), copper (Cu), nickel (Ni), or gold (Au). In the case where the electroless plating process is performed, the material of the body-facing layer 25 may have an ability to absorb a catalyst or may have plating solution resistance. For example, in the case where the electroless plating process is performed, the body-facing layer 25 may contain a silicon oxide (SiO), a silicon dioxide (SiO₂), siloxane (SiOR₂) zinc (Zn), titanium (Ti), copper (Cu), or nickel (Ni).

The material of the substrate-facing layer 26 is not particularly limited provided that the material is capable of ensuring the adhesion to the mask substrate 15 and is capable of reducing the erosion of the etching medium that is used at the substrate etching step described later. For example, the substrate-facing layer 26 may contain gold (Au), aluminum (Al), chromium (Cr), nickel (Ni), titanium (Ti), titanium nitride (TiN), an aluminum alloy (Al-Nd) that contains neodymium, a silicon oxide (SiO) or a silicon dioxide (SiO₂). In the case where the substrate-facing layer 26 is composed of an aluminum alloy that contains neodymium, the aluminum alloy may contain neodymium in an amount of 0.5 atomic% or more and 2 atomic% or less. Atomic% described herein is obtained by analyzing the composition of the substrate-facing layer 26 by using an XPS method. The XPS method is a method in which knowledge about the kinds or amounts of constituent elements in a region in a range of several nanometers from a surface of a sample is obtained as a result of measurement of the energy distribution of photoelectrons that are emitted from the sample when the sample is irradiated with an X-ray. In this case, the amount of each constituent element is proportional to a peak area value that is calculated by integrating the area of a peak that corresponds to the constituent element in a spectrum that is measured by X-ray photoelectron spectroscopy. Accordingly, the peak area values that correspond to the respective constituent elements are first calculated. Subsequently, the sum of the peak area values of the constituent elements is calculated, subsequently, the peak area value of the target constituent element is divided by the sum and is multiplied by 100, and consequently, the atomic% of the target constituent element can be calculated. Relationships between the amounts of the constituent elements and the peak area values differ from each other depending on, for example, sensitivity to the X-ray with respect to every constituent element. In this case, the peak area values of the constituent elements may be multiplied by a relative sensitivity coefficient for correcting a difference in sensitivity, corrected peak area values may be calculated, and the sum and atomic% described above may be subsequently calculated.

The material of the intermediate layer 27 is not particularly limited provided that the material is capable of ensuring adhesion between the body-facing layer 25 and the substrate-facing layer 26 and is capable of protecting the substrate-facing layer 26 from the plating solution that is used at the first metal layer formation step. The material of the intermediate layer 27 may have a thermal expansion coefficient that is between the thermal expansion coefficient of the body-facing layer 25 and the thermal expansion coefficient of the substrate-facing layer 26. The material of the intermediate layer 27 may have surface free energy that is between the surface free energy of the body-facing layer 25 and the surface free energy of the substrate-facing layer 26. For example, the intermediate layer 27 may contain titanium (Ti), titanium nitride (TiN), aluminum (Al), an aluminum alloy (Al-Nd) that contains neodymium, a silicon oxide (SiO), a silicon dioxide (SiO₂), nickel (Ni), copper (Cu), chromium (Cr), or gold (Au).

The mask layer 20 may include the through-holes 40. The mask layer 20 may include two or more through-holes 40. The through-holes 40 may extend through the mask layer 20. According to the present embodiment, the through-holes 40 extend from the first surface 20a to the second surface 20b through the mask layer 20. In this case, the through-holes 40 may extend through the first metal layer 21 and the second metal layer 22.

The opening dimension of each through-hole 40 in a predetermined direction (such as a first direction D11 or a second direction D12 described later) at the second surface 20b may be larger than the opening dimension of each through-hole 40 in the predetermined direction at the first surface 20a. According to an embodiment, the sectional openings of the through-holes 40 in a direction parallel with the first surface 20a may be gradually enlarged in a direction from the first surface 20a toward the second surface 20b. In other words, the sectional areas of the through-holes 40 in a section parallel with the first surface 20a at positions in the normal direction of the mask layer 20 may be gradually increased in the direction from the first surface 20a toward the second surface 20b. In this case, the through-holes 40 may include wall surfaces 41 that are gradually separated from the central axes CL of the through-holes 40 in direction from the first surface 20a toward the second surface 20b. In an example illustrated in Fig. 3, the wall surfaces 41 of the through-holes 40 are linearly inclined with respect to the central axes CL so as to be separated from the central axes CL in direction from the first surface 20a toward the second surface 20b.

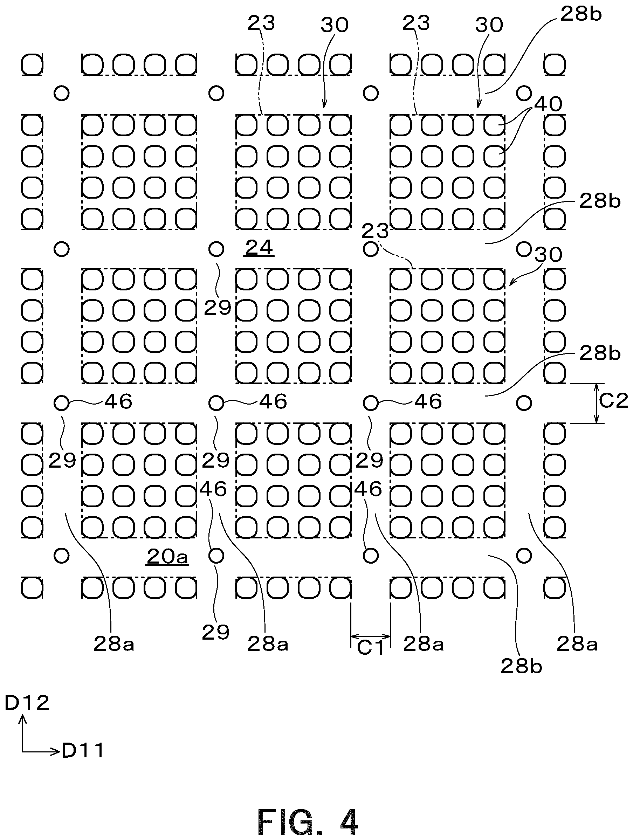

As illustrated in Fig. 2 and Fig. 4, the through-holes 40 may form two or more through-hole groups 30. The through-hole groups 30 are located in the substrate opening 16 of the mask substrate 15 in a plan view. That is, one of the through-hole groups 30 (or effective regions 23 described later) may be located in the substrate opening 16, or the multiple through-hole groups 30 (or the multiple effective regions 23) may be located therein. All of the through-hole groups 30 may be located in the single substrate opening 16. As illustrated in Fig. 4, each through-hole group 30 may be formed so that two or more through-holes 40 form a group. The through-hole groups 30 correspond to a term that means an aggregation of the multiple through-holes 40 that are regularly arranged. The through-holes 40 that form one of the through-hole groups 30 and that are on outer edges thereof are located at outermost positions among the multiple through-holes 40 that are regularly arranged in the same manner. The through-holes 40 that are regularly arranged and that are configured such that the vapor deposition material 82 is to pass through may not be present outside the through-holes 40 that are located at the outermost positions in one of the through-hole groups 30.

As illustrated in Fig. 2 and Fig. 4, mask sash bars 28a and 28b may be provided between the through-hole groups 30 adjacent to each other. The mask sash bars 28a and 28b may not include the through-holes 40 that are configured such that the vapor deposition material 82 is to pass through. The mask sash bars 28a and 28b may include first mask sash bars 28a and second mask sash bars 28b that extend in respective directions perpendicular to each other. The first mask sash bars 28a may extend in the second direction D12, and the second mask sash bars 28b may extend in the first direction D11. The multiple first mask sash bars 28a may be arranged in the first direction D11. The multiple second mask sash bars 28b may be arranged in the second direction D12. The first mask sash bars 28a and the second mask sash bars 28b intersect with each other at intersecting portions 29. The mask sash bars 28a and 28b may include through-holes and recessed portions (not illustrated) for other purposes. The through-holes and the recessed portions for the other purposes may not be regularly arranged unlike the through-holes 40 and may be thought so as not to be included in the through-hole groups 30. The mask sash bars 28a and 28b may form a portion of a surrounding region 24 described later.

As illustrated in Fig. 4, the multiple through-hole groups 30 may be arranged in a predetermined interval (a predetermined pitch). The through-hole groups 30 may be arranged in a predetermined interval in the first direction D11 and may be arranged in a predetermined interval in the second direction D12. The through-hole groups 30 may be arranged with the first mask sash bars 28a interposed therebetween in the first direction D11 and may be arranged with the second mask sash bars 28b interposed therebetween in the second direction D12. The array pitch of the through-hole groups 30 in the first direction D11 may differ from or may be equal to that in the second direction D12. In an example illustrated in Fig. 4, the array pitch in the first direction D11 is equal to the array pitch in the second direction D12. As illustrated in Fig. 4, the through-hole groups 30 may be arranged in parallel. That is, the through-hole groups 30 that are arranged in a row in the first direction D11 and the through-hole groups 30 that are arranged in another row adjacent to the row in the second direction D12 may be aligned in the second direction D12.

In Fig. 4, distances between the through-hole groups 30 adjacent to each other in the first direction D11 are illustrated as C1. The distances C1 correspond to the widths of the first mask sash bars 28a. Distances between the through-hole groups 30 adjacent to each other in the second direction D12 are illustrated as C2. The distances C2 correspond to the widths of the second mask sash bars 28b. The distances C1 and the distances C2 may differ from each other, but the distances C1 and the distances C2 are equal to each other in the example illustrated in Fig. 4. The distances C1 and C2 may be set depending on the width of a dicing saw that is used when the vapor deposition substrate 110 (see Fig. 15A) on which multiple organic devices 100 that include, for example, the organic layers 130A, 130B, and 130C are deposited is cut for every organic device 100. The vapor deposition substrate 110 may be cut by single sewing for dividing the vapor deposition substrate 110 by single cutting of regions between the organic devices 100 adjacent to each other. As for the single sewing, the vapor deposition substrate 110 can be efficiently divided in the perspective that the vapor deposition substrate 110 can be divided by the single cutting. The single sewing may be used in the case where the distances C1 and the distances C2 are relatively short. In the case where the single sewing is used, the distances C1 and the distances C2 may be equal or close to the width of the dicing saw. Instead of the single sawing, the vapor deposition substrate 110 may be cut by double sawing for dividing the vapor deposition substrate 110 by double cutting of the regions between the organic devices 100 adjacent to each other. For example, the double cutting that is performed includes cutting at a position along one of edges of each organic device 100 and cutting at a position along another edge of each organic device 100. The double sawing may be used in the case where the distances C1 and the distances C2 are relatively long, or in the case where the width of the dicing saw is relatively narrow. In the case where the double sawing is used, the use of the double sawing that has the narrow width enables a time for cutting the vapor deposition substrate 110 to be reduced.

For example, the distances C1 and C2 may be 30 µm or more, may be 50 µm or more, may be 100 µm or more, and may be 150 µm or more. When the distances C1 and C2 are 30 µm or more, a cutting width for cutting the vapor deposition substrate 110 by the single sewing with the dicing saw can be ensured, and the strength of the vapor deposition mask 10 can be improved. For example, the distances C1 and C2 may be 240 µm or less, may be 260 µm or less, may be 280 µm or less, and may be 300 µm or less. When the distances C1 and C2 are 300 µm or less, the efficiency of attachment to the vapor deposition substrate 110 can be improved. The ranges of the distances C1 and C2 may be determined by using a first group consisting of 30 µm, 50 µm, 100 µm, and 150 µm and/or a second group consisting of 240 µm, 260 µm, 280 µm, and 300 µm. The ranges of the distances C1 and C2 may be determined by using a combination of a freely selected one of values in the first group described above and a freely selected one of values in the second group described above. The ranges of the distances C1 and C2 may be determined by using a combination of freely selected two of values in the first group described above. The ranges of the distances C1 and C2 may be determined by using a combination of freely selected two of values in the second group described above. For example, the ranges may be 30 µm or more and 300 µm or less, may be 30 µm or more and 280 µm or less, may be 30 µm or more and 260 µm or less, may be 30 µm or more and 240 µm or less, may be 30 µm or more and 150 µm or less, may be 30 µm or more and 100 µm or less, may be 30 µm or more and 50 µm or less, may be 50 µm or more and 300 µm or less, may be 50 µm or more and 280 µm or less, may be 50 µm or more and 260 µm or less, may be 50 µm or more and 240 µm or less, may be 50 µm or more and 150 µm or less, may be 50 µm or more and 100 µm or less, may be 100 µm or more and 300 µm or less, may be 100 µm or more and 280 µm or less, may be 100 µm or more and 260 µm or less, may be 100 µm or more and 240 µm or less, may be 100 µm or more and 150 µm or less, may be 150 µm or more and 300 µm or less, may be 150 µm or more and 280 µm or less, may be 150 µm or more and 260 µm or less, may be 150 µm or more and 240 µm or less, may be 240 µm or more and 300 µm or less, may be 240 µm or more and 280 µm or less, may be 240 µm or more and 260 µm or less, may be 260 µm or more and 300 µm or less, may be 260 µm or more and 280 µm or less, or may be 280 µm or more and 300 µm or less.

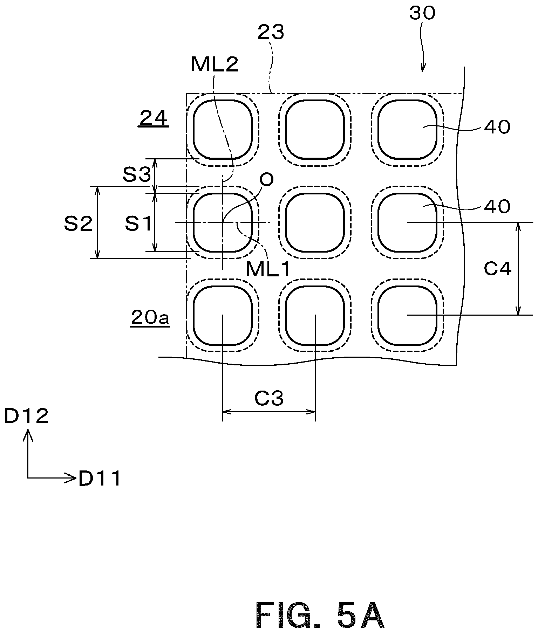

As for one of the through-hole groups 30, as illustrated in Fig. 4 and Fig. 5A, the multiple through-holes 40 may be arranged at a predetermined interval or a predetermined pitch. The through-holes 40 may be arranged at a predetermined pitch (reference characters C3 illustrated in Fig. 5A) in the first direction D11 and may be arranged at a predetermined pitch (reference characters C4 illustrated in Fig. 5A) in the second direction D12. The array pitches C3 and C4 of the through-holes 40 in the first direction D11 and the second direction D12 may differ from each other or may be equal to each other. In an example illustrated in Fig. 5A, the array pitch C3 in the first direction D11 is equal to the array pitch C4 in the second direction D12. As illustrated in Fig. 5A, the through-holes 40 may be arranged in parallel. That is, the through-holes 40 that are arranged in a row in the first direction D11 and the through-holes 40 that are arranged in another row adjacent to the row in the second direction D12 may be aligned in the second direction D12. The array pitches C3 and C4 of the through-holes 40 may be determined depending on the pixel density of a display device or a projecting device, for example, in the following manner.
· In the case where the pixel density is 600 ppi or more, the pitches are 42.3 µm or less.
· In the case where the pixel density is 1200 ppi or more, the pitches are 21.2 µm or less.
· In the case where the pixel density is 3000 ppi or more, the pitches are 8.5 µm or less.
· In the case where the pixel density is 5000 ppi or more, the pitches are 5.1 µm or less.

The display device or the projecting device that has a pixel density of 600 ppi may be used to display an image or a picture at a distance of about 15 cm from the eyeball and may be used for, for example, a smart phone. The display device or the projecting device that has a pixel density of 1200 ppi may be used to display an image or a picture at a distance of about 8 cm from the eyeball and may be used to display or project an image or a picture, for example, for expressing virtual reality (so-called VR). The display device or the projecting device that has a pixel density of 3000 ppi may be used to display an image or a picture at a distance of about 3 cm from the eyeball and may be used to display or project an image or a picture, for example, for expressing augmented reality (so-called AR). The display device or the projecting device that has a pixel density of 5000 ppi may be used to display an image or a picture at a distance of about 2 cm from the eyeball and may be used to display or project an image or a picture, for example, for expressing augmented reality.

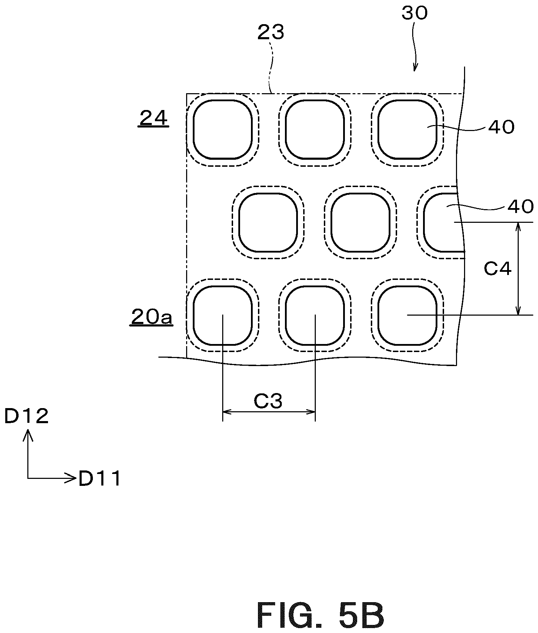

As for one of the through-hole groups 30, as illustrated in Fig. 5B, the through-holes 40 may be arranged in a staggered arrangement instead of parallel arrangement. That is, the through-holes 40 that are arranged in a row in the first direction D11 and the through-holes 40 that are arranged in another row adjacent to the row in the second direction D12 may be not aligned in the second direction D12. In an example illustrated in Fig. 5B, the through-holes 40 that are arranged in a row and the through-holes 40 that are arranged in another row adjacent to the row are shifted from each other in the first direction D11, and shifting amounts are half of the array pitch C3 in the first direction. The present disclosure, however, is not limited thereto, and the shifting amounts described above are not limited to half of the array pitch C3. In the example illustrated in Fig. 5B, two rows of the through-holes 40 adjacent to each other in the second direction D12 are shifted in the first direction D11, but two columns of the through-holes 40 adjacent to each other in the first direction D11 may be shifted in the second direction D12.

As illustrated in Fig. 5A, each through-hole 40 may have a contour that has a substantially rectangular shape in a plan view. In this case, four corners of the contour of each through-hole 40 may curve. The shape of the contour can be freely determined depending on the shapes of the pixels. Examples thereof may include another polygonal shape such as a hexagonal shape or an octagonal shape, and a circular shape. The shape of the contour may be a combination of multiple shapes. The contours of the through-holes 40 may have different shapes. The opening dimension of each through-hole 40 in the first direction D11 may be a dimension between two intersecting points at which a straight line (corresponding to a first intermediate straight line ML1 described later in Fig. 5A) that passes through the center O of the opening and that extends in the first direction D11 intersects with the contour of the opening. The opening dimension of each through-hole 40 in the second direction D12 may be a dimension between two intersecting points at which a straight line (corresponding to a second intermediate straight line ML2 described later in Fig. 5A) that passes through the center O of the opening and that extends in the second direction D12 intersects with the contour of the opening. The center O of the opening of each through-hole 40 at the first surface 20a and the second surface 20b may be an intersecting point of the first intermediate straight line ML1 and the second intermediate straight line ML2. The first intermediate straight line ML1 may be at the same distance from two straight lines that extend in the first direction D11 and that are circumscribed by the contour of the opening. The second intermediate straight line ML2 may be at the same distance from two straight lines that extend in the second direction D12 and that are circumscribed by the contour of the opening. In the case where each through-hole 40 has a contour that has a polygonal shape that has even numbered vertexes, as illustrated in Fig. 5A, the opening dimension of the through-hole 40 may be a distance between two facing sides of the polygonal shape.

In Fig. 5A, the opening dimension of one of the through-holes 40 at the first surface 20a of the mask layer 20 is illustrated by using reference characters S1. The opening dimension of the through-hole 40 at the second surface 20b of the mask layer 20 is illustrated by using reference characters S2. The opening dimension S2 is larger than the opening dimension S1. In Fig. 5A, the planar shape of the through-hole 40 is a square shape, and accordingly, the opening dimension of the through-hole 40 in the first direction D11 and the opening dimension of the through-hole 40 in the second direction D12 are equal to each other. The dimension of the through-hole 40 in the second direction D12 is representatively illustrated by using the reference characters S1 and S2. A reference character S3 represents a distance between the through-holes 40 adjacent to each other at the first surface 20a.

The dimension S1, the dimension S2, and the dimension S3 may be determined depending on the pixel density of the display device or the projecting device, for example, as illustrated in Table 1 below.

**[Table 1]**

| Pixel density | S1 | S2 | S3 |
|---|---|---|---|
| 600ppi | 14.0 µm or more and 28.0 µm or less | 14.0 µm or more and 40.0 µm or less | 14.0 µm or more and 28.0 µm or less |
| 1200ppi | 7.0 µm or more and 15.0 µm or less | 7.0 µm or more and 19.0 µm or less | 6.0 µm or more and 14.0 µm or less |
| 3000ppi | 3.0 µm or more and 6.0 µm or less | 3.0 µm or more and 7.0 µm or less | 2.5 µm or more and 5.5 µm or less |
| 5000ppi | 1.7 µm or more and 3.4 µm or less | 1.7 µm or more and 4.0 µm or less | 1.7 µm or more and 3.4 µm or less |

As illustrated in Fig. 3, the wall surfaces 41 of the through-holes 40 described above may be inclined at an angle θ1 with respect to the first surface 20a of the mask layer 20.

For example, the angle θ1 may be 60° or more, may be 65° or more, may be 70° or more, or may be 75° or more. When the angle θ1 is 60° or more, the array pitches C3 and C4 of the through-holes 40 can be reduced as described later. For example, the angle θ1 may be 80° or less, may be 83° or less, may be 85° or less, or may be 90° or less. When the angle θ1 is 90° or less, shadow can be inhibited from occurring. The range of the angle θ1 may be determined by using a first group consisting of 60°, 65°, 70°, and 75° and/or a second group consisting of 80°, 83°, 85°, and 90°. The range of the angle θ1 may be determined by using a combination of a freely selected one of values in the first group described above and a freely selected one of values in the second group described above. The range of the angle θ1 may be determined by using a combination of freely selected two of values in the first group described above. The range of the angle θ1 may be determined by using a combination of freely selected two of values in the second group described above. For example, the range may be 60° or more and 90° or less, may be 60° or more and 85° or less, may be 60° or more and 83° or less, may be 60° or more and 80° or less, may be 60° or more and 75° or less, may be 60° or more and 70° or less, may be 60° or more and 65° or less, may be 65° or more and 90° or less, may be 65° or more and 85° or less, may be 65° or more and 83° or less, may be 65° or more and 80° or less, may be 65° or more and 75° or less, may be 65° or more and 70° or less, may be 70° or more and 90° or less, may be 70° or more and 85° or less, may be 70° or more and 83° or less, may be 70° or more and 80° or less, may be 70° or more and 75° or less, may be 75° or more and 90° or less, may be 75° or more and 85° or less, may be 75° or more and 83° or less, may be 75° or more and 80° or less, may be 80° or more and 90° or less, may be 80° or more and 85° or less, may be 80° or more and 83° or less, may be 83° or more and 90° or less, may be 83° or more and 85° or less, or may be 85° or more and 90° or less.

The technical meaning of the angle θ1 will now be described. Components of a direction in which the vapor deposition material 82 comes at the vapor deposition step at which the vapor deposition material 82 is deposited on the vapor deposition substrate 110 by using the vapor deposition mask 10 will be described. In some cases, the components include a component when the vapor deposition material 82 comes in the thickness direction D2 of the vapor deposition mask 10 from the vapor deposition source (the crucible 81) toward the vapor deposition substrate 110 and a component when the vapor deposition material 82 comes in a direction inclining with respect to the thickness direction D2 of the vapor deposition mask 10, which depends on the structure of the crucible 81 illustrated in Fig. 1. In these cases, the vapor deposition material 82 that comes in the inclining direction is partly attached to the second surface 20b of the mask layer 20 and the wall surfaces 41 of the through-holes 40 before reaching the vapor deposition substrate 110. For this reason, the thickness of the vapor deposition layer (or the organic layers 130A, 130B, and 130C described later) that is formed on the vapor deposition substrate 110 is likely to reduce as the position is nearer to the wall surfaces 41 of the through-holes 40. This phenomenon is also referred to as shadow where the wall surfaces 41 of the through-holes 40 impede the attachment of the vapor deposition material 82 to the vapor deposition substrate 110. A conceivable measure for inhibiting shadow from occurring is to reduce the angle θ1 described above or to reduce the thickness H2 of the mask layer 20.

Reducing the angle θ1 means enlarging the openings of the through-holes 40 at the second surface 20b. In this case, the wall surfaces 41 of the through-holes 40 adjacent to each other at the second surface 20b are connected, and consequently, the second surface 20b is not present between the through-holes 40. That is, a material between the through-holes 40 adjacent to each other at the second surface 20b is removed by being irradiated with laser light at the through-hole formation step described later. For this reason, the angle θ1 may not be too small. In this case, the mechanical strength of the mask layer 20 can be ensured, and the array pitches C3 and C4 of the through-holes 40 can be reduced.

In the case where the angle θ1 is inhibited from being too small, the thickness H2 of the mask layer 20 may be reduced. Consequently, shadow can be inhibited from occurring. However, merely reducing the thickness H2 means reducing the mechanical strength of the mask layer 20. For this reason, the thickness H2 may not be excessively reduced. In this case, the mechanical strength of the mask layer 20 can be ensured.

In view of this, according to the present embodiment, the angle θ1 is relatively large, for example, 60° or more. The angle θ1 is larger than, for example, 50° or less in the case of an existing vapor deposition mask. For this reason, the wall surfaces 41 of the through-holes 40 can be formed in a shape nearly perpendicular to the first surface 20a and the second surface 20b of the mask layer 20, and the material of the mask layer 20 can remain near the through-holes 40. Accordingly, the mechanical strength of the mask layer 20 can be improved. Increasing the angle θ1 enables the array pitches C3 and C4 of the through-holes 40 to be reduced.

The angle θ1 of the vapor deposition mask 10 according to the present embodiment is thus 60° or more and 90° or less. For this reason, the vapor deposition mask 10 according to the present embodiment may be used for the vapor deposition apparatus 80 that includes the crucible 81 that has a vapor deposition angle (for example, 60° or more and 90° or less) of 90° or close to 90° or may be used for a vapor deposition apparatus (not illustrated) in a surface vapor deposition method. As for the vapor deposition apparatus 80 that includes the crucible 81 illustrated in Fig. 1, a component when the vapor deposition material 82 comes in a direction inclining with respect to the thickness direction D2 is included in some cases. As for the vapor deposition apparatus in the surface vapor deposition method, however, the vapor deposition source that is disposed below the vapor deposition substrate 110 has a planar spread so as to face the vapor deposition mask 10. This enables the vapor deposition material 82 to come in the thickness direction D2 to the vapor deposition substrate 110. For this reason, the vapor deposition material 82 can come evenly in the first direction D11 and in the second direction D12. The vapor deposition angle is 90° or close to 90°.

In some cases, one of the through-hole groups 30 is referred to as one of the effective regions 23. In some cases, a region around each effective region 23 is referred to as the surrounding region 24. In this case, the surrounding region 24 surrounds the multiple effective regions 23.

In the case where a display device such as the organic device 100 (described later) is manufactured by using the vapor deposition mask 10, one of the effective regions 23 corresponds to a display region of the single organic device 100. For this reason, the vapor deposition mask 10 illustrated in Fig. 2 enables the multiple organic devices 100 to be deposited on the single vapor deposition substrate 110. Such vapor deposition is also referred to as multi-attachment vapor deposition. In some cases, one of the effective regions 23 corresponds to display regions of the multiple organic devices 100.

As illustrated in, for example, Fig. 4, each effective region 23 may have a contour that has a substantially rectangular shape in a plan view. The contour of each effective region 23 may be defined by using a line that is circumscribed by the through-hole 40 that is located at the outermost position among the through-hole groups 30 that correspond thereto. More specifically, the contour of each effective region 23 may be defined by using a line that is in contact with the opening of the through-hole 40. In the example illustrated in Fig. 4, the through-holes 40 are arranged in parallel, and accordingly, the contour of each effective region 23 has a substantially rectangular shape. Each effective region 23 may have a contour that has a shape depending on the shape of the display region of each organic device 100 among various shapes. For example, each effective region 23 may have a contour that has a circular shape.

As illustrated in Fig. 2 and Fig. 3, first alignment marks 45 for adjusting the position of the vapor deposition substrate 110 may be provided on the mask substrate 15. The first alignment marks 45 can be located at freely determined positions, provided that the positions of the through-holes 40 of the vapor deposition mask 10 and the position of the vapor deposition substrate 110 can be adjusted. For example, as illustrated in Fig. 2 and Fig. 3, the first alignment marks 45 may be formed on the second substrate surface 15b of the mask substrate 15 at the substrate frame body 17. In the case where the vapor deposition substrate 110 has optical transparency that means properties that enable visible light to pass therethrough, the first alignment marks 45 that are provided on the mask substrate 15 can be visually recognized through the vapor deposition substrate 110, and the position of the vapor deposition substrate 110 and the positions of the through-holes 40 of the vapor deposition mask 10 can be easily adjusted. In the case where the vapor deposition substrate 110 does not have the optical transparency, for example, the first alignment marks 45 may be visually recognized by being irradiated with infrared rays via the vapor deposition substrate 110. In an example illustrated in Fig. 2, the planar shape of each first alignment mark 45 is a circular shape but is not limited thereto and may be a freely determined shape such as a rectangular shape or a cross shape. The first alignment marks 45 may be formed in a recessed shape by etching the second substrate surface 15b of the mask substrate 15 at the substrate etching step described later.

As illustrated in Fig. 3 and Fig. 4, second alignment marks 46 for adjusting the position of the vapor deposition substrate 110 may be provided on the first surface 20a of the mask layer 20. The second alignment marks 46 can be located at freely determined positions, provided that the positions of the through-holes 40 of the vapor deposition mask 10 and the position of the vapor deposition substrate 110 can be adjusted. For example, the second alignment marks 46 may be nearer than the first alignment marks 45 to the through-holes 40. For example, as illustrated in Fig. 3 and Fig. 4, the second alignment marks 46 may be formed on the first surface 20a of the mask layer 20 in the substrate opening 16 of the mask substrate 15 in a plan view. For example, the second alignment marks 46 may be located on the mask sash bars 28a and 28b that are formed between the through-hole groups 30 adjacent to each other. For example, the second alignment marks 46 may be located at the intersecting portions 29 at which the first mask sash bars 28a and the second mask sash bars 28b intersect with each other. In Fig. 4, the second alignment marks 46 are provided at the intersecting portions 29 at which the first mask sash bars 28a and the second mask sash bars 28b intersect with each other. In other words, the second alignment marks 46 are located on the first mask sash bars 28a, and the second alignment marks 46 are located on the second mask sash bars 28b. In this case, the second alignment marks 46 are located at positions that correspond to those of each corner portion of each through-hole group 30.

In the case where the vapor deposition substrate 110 has the optical transparency for visible light, the second alignment marks 46 that are provided on the mask layer 20 can be visually recognized through the vapor deposition substrate 110, and the position of the vapor deposition substrate 110 and the positions of the through-holes 40 of the vapor deposition mask 10 can be easily adjusted. In the case where the vapor deposition substrate 110 does not have the optical transparency, for example, the second alignment marks 46 may be visually recognized by being irradiated with infrared rays via the vapor deposition substrate 110. In the example illustrated in Fig. 4, the planar shape of each second alignment mark 46 is a circular shape but is not limited thereto and may be a freely determined shape such as a rectangular shape or a cross shape. The second alignment marks 46 may be formed in a recessed shape, for example, by irradiating the first surface 20a of the first metal layer 21 with laser light. The present disclosure, however, is not limited thereto, and the second alignment marks 46 may be formed in a recessed shape, for example, by etching the first surface 20a of the first metal layer 21. Alternatively, as for the second alignment marks 46, the first metal layer 21 may be formed so as to include the second alignment marks 46, for example, by performing a plating process at the first metal layer formation step. In this case, the first metal layer 21 may be formed by performing the plating process with resists (not illustrated) formed at positions that correspond to those of the second alignment marks 46 on a surface of the second metal layer 22 opposite the mask substrate 15. This enables the second alignment marks 46 that extend through the first metal layer 21 to be formed.

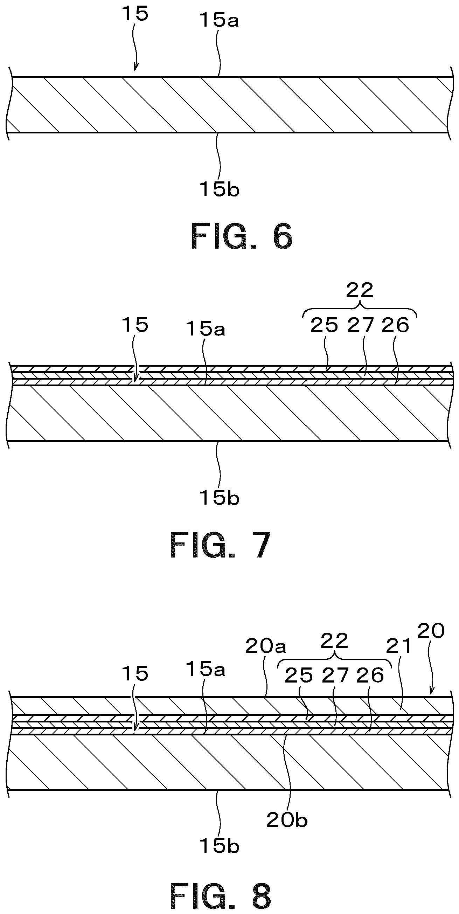

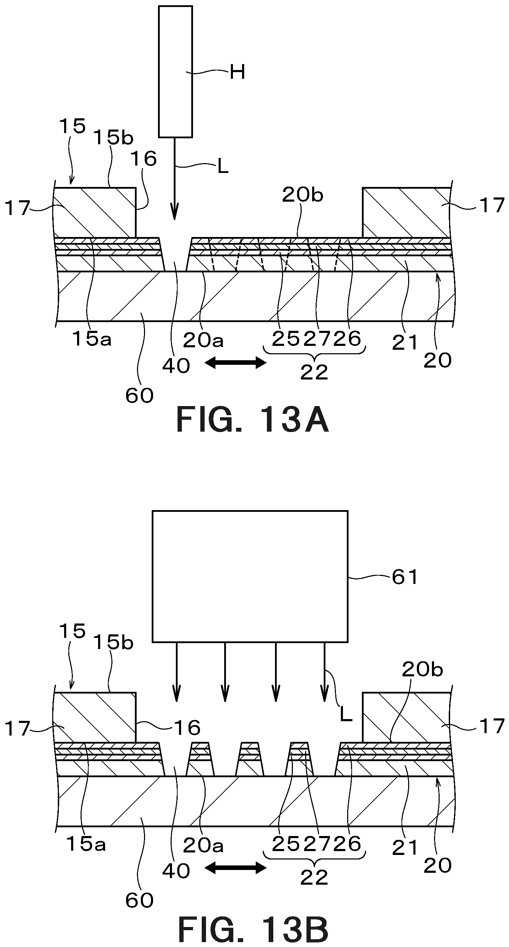

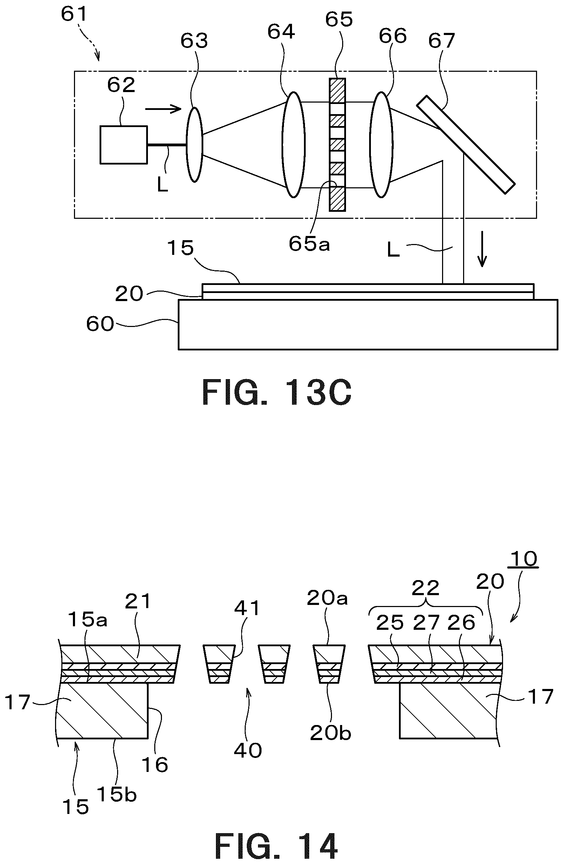

A method of manufacturing the vapor deposition mask 10 that is thus configured will now be described with reference to Fig. 6 to Fig. 14. In an example described herein, the mask substrate 15 is a silicon substrate. The method of manufacturing the vapor deposition mask 10 according to the present embodiment may include a substrate preparation step, a mask layer formation step, a substrate opening formation step, and a through-hole formation step. In Fig. 13 and Fig. 14, the number of the through-holes 40 is smaller than that in Fig. 3 to make the figure easy to understand.

At the substrate preparation step, as illustrated in Fig. 6, the mask substrate 15 that includes the first substrate surface 15a and the second substrate surface 15b may be prepared. For example, the mask substrate 15 may be a silicon wafer that has a plane orientation of (110) where the first substrate surface 15a and the second substrate surface 15b are polished mirror surfaces.

At the mask layer formation step after the substrate preparation step, the mask layer 20 that includes the first surface 20a and the second surface 20b may be formed on the mask substrate 15. The second surface 20b of the mask layer 20 faces the mask substrate 15 and is attached to the first substrate surface 15a of the mask substrate 15. At the mask layer formation step according to the present embodiment, a second metal layer formation step of forming the second metal layer 22 is first performed, and the first metal layer formation step of forming the first metal layer 21 is subsequently performed. The first metal layer formation step is an example of a mask body layer formation step, and the second metal layer formation step is an example of a mask intermediate layer formation step.

At the second metal layer formation step, as illustrated in Fig. 7, the second metal layer 22 is formed on the first substrate surface 15a of the mask substrate 15. More specifically, the second metal layer 22 that includes the body-facing layer 25, the substrate-facing layer 26, and the intermediate layer 27 is formed on the mask substrate 15.

The substrate-facing layer 26 is first formed. The substrate-facing layer 26 may be formed on the whole of the first substrate surface 15a of the mask substrate 15. The substrate-facing layer 26 may be formed, for example, by performing the sputtering process in which a spattering target composed of the material of the substrate-facing layer 26 is used. The substrate-facing layer 26 formed is attached to the mask substrate 15.

Subsequently, the intermediate layer 27 is formed on the substrate-facing layer 26. The intermediate layer 27 may be formed on the whole of the surface of the substrate-facing layer 26. The intermediate layer 27 may be formed, for example, by performing the sputtering process in which a spattering target composed of the material (such as titanium) of the intermediate layer 27 is used. The intermediate layer 27 formed is attached to the substrate-facing layer 26.

Subsequently, the body-facing layer 25 is formed on the intermediate layer 27. The body-facing layer 25 may be formed on the whole of the surface of the intermediate layer 27. The body-facing layer 25 may be formed, for example, by performing the sputtering process in which a spattering target composed of the material (such as copper) of the body-facing layer 25 is used. The body-facing layer 25 formed is attached to the intermediate layer 27.

In this way, the second metal layer 22 that includes the body-facing layer 25, the substrate-facing layer 26, and the intermediate layer 27 is attached to the mask substrate 15.

At the first metal layer formation step, as illustrated in Fig. 8, the first metal layer 21 is formed on the surface of the second metal layer 22 opposite the mask substrate 15. More specifically, the first metal layer 21 is formed on the body-facing layer 25. The first metal layer 21 may be formed, for example, by performing the plating process. The first metal layer 21 is formed by performing an electroplating process with the second metal layer 22 used as a power supply electrode. More specifically, the plating solution is supplied to the surface of the body-facing layer 25 opposite the mask substrate 15. For example, the mask substrate 15 on which the second metal layer 22 is formed is immersed in a plating tank that is filled with the plating solution. The body-facing layer 25 of the second metal layer 22 described above functions as the power supply electrode for plating. Consequently, the components of the plating solution precipitate on the surface of the body-facing layer 25 opposite the mask substrate 15, and the first metal layer 21 is formed. The first metal layer 21 may be formed on the whole of the surface of the body-facing layer 25 opposite the mask substrate 15. In this way, the first metal layer 21 is attached to the body-facing layer 25.

The components of the plating solution to be used are appropriately determined depending on characteristics that are required for the first metal layer 21. For example, in the case where the first metal layer 21 is composed of an iron alloy that contains nickel, the plating solution may be a mixed solution of a solution that contains a nickel compound and a solution that contains an iron compound. For example, a mixed solution of a solution that contains sulfamic acid nickel and nickel bromide and a solution that contains sulfamic acid ferrous may be used. For example, in the case where the first metal layer 21 is composed of nickel, the plating solution may be a solution that contains a nickel compound. For example, sulfamic acid nickel solution may be used. In the case where the first metal layer 21 is composed of a nickel alloy that contains cobalt, the plating solution may be a mixed solution of a solution that contains a nickel compound and a solution that contains a cobalt compound. For example, a sulfamic acid cobalt solution may be used. The plating solution described above may contain various additives. Examples of the additives may include a pH buffer material such as boric acid and an additive such as malonic acid or saccharin.

After the first metal layer 21 is formed, an annealing treatment (a firing treatment) may be performed on the first metal layer 21. This enables the first metal layer 21 that is formed by performing the plating process to be recrystallized and enables the thermal expansion coefficient of the first metal layer 21 to be reduced. That is, the thermal expansion coefficient of a plating material typically tends to be higher than the thermal expansion coefficient of a rolled material even in the case where the rolled material that is manufactured by performing a rolling process and the plating material that is manufactured by performing the plating process contain the same material component. For this reason, the first metal layer 21 may be recrystallized, and the thermal expansion coefficient of the first metal layer 21 may be reduced. In the annealing treatment, the first metal layer 21 may be heated at a temperature of, for example, 600°C for 5 minutes.

As for the first metal layer formation step, a specific method of performing the plating process is not particularly limited provided that the first metal layer 21 can be formed. For example, the electroless plating process may be performed instead of the electroplating process. In the case where the electroless plating process is performed, there is no electrode as in the electroplating process, and accordingly, the thickness of the first metal layer 21 that is formed by performing the electroless plating process can be uniform. In the case where the electroless plating process is performed, a catalyst layer (not illustrated) may be provided on the surface of the second metal layer 22 opposite the mask substrate 15. Also in the case where the electroplating process is performed, the catalyst layer may be provided on the second metal layer 22.

At the substrate opening formation step after the mask layer formation step, the substrate opening 16 through which the second surface 20b of the mask layer 20 is exposed may be formed in the mask substrate 15. At the substrate opening formation step according to the present embodiment, a resist layer formation step, the substrate etching step, and a resist layer removal step are performed in this order.

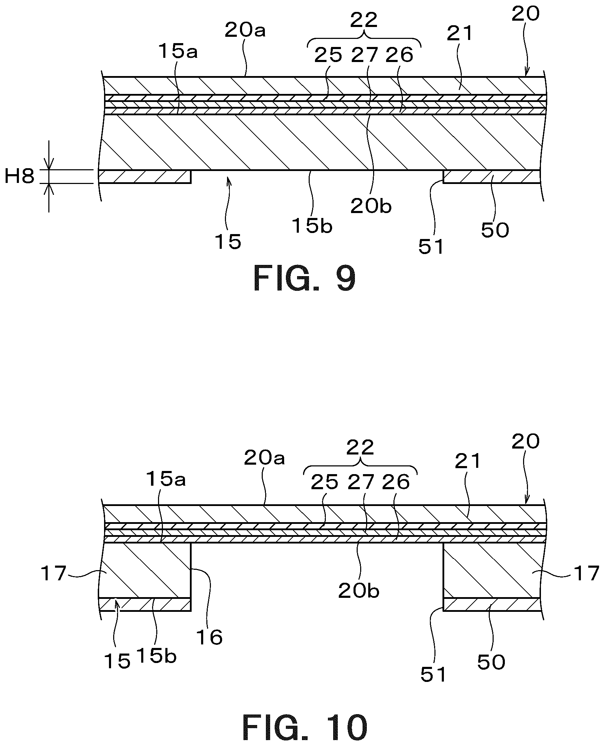

At the resist layer formation step, as illustrated in Fig. 9, a resist layer 50 is formed on the second substrate surface 15b of the mask substrate 15. The resist layer 50 includes a resist opening 51 that corresponds to the substrate opening 16. More specifically, liquid resist is first applied to the second substrate surface 15b of the mask substrate 15 by using a spinner, dried, and hardened, and consequently, the resist layer 50 is formed. The resist layer 50 may be formed on the whole of the second substrate surface 15b. Subsequently, the resist layer 50 is patterned by performing a photolithography process. For example, in the case where the resist layer 50 is negative resist, an exposure mask (not illustrated) is disposed on the resist layer 50 such that a portion of the resist layer 50 that corresponds to the resist opening 51 is not irradiated with light. Subsequently, the resist layer 50 is exposed to light via the exposure mask. The resist layer 50 exposed to light is developed, the portion of the resist layer 50 that is not exposed to light is removed, and the resist opening 51 is formed. After development, the resist layer 50 may be heated, and adhesion of the resist layer 50 to the mask substrate 15 may be improved. An example of the negative resist may be novolak resist. The resist layer 50 may be positive resist. Dry film resist that serves as the resist layer 50 may be stuck to the mask substrate 15.

For example, the thickness H8 of the resist layer 50 may be 0.1 µm or more, may be 0.5 µm or more, may be 1.0 µm or more, or may be 1.5 µm or more. When the thickness H8 is 0.1 µm or more, a portion that is covered by the resist layer 50 can be inhibited from being etched at the substrate etching step described later. For example, the thickness H8 may be 20.0 µm or less, may be 30.0 µm or less, may be 40.0 µm or less, or may be 50.0 µm or less. When the thickness H8 is 50.0 µm or less, availability can be ensured in the case of the dry film resist, and the resist layer 50 can be efficiently formed in the case of the liquid resist. The range of the thickness H8 may be determined by using a first group consisting of 0.1 µm, 0.5 µm, 1.0 µm, and 1.5 µm and/or a second group consisting of 20.0 µm, 30.0 µm, 40.0 µm, and 50.0 µm. The range of the thickness H8 may be determined by using a combination of a freely selected one of values in the first group described above and a freely selected one of values in the second group described above. The range of the thickness H8 may be determined by using a combination of freely selected two of values in the first group described above. The range of the thickness H8 may be determined by using a combination of freely selected two of values in the second group described above. For example, the range may be 0.1 µm or more and 50.0 µm or less, may be 0.1 µm or more and 40.0 µm or less, may be 0.1 µm or more and 30.0 µm or less, may be 0.1 µm or more and 20.0 µm or less, may be 0.1 µm or more and 1.5 µm or less, may be 0.1 µm or more and 1.0 µm or less, may be 0.1 µm or more and 0.5 µm or less, may be 0.5 µm or more and 50.0 µm or less, may be 0.5 µm or more and 40.0 µm or less, may be 0.5 µm or more and 30.0 µm or less, may be 0.5 µm or more and 20.0 µm or less, may be 0.5 µm or more and 1.5 µm or less, may be 0.5 µm or more and 1.0 µm or less, may be 1.0 µm or more and 50.0 µm or less, may be 1.0 µm or more and 40.0 µm or less, may be 1.0 µm or more and 30.0 µm or less, may be 1.0 µm or more and 20.0 µm or less, may be 1.0 µm or more and 1.5 µm or less, may be 1.5 µm or more and 50.0 µm or less, may be 1.5 µm or more and 40.0 µm or less, may be 1.5 µm or more and 30.0 µm or less, may be 1.5 µm or more and 20.0 µm or less, may be 20.0 µm or more and 50.0 µm or less, may be 20.0 µm or more and 40.0 µm or less, may be 20.0 µm or more and 30.0 µm or less, may be 30.0 µm or more and 50.0 µm or less, may be 30.0 µm or more and 40.0 µm or less, or may be 40.0 µm or more and 50.0 µm or less.

Alternatively, for example, the thickness H8 of the resist layer 50 may be 0.1 µm or more, may be 0.2 µm or more, may be 0.3 µm or more, or may be 0.4 µm or more. When the thickness H8 is 0.1 µm or more, the portion that is covered by the resist layer 50 can be inhibited from being etched at the substrate etching step described later. For example, H8 may be 0.6 µm or less, may be 0.7 µm or less, may be 0.8 µm or less, or may be 0.9 µm or less. When the thickness H8 is 0.9 µm or less, availability can be ensured with more certainty in the case of the dry film resist, and the resist layer 50 can be more efficiently formed in the case of the liquid resist. The range of H8 may be determined by using a first group consisting of 0.1 µm, 0.2 µm, 0.3 µm, and 0.4 µm and/or a second group consisting of 0.6 µm, 0.7 µm, 0.8 µm, and 0.9 µm. The range of H8 may be determined by using a combination of a freely selected one of values in the first group described above and a freely selected one of values in the second group described above. The range of H8 may be determined by using a combination of freely selected two of values in the first group described above. The range of H8 may be determined by using a combination of freely selected two of values in the second group described above. For example, the range may be 0.1 µm or more and 0.9 µm or less, may be 0.1 µm or more and 0.8 µm or less, may be 0.1 µm or more and 0.7 µm or less, may be 0.1 µm or more and 0.6 µm or less, may be 0.1 µm or more and 0.4 µm or less, may be 0.1 µm or more and 0.3 µm or less, may be 0.1 µm or more and 0.2 µm or less, may be 0.2 µm or more and 0.9 µm or less, may be 0.2 µm or more and 0.8 µm or less, may be 0.2 µm or more and 0.7 µm or less, may be 0.2 µm or more and 0.6 µm or less, may be 0.2 µm or more and 0.4 µm or less, may be 0.2 µm or more and 0.3 µm or less, may be 0.3 µm or more and 0.9 µm or less, may be 0.3 µm or more and 0.8 µm or less, may be 0.3 µm or more and 0.7 µm or less, may be 0.3 µm or more and 0.6 µm or less, may be 0.3 µm or more and 0.4 µm or less, may be 0.4 µm or more and 0.9 µm or less, may be 0.4 µm or more and 0.8 µm or less, may be 0.4 µm or more and 0.7 µm or less, may be 0.4 µm or more and 0.6 µm or less, may be 0.6 µm or more and 0.9 µm or less, may be 0.6 µm or more and 0.8 µm or less, may be 0.6 µm or more and 0.7 µm or less, may be 0.7 µm or more and 0.9 µm or less, may be 0.7 µm or more and 0.8 µm or less, or may be 0.8 µm or more and 0.9 µm or less.

At the substrate etching step, as illustrated in Fig. 10, the mask substrate 15 is etched through the resist opening 51, and the substrate opening 16 is formed. Consequently, a portion of the second surface 20b of the mask layer 20 is exposed through the substrate opening 16. The process of etching the mask substrate 15 may be a dry etching process in which etching gas is used. The etching gas is an example of the etching medium. In this case, the mask substrate 15 may be etched by using, for example, the etching gas such as DEEP-RIE, ICP (Inductively Coupled Plasma), SF6 gas, CF gas, or chlorine gas. In the case where the dry etching process is performed, an etching speed can be increased, and the wall surface of the substrate opening 16 can be substantially perpendicular to the first substrate surface 15a. The substrate-facing layer 26 that is composed of a material that enables the erosion of the etching medium to be reduced functions as a stopper layer that stops etching. The mask substrate 15 may be etched by performing a wet etching process in which an etching solution is used. The etching solution is an example of the etching medium. For example, a 35 weight% of potassium hydroxide aqueous solution at 80°C may be used as the etching solution, and the mask substrate 15 may be immersed in the etching solution for a predetermined time. The portion of the mask substrate 15 that is exposed from the resist layer 50 may be etched by anisotropic etching so as to depend on the plane orientation (or a crystal orientation).

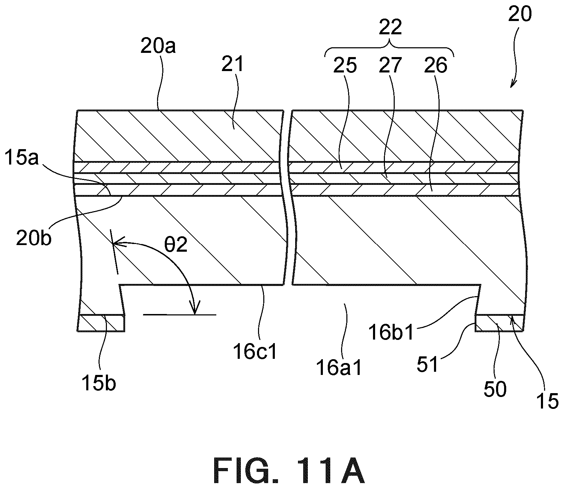

The substrate etching step will be described in more detail. In an example described herein with reference to Fig. 11A to Fig. 11E, the substrate opening 16 illustrated in Fig. 3 is formed by so-called deep RIE (deep reactive-ion etching). Fig. 11A to Fig. 11E schematically illustrate an enlarged sectional view of a portion of the substrate opening 16 illustrated in Fig. 3.

As illustrated in Fig. 11A, a portion of the resist layer 50 that is exposed through the resist opening 51 is etched by anisotropic etching. Consequently, a first recessed portion 16a1 is formed on the second substrate surface 15b. The first recessed portion 16a1 includes a wall surface 16b1 that extends from the resist opening 51 toward the first substrate surface 15a and an end surface 16c1. The wall surface 16b1 is formed so as to spread toward the first substrate surface 15a. That is, as illustrated in Fig. 11A, an angle θ2 that is formed between the wall surface 16b1 and the first substrate surface 15a is slightly larger than 90°.

As for anisotropic dry etching, the plasma of gas for etching is generated in a vapor deposition chamber (not illustrated) in which the mask substrate 15 is disposed, and the second substrate surface 15b of the mask substrate 15 is irradiated with the plasma. The etching gas for generating the plasma may be the etching gas described above. Etching not only progresses in the thickness direction of the mask substrate 15 but also slightly progresses in the direction of the second substrate surface 15b. However, reducing etching time enables etching in the direction of the second substrate surface 15b to be inhibited from progressing.

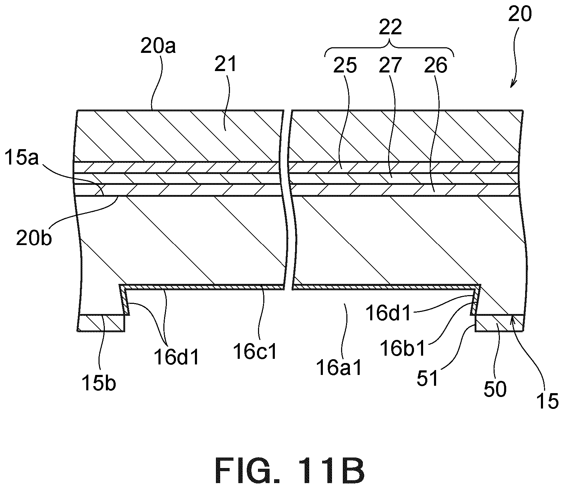

After the first recessed portion 16a1 is formed, as illustrated in Fig. 11B, a first protection layer 16d1 is formed on the wall surface 16b1 and the end surface 16c1 of the first recessed portion 16a1. The first protection layer 16d1 is formed on the wall surface 16b1 and the end surface 16c1 by supplying material gas such as C₄F₈ gas to the first recessed portion 16a1.

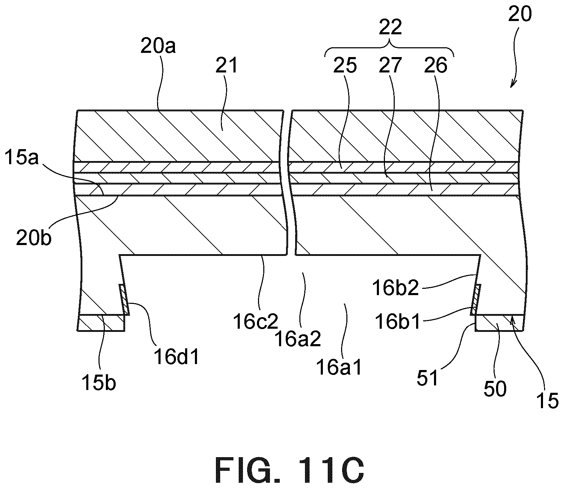

After the first protection layer 16d1 is formed, as illustrated in Fig. 11C, the first recessed portion 16a1 is etched by anisotropic dry etching. Consequently, a portion of the first protection layer 16d1 that is located at the end surface 16c1 is removed, and a second recessed portion 16a2 is formed. More specifically, the end surface 16c1 of the first recessed portion 16a1 is etched by anisotropic dry etching in the same manner as in that at a step of forming the first recessed portion 16a1, and the second recessed portion 16a2 that is connected to the first recessed portion 16a1 is formed. At this time, a wall surface 16b2 of the second recessed portion 16a2 is formed so as to spread toward the first substrate surface 15a as in the wall surface 16b1 of the first recessed portion 16a1 described above.

The first protection layer 16d1 that is formed on the wall surface 16b1 of the first recessed portion 16a1 may be removed by anisotropic dry etching for forming the second recessed portion 16a2 or may not be removed. Even in the case where the first protection layer 16d1 is removed, the wall surface 16b1 of the first recessed portion 16a1 can be inhibited from being eroded due to etching until the first protection layer 16d1 is removed. In the case where the first protection layer 16d1 is not removed but remains, the wall surface 16b of the first recessed portion 16a1 can be further inhibited from being eroded due to etching. Even in the case where the first protection layer 16d1 is not removed, the first protection layer 16d1 may be partly removed by etching.

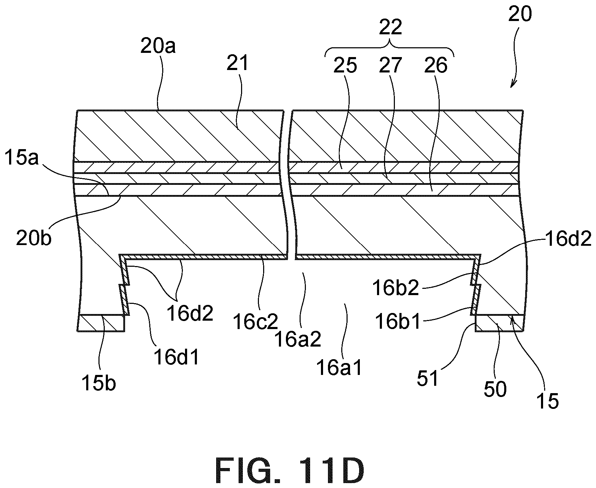

As illustrated in Fig. 11D, a second protection layer 16d2 is formed on the wall surface 16b2 and an end surface 16c2 of the second recessed portion 16a2. The second protection layer 16d2 can be formed in the same manner as in the first protection layer 16d1.

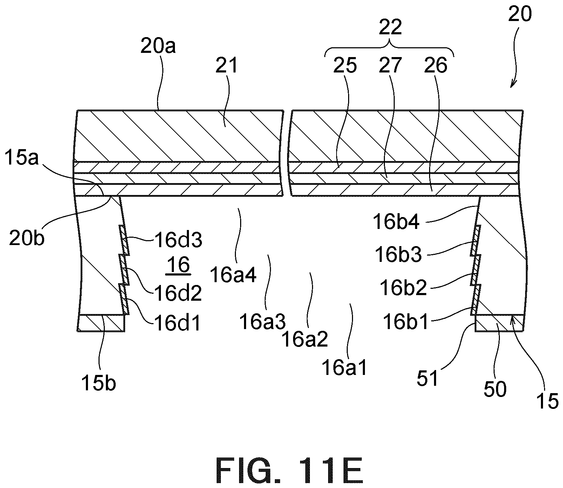

As illustrated in Fig. 11E, the formation of the recessed portions and the formation of the protection layers are repeated multiple times until the mask substrate 15 is etched up to the substrate-facing layer 26. In an example illustrated in Fig. 11E, a third recessed portion 16a3 that includes a wall surface 16b3 and a fourth recessed portion 16a4 that includes a wall surface 16b4 are formed after the second recessed portion 16a2 to simplify the description. The fourth recessed portion 16a4 extends to the substrate-facing layer 26 that functions as the stopper layer for etching. The substrate-facing layer 26 according to the present embodiment is composed of a material that enables the erosion of the etching gas to be reduced. For this reason, the substrate-facing layer 26 is capable of functioning the stopper layer for etching and is not etched but remains. A third protection layer 16d3 is formed on the wall surface 16b3, but no protection layer is formed on the wall surface 16b4.

Subsequently, the protection layers 16d1 to 16d3 that remain on the wall surfaces 16b1 to 16b3 of the recessed portions 16a1 to 16a3 are removed by using a process liquid. An example of the process liquid may be hydrofluoroether (HFE). For example, the protection layers 16d1 to 16d3 may be immersed in a process liquid at a temperature of a normal temperature (for example, about 25°C) to 70°C for 30 minutes. As for the process liquid, an undiluted solution that is not diluted may be used.

In this way, the substrate opening 16 illustrated in Fig. 10 is formed on the mask substrate 15. The wall surface of the substrate opening 16 is formed by the wall surfaces 16b1 to 16b4 of the recessed portions 16a1 to 16a4. The time of dry etching for forming the recessed portions 16a1 to 16a4 may be reduced, and the number of times the formation of the recessed portions 16a1 to 16a4 and the formation of the protection films are repeated may be increased. In this case, the wall surface of the substrate opening 16 that is formed by the wall surfaces 16b1 to 16b4 of the recessed portions 16a1 to 16a4 can be substantially perpendicular to the second substrate surface 15b. The wall surfaces 16b1 to 16b4 of the recessed portions 16a1 to 16a4 adjacent to each other can have fine steps, but reducing the thicknesses of the protection layer 16d1 to 16d3 described above enables the steps to be small. In this case, the wall surface of the substrate opening 16 can be formed so as to form a straight line substantially perpendicular to the first substrate surface 15a in a section illustrated in Fig. 10.

At the substrate etching step, a step of forming the first alignment marks 45 illustrated in Fig. 2 and Fig. 3 may be performed. That is, at the substrate etching step, the first alignment marks 45 may be formed.

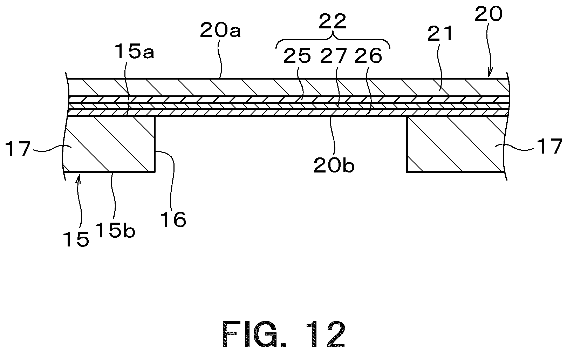

At the resist layer removal step, as illustrated in Fig. 12, the resist layer 50 is removed from the mask substrate 15. For example, the resist layer 50 may be removed from the mask substrate 15 by using an alkali stripping solution.

In this way, as illustrated in Fig. 12, the mask substrate 15 that includes the substrate opening 16 is obtained.

The substrate opening formation step is not limited to the step described above. For example, at the substrate opening formation step, a resistance layer (not illustrated) such as a silicon oxide layer, a silicon nitride layer, or a silicon carbide layer may be formed on the second substrate surface 15b of the mask substrate 15. In this case, a resistance layer opening may be formed in the resistance layer, and subsequently, the mask substrate 15 may be etched through the resistance layer opening. The resistance layer opening may be formed in a manner in which a resist layer that includes a resist opening is formed on the resistance layer by performing the photolithography process, and the resistance layer is etched through the resist opening. The mask substrate 15 may be etched through the resistance layer opening, and the substrate opening 16 may be formed. After the substrate opening 16 is formed, the resistance layer may be removed.

At the through-hole formation step after the substrate opening formation step, the multiple through-holes 40 may be formed in the mask layer 20 so as to be exposed to the substrate opening 16. The through-holes 40 may be formed in a manner in which the mask layer 20 is irradiated with laser light L. The through-holes 40 may be formed so as to extend through the first metal layer 21 and the opening region portion 22b.

For example, as illustrated in Fig. 13A, the through-holes 40 may be formed one by one by emitting the laser light L.

More specifically, as illustrated in Fig. 13A, the mask substrate 15 and the mask layer 20 that are obtained as described above are first placed on a movable stage 60.

Subsequently, the formation of the through-holes 40 and the movement of the movable stage 60 are repeated, and consequently, a large number of the through-holes 40 may be formed. In this case, an irradiation head H may not be moved.

For example, the irradiation head H is caused to face a position (the center of each through-hole 40) at which each through-hole 40 is to be formed. Subsequently, the second surface 20b of the mask layer 20 is irradiated with the laser light L via the substrate opening 16 in a direction from the mask substrate 15 toward the first metal layer 21. Consequently, the material of a portion of the mask layer 20 that is irradiated with the laser light L is sublimated and removed, and as illustrated in Fig. 13A, the through-holes 40 are formed. In Fig. 13A, the materials of each of the layers 25 to 27 of the second metal layer 22 and the first metal layer 21 that are included in the mask layer 20 are removed. In this case, the wall surfaces 41 of the through-holes 40 tend to be formed so as to be perpendicular to the second surface 20b. As illustrated in Fig. 13A, however, the wall surfaces 41 of the through-holes 40 can be inclined depending on the strength and pulse width of the laser light L and the thickness of the mask layer 20.

The laser light L with which the mask layer 20 is irradiated may be femtosecond laser light. The femtosecond laser light is a pulse laser light that has a narrow pulse width, and a high-intensity laser light can be outputted with the narrow width. The femtosecond laser light enables the mask layer 20 to be irradiated with the laser light L with high power in a short time. For this reason, material molecules can be vaporized in a short time, and the through-holes 40 can be formed. In this case, a burr can be inhibited from being formed on the first surface 20a of the mask layer 20. The burr is a projection that is formed by processing the metal material. For example, the output of the femtosecond laser light L may be 5 W or more and 100 W or less. For example, the pulse width of the laser light L may be 1 fs or more and 10 ns. For example, the wavelength of the laser light L may be 250 nm or more and 1100 nm or less or may be 513 nm, which corresponds to, for example, a green laser. For example, the oscillation frequency of the laser light L may be 1 Hz or more and 10 MHz or less. For example, in the case where the mask layer 20 the thickness H2 of which is 4 µm is directly irradiated with the laser light L without the use of a photo mask 65 described later, and one of the through-holes 40 is formed, the pulse width of the laser light L may be 260 fs. In this case, the wavelength of the laser light L may be 513 nm. The number of times the laser light L is emitted to form the one of the through-holes 40 may be one or multiple times to form the one of the through-holes 40.

After the one of the through-holes 40 is formed, the emission of the laser light L is stopped. The movable stage 60 is moved, and the irradiation head H is subsequently caused to face a next position (the center of the through-hole 40) at which the through-hole 40 is to be formed. The laser light L is emitted in the same manner as above. These are repeated, and consequently, a large number of the through-holes 40 are formed in the vapor deposition mask 10 according to the present embodiment.

In the case where the laser light L is emitted, and the through-holes 40 are formed as described above, the movable stage 60 may not be moved, but the irradiation head H may be moved.

A method of forming the through-holes 40 is not limited thereto. For example, as illustrated in Fig. 13B, the multiple through-holes 40 may be formed in parallel by emitting the laser light L. For example, as illustrated in Fig. 13B and Fig. 13C, the laser light L may be emitted from a laser light generation device 61.

The laser light generation device 61 illustrated in Fig. 13C includes a laser light source 62, a first lens 63, a second lens 64 (also referred to as a collimator lens), the photo mask 65, a third lens 66 (also referred to as a condensing lens), and a mirror 67. The laser light L that is emitted from the laser light source 62 is enlarged by the first lens 63 and becomes parallel light through the second lens 64. The laser light L that becomes the parallel light passes through mask holes 65a of the photo mask 65 and is focused by the third lens 66. The laser light L focused is reflected by the mirror 67, changes the direction, and is emitted to the second surface 20b of the mask layer 20. The laser light L that passes through the photo mask 65 and the third lens 66 is patterned light so as to correspond to the through-holes 40 as illustrated in Fig. 13B although this is simplified in Fig. 13C.

The photo mask 65 includes the multiple mask holes 65a at positions that correspond to those of the multiple through-holes 40. In an example illustrated in Fig. 13B, the laser light L that passes through one of the mask holes 65a forms a corresponding one of the through-holes 40. In this case, one of the mask holes 65a may be assigned to one of the through-holes 40. The photo mask 65 may include a substrate that has the optical transparency such as glass and a layer that is obtained by forming a patterned metal material such as chromium on the substrate and that includes the mask holes 65a described above. In Fig. 13C, the substrate described above is omitted to simplify the figure.

Subsequently, the movable stage 60 may be moved, and the position to which the laser light L is emitted may be adjusted. In the case where the laser light generation device 61 is movable, the laser light generation device 61 may be moved.

Subsequently, the second surface 20b of the mask layer 20 is irradiated with the laser light L from the laser light generation device 61. Consequently, the materials of multiple portions of the mask layer 20 that is irradiated with the laser light L are sublimated and removed, and as illustrated in Fig. 13B, the multiple through-holes 40 are formed in parallel. The laser light L that passes through a corresponding one of the mask holes 65a assigned forms each through-hole 40. The number of times the laser light L is emitted to form the through-holes 40 may be one or multiple times to form the through-holes 40. The photo mask 65 is not limited by the case where the multiple through-holes 40 are formed in parallel but may be used in the case where the laser light L passes through one of the mask holes 65a, and the through-holes 40 are formed one by one. In this case, the through-holes 40 are formed one by one by emitting the laser light L.

The multiple mask holes 65a may be assigned to one of the through-holes 40. In this case, the mask hole(s) 65a that has(have) a relatively large planar shape may be located at the center of the through-hole 40. In addition, the mask holes 65a that have a relatively small planar shape may be located in the vicinity of the mask hole(s) 65a that has(have) a relatively large planar shape. The sizes of the planar shapes of the mask holes 65a may be gradually reduced in an outward direction from the center of the through-hole 40. In some cases, the pattern of the mask holes 65a is referred to as a halftone pattern or a gradation pattern. That is, the mask hole(s) 65a that has(have) a relatively large planar shape may be assigned to the center of the through-hole 40, and the mask holes 65a that have a relatively small planar shape may be assigned to the vicinity of the mask hole(s) 65a that has(have) a relatively large planar shape. In this case, the laser light L that passes through the mask hole(s) 65a that is(are) large at the center is emitted to the mask layer 20 with relatively high intensity. For this reason, the laser light L that passes through the mask hole(s) 65a that has(have) a relatively large planar shape enables the hole that extends through the mask layer 20 to be formed. The laser light L that passes through the mask holes 65a that are relatively small in the vicinity is emitted to the mask layer 20 with relatively low intensity. For this reason, no holes extend through the mask layer 20 at the positions to which the laser light L that passes through the mask holes 65a that have a relatively small planar shape is emitted, and the material in a recessed shape is removed. The sizes of the planar shapes of the mask holes 65a that are assigned to the one of the through-holes 40 is gradually reduced in the outward direction from the center, and consequently, the multiple through-holes 40 the wall surfaces 41 of which are inclined can be formed in parallel as illustrated in Fig. 3.

In the example illustrated in Fig. 13B, the multiple through-holes 40 are formed in parallel by emitting the laser light L by using the photo mask 65. The present disclosure, however, is not limited thereto, and the through-holes 40 may be formed one by one by emitting the laser light L via the multiple mask holes 65a of the photo mask 65. That is, in the case where the multiple mask holes 65a are assigned to one of the through-holes 40, the laser light L may be emitted to only the mask holes 65a. In this case, the through-holes 40 that include the wall surfaces 41 that are inclined can be formed one by one.

At the through-hole formation step, a step of forming the second alignment marks 46 illustrated in Fig. 3 and Fig. 4 may be performed. That is, the vapor deposition mask 10 is reversed in the up-down direction such that the first surface 20a faces the irradiation head H. The first surface 20a of the first metal layer 21 may be irradiated with the laser light, and the second alignment marks 46 that have a recessed shape may be formed.

In this way, the vapor deposition mask 10 according to the present embodiment illustrated in Fig. 14 is obtained.

The first metal layer 21 according to the present embodiment is formed by performing the plating process as described above. In this case, a stress that acts on the first metal layer 21 in a direction in which the first metal layer 21 shrinks in a plan view remains. Consequently, even in the case where the temperature of the first metal layer 21 increases, and the first metal layer 21 thermally expands, for example, during vapor deposition, the precision of the positions of the through-holes 40 can be maintained with the stress described above remaining. This state can be said to be a state in which a typical vapor deposition mask that is manufactured by performing, for example, the etching process or the plating process is stretched on a frame.

A method of manufacturing an organic EL display device by using the vapor deposition mask 10 according to the present embodiment will now be described with reference to Fig. 1, Fig. 15A, and Fig. 15B.

The components and display region of the organic device 100 will be described in detail. Fig. 15A illustrates a plan view of an example of the organic device 100 and illustrates the organic layers that are deposited at the vapor deposition step. Fig. 15B illustrates a sectional view of the organic device 100 in Fig. 15A taken along a line B-B. Fig. 15A illustrates a plan view of the organic layers that are deposited at the vapor deposition step where second electrodes 140 that are formed after the vapor deposition step and that will be described later are omitted. An example of the organic device 100 is an organic EL display device. The organic device 100 includes a light-emitting layer that is formed on the vapor deposition substrate 110 described later by using the vapor deposition mask 10 described above according to the present embodiment. The single organic device 100 may correspond to the single display region.

As illustrated in Fig. 15A and Fig. 15B, the organic device 100 includes the vapor deposition substrate 110 and elements 115 that are located on the vapor deposition substrate 110. The elements 115 may include first electrodes 120, organic layers 130 that are located on the first electrodes 120, and the second electrodes 140 that are located on the organic layers 130.

The organic device 100 may include an insulating layer 160 that is located between two first electrodes 120 adjacent to each other in a plan view. The insulating layer 160 may contain, for example, polyimide. The insulating layer 160 may overlap end portions of the first electrodes 120.

The organic device 100 may be an active-matrix device. For example, the organic device 100 may include switches that are electrically connected to the respective multiple elements 115 although this is not illustrated. Examples of the switches may include transistors. The switches are capable of controlling on-off of a voltage or current to the respective elements 115.

The vapor deposition substrate 110 may include a first surface 110a on which the first electrodes 120 are formed and a second surface 110b that is located opposite the first surface 110a. The vapor deposition substrate 110 may be an insulating plate member. The vapor deposition substrate 110 may have the optical transparency such that light passes therethrough.

In the case where the vapor deposition substrate 110 has predetermined optical transparency, the optical transparency of the vapor deposition substrate 110 may be such that light from the organic layers 130 can pass therethrough and can be displayed. For example, the transmittance of the vapor deposition substrate 110 in a visible-light region may be 80% or more or may be 90% or more. The transmittance of the vapor deposition substrate 110 may be measured by using Plastics-Determination of the total luminous transmittance of transparent materials based on JIS K7361-1.

The vapor deposition substrate 110 may be flexible or may not be flexible. The vapor deposition substrate 110 can be appropriately selected depending on the use of the organic device 100.

For example, the vapor deposition substrate 110 contains silicon, and examples may be a silicon substrate. Alternatively, the vapor deposition substrate 110 may contain glass, and the examples may be a glass substrate. The examples of the material of the vapor deposition substrate 110 may also include rigid materials that are not flexible such as quartz glass, Pyrex (registered trademark) glass, and a synthetic quartz plate. Alternatively, the material of the vapor deposition substrate 110 may include flexible materials such as a resin film (such as a polyimide film or a liquid-crystal polymer), an optical resin plate, and thin glass. The vapor deposition substrate 110 may be a stacked body that includes a barrier layer on a surface of a resin film or barrier layers on both surfaces of the resin film.

In the case where the vapor deposition substrate 110 is composed of a material other than a silicon substrate, the thickness of the vapor deposition substrate 110 may be appropriately selected depending on, for example, the material used for the vapor deposition substrate 110 or the use of the organic device 100. In this case, for example, the thickness of the vapor deposition substrate 110 may be 0.005 mm or more. The thickness of the vapor deposition substrate 110 may be 5 mm or less.

The elements 115 are configured to fulfill a function in a manner in which a voltage is applied between the first electrodes 120 and the second electrodes 140 or a current flows between the first electrodes 120 and the second electrodes 140. For example, in the case where the elements 115 are pixels of an organic EL display device, the elements 115 are capable of emitting light for forming a picture.

The first electrodes 120 contain a conductive material. For example, the first electrodes 120 contain metal, a conductive metal oxide or another conductive inorganic material. The first electrodes 120 may contain a conductive metal oxide that has the optical transparency such as an indium tin oxide.

An example of the material of the first electrodes 120 may be metal such as Au, Cr, Mo, Ag, or Mg. Alternatively, the material of the first electrodes 120 may be an indium tin oxide abbreviated as ITO, an indium zinc oxide abbreviated as IZO, or an inorganic oxide such as a zinc oxide or an indium oxide. An example of the material of the first electrodes 120 may be a conductive polymer such as polythiophene doped with metal. These conductive materials may be used alone, or two or more kinds of the materials may be combined and used. In the case where two or more kinds of the materials are used, layers composed of the respective materials may be stacked on the conductive material. The conductive material may be an alloy that contains two or more kinds of the materials. For example, the conductive material may be a magnesium alloy such as MgAg.

The organic layers 130 contain an organic material. When the organic layers 130 are energized, the organic layers 130 can perform a function. The phrase "to be energized" means that a voltage is applied to the organic layers 130, or a current flows through the organic layers 130. Examples of the organic layers 130 may include light-emitting layers that emit light when being energized and layers the refractive index or the optical transmittance of which changes when being energized. The organic layers 130 may contain an organic semiconductor material.

As illustrated in Fig. 15B, the organic layers 130 may include the first organic layers 130A and the second organic layers 130B. As illustrated in Fig. 15A, the organic layers 130 may further include the third organic layers 130C. For example, the first organic layers 130A, the second organic layers 130B, and the third organic layers 130C are red light-emitting layers, blue light-emitting layers, and green light-emitting layers. In the following description, the words and reference characters of the "organic layers 130" are used in the case of description of a structure that is common to the first organic layers 130A, the second organic layers 130B, and the third organic layers 130C among structures in the organic layers.

Stacked structures that include the first electrodes 120, the first organic layers 130A, and the second electrodes 140 are also referred to as first elements 115A. Stacked structures that include the first electrodes 120, the second organic layers 130B, and the second electrodes 140 are also referred to as second elements 115B. Stacked structures that include the first electrodes 120, the third organic layers 130C, and the second electrodes 140 are also referred to as third elements 115C. In the case where the organic device 100 is an organic EL display device, the first elements 115A, the second elements 115B, and the third elements 115C are sub-pixels.

In the following description, the words and reference characters of the "elements 115" are used in the case of description of a structure that is common to the first elements 115A, the second elements 115B, and the third elements 115C among structures in the elements. In a plan view such as Fig. 15A, the contours of the elements 115 may be the same as the contours of the organic layers 130 that overlap the first electrodes 120 and the second electrodes 140 in a plan view. In the case where the organic device 100 includes the insulating layers 160, the contours of the elements 115 may be the same as the contours of the organic layers 130 that overlap the first electrodes 120 and the second electrodes 140 and that do not overlap the insulating layers 160 in a plan view.

The arrays of the first elements 115A, the second elements 115B, and the third elements 115C will be described. As illustrated in Fig. 15A, the first elements 115A, the second elements 115B, and the third elements 115C may be arranged in an element first direction F1. The first elements 115A, the second elements 115B, and the third elements 115C may be arranged in an element second direction F2.

When a voltage is applied between the first electrodes 120 and the second electrodes 140, the organic layers 130 that are located therebetween are driven. In the case where the organic layers 130 are light-emitting layers, light is emitted from the organic layers 130, and the light exits from the second electrodes 140 or the first electrodes 120 to the outside.

In the case where the organic layers 130 include light-emitting layers that emit light when being energized, the organic layers 130 may further include a hole injection layer, a hole transport layer, an electron transport layer, an electron injection layer, and another layer.

For example, in the case where the first electrodes 120 are anodes, the organic layers 130 may include hole injection transport layers between light-emitting layers and the first electrodes 120. The hole injection transport layers may be hole injection layers that have a hole injection function, may be hole transport layers that have a hole transport function, or may have both of the hole injection function and the hole transport function. The hole injection transport layers may have a structure in which a hole injection layer and a hole transport layer are stacked.

In the case where the second electrodes 140 are cathodes, the organic layers 130 may include electron injection transport layers between light-emitting layers and the second electrodes 140. The electron injection transport layers may be electron injection layers that have an electron injection function, may be electron transport layers that have an electron transport function, or may have both of the electron injection function and the electron transport function. The electron injection transport layers may have a structure in which an electron injection layer and an electron transport layer are stacked.

The light-emitting layers contain a light-emitting material. The light-emitting layers may contain an additive that improves leveling properties.

A known material may be used as the light-emitting material, and examples of the light-emitting material may include a pigment material, a metal complex material, or a polymeric material.

The film thicknesses of the light-emitting layers are not particularly limited provided that the film thicknesses enable an electron and a hole to be recombined and enables light to be emitted. For example, the film thicknesses of the light-emitting layers may be 1 nm or more. The film thicknesses of the light-emitting layers may be 500 nm or less.

The second electrodes 140 contain a conductive material such as metal. The second electrodes 140 are formed on the organic layers 130 by performing the vapor deposition method in which a mask described later is used. Examples of the material of the second electrodes 140 may include platinum, gold, silver, copper, iron, tin, chromium, aluminum, indium, lithium, sodium, potassium, calcium, magnesium, chromium, or carbon. These conductive materials may be used alone, or two or more kinds of the materials may be combined and used. In the case where two or more kinds of the materials are used, layers composed of the respective materials may be stacked on the conductive material. An alloy that contains two or more kinds of the materials may be used as the conductive material. For example, the conductive material may be a magnesium alloy such as MgAg, an aluminum alloy such as AlLi, AlCa, orAlMg, an alkali metal alloy, or an alkali earth metal alloy.

As illustrated in Fig. 15B, the organic device 100 may include a sealing layer (not illustrated) that covers elements on the vapor deposition substrate 110 such as the organic layers 130A, 130B, and 130C. The sealing layer is capable of inhibiting, for example, water vapor outside the organic device 100 from entering the organic device 100. This enables the organic layers 130A, 130B, and 130C, for example, to be inhibited from being degraded due to moisture. The sealing layer may include a layer composed of, for example, an organic material. The organic material may have a refractive index equal or close to those of the organic layers 130A, 130B, and 130C in order to inhibit light from being refracted by the sealing layer. For example, the organic material may be sealed by using an inorganic material such as silicon nitride (SiN). In this case, the sealing layer may have a stacked structure in which a layer composed of the organic material and a layer composed of the inorganic material are stacked. A flattening layer (not illustrated) may be interposed between the second electrodes 140 and the sealing layer. The flattening layer may be used to improve the adhesion of the sealing layer by filling unevenness of the elements on the vapor deposition substrate 110.

A method of manufacturing the organic device 100 may include a step of forming the organic layers 130A, 130B, and 130C by attaching the vapor deposition material 82 to the vapor deposition substrate 110 by using the vapor deposition mask 10. More specifically, a method of manufacturing an organic EL display device according to the present embodiment may include a vapor deposition mask preparation step, a position adjustment step, a close contact step, a vapor deposition step, and a cutting step.

At the vapor deposition mask preparation step, the vapor deposition mask 10 described above may be prepared.

At the position adjustment step after the vapor deposition mask preparation step, the position of the vapor deposition mask 10 is adjusted with respect to the vapor deposition substrate 110. At the position adjustment step, the positions of the through-holes 40 of the vapor deposition mask 10 with respect to the vapor deposition substrate 110 are checked. At this time, the positions of the through-holes 40 of the vapor deposition mask 10 with respect to the vapor deposition substrate 110 may be adjusted. For example, the positions of the first alignment marks 45 that are provided on the substrate frame body 17 of the mask substrate 15 and the position of a corresponding substrate alignment mark 111 (see Fig. 3) of the vapor deposition substrate 110 are adjusted. In addition, the positions of the second alignment marks 46 that are provided on the mask sash bars 28a and 28b of the mask layer 20 and the position of a corresponding alignment mark (not illustrated) of the vapor deposition substrate 110 are adjusted. For example, the position of the vapor deposition substrate 110 and the positions of the through-holes 40 may be first roughly adjusted by using the first alignment marks 45, and subsequently, the position of the vapor deposition substrate 110 and the positions of the through-holes 40 may be finely adjusted by using the second alignment marks 46. This enables the positions of the through-holes 40 of the vapor deposition mask 10 with respect to the vapor deposition substrate 110 to be adjusted with precision.

At the close contact step after the position adjustment step, the first surface 20a of the mask layer 20 of the vapor deposition mask 10 may be brought into close contact with the vapor deposition substrate 110. More specifically, the first surface 20a of the mask layer 20 of the vapor deposition mask 10 is brought into close contact with the first surface 110a (see Fig. 3) of the vapor deposition substrate 110 in the vapor deposition apparatus 80 with the positions adjusted. At this time, the vapor deposition substrate 110 is interposed between the vapor deposition mask 10 and the magnet 85, and the vapor deposition mask 10 is attracted toward the vapor deposition substrate 110 due to the magnetic force of the magnet 85. Consequently, the vapor deposition substrate 110 comes into close contact with the first surface 20a of the vapor deposition mask 10.

At the vapor deposition step after the close contact step, the vapor deposition material 82 may be deposited on the first electrodes 120 that are formed on the vapor deposition substrate 110 via the through-holes 40 of the vapor deposition mask 10, and the organic layers 130A, 130B, and 130C may be formed (see Fig. 15B). The organic layers 130A, 130B, and 130C are formed on respective hole transport layers. More specifically, the pressure in the vapor deposition apparatus 80 is reduced to that in the vacuum atmosphere. Subsequently, the vapor deposition material 82 is vaporized and is caused to come to the hole transport layers. The vapor deposition material 82 that comes passes through the through-holes 40 of the vapor deposition mask 10 and are attached to desired hole transport layers. Consequently, the organic layers 130A, 130B, and 130C are formed on the first electrodes 120 and the insulating layer 160 in a pattern that corresponds to the pattern of the through-holes 40.

The organic layers 130A, 130B, and 130C are formed across the first electrodes 120 and the insulating layers 160 adjacent to the first electrodes 120. The organic layers 130A, 130B, and 130C adjacent to each other on the insulating layers 160 may overlap although this is not illustrated.

According to the present embodiment, the through-holes 40 are formed in the predetermined pattern in each of the effective regions 23 as described above. In the case where multiple colors are used for display, the vapor deposition mask 10 that includes the through-holes 40 that are formed in the pattern that corresponds to the organic layers 130A, 130B, and 130C in the respective colors is prepared. The vapor deposition material 82 in each color is attached to the corresponding hole transport layer by using the corresponding vapor deposition mask 10. Consequently, an organic light-emitting material for red color, an organic light-emitting material for green color, and an organic light-emitting material for blue color, for example, can be deposited on the single vapor deposition substrate 110, and the organic layers 130A, 130B, and 130C can be formed.

After the organic layers 130A, 130B, and 130C are formed, the electron transport layers and the electron injection layers are formed on the organic layers 130A, 130B, and 130C. Subsequently, the second electrodes 140 are formed. The second electrodes 140 are formed so as to cover the respective organic layers 130A, 130B, and 130C and are formed across the first electrodes 120 and the insulating layers 160 adjacent to the first electrodes 120 on the organic layers 130A, 130B, and 130C. For example, the second electrodes 140 may be continuously formed across two of the organic layers 130A, 130B, and 130C adjacent to each other in a plan view.

The flattening layer and the sealing layer described above are formed on the second electrodes 140 formed. In this way, elements such as the organic layers 130A, 130B, and 130C that are provided on the vapor deposition substrate 110 are sealed by the sealing layer.

At the cutting step after the vapor deposition step, the vapor deposition substrate 110 is cut for every organic device 100. In this case, for example, the vapor deposition substrate 110 is cut between the organic devices 100 adjacent to each other by using the dicing saw. The vapor deposition substrate 110 may be cut by using the single sewing depending on the distance between the organic devices 100 adjacent to each other and the width of the dicing saw, or the vapor deposition substrate 110 may be cut by using the double sawing.

In this way, the organic device 100 that includes the organic layers 130A, 130B, and 130C in the respective colors that are formed on the vapor deposition substrate 110 is obtained.

According to the present embodiment, the vapor deposition mask 10 thus includes the mask layer 20 that includes the through-holes 40 and the mask substrate 15 that is located on the second surface 20b of the mask layer 20. The mask substrate 15 is thus located on the mask layer 20, consequently, the strength of the vapor deposition mask 10 can be improved, and the close contact with the vapor deposition substrate 110 can be achieved in this state. This enables the precision of the shapes and the precision of the positions of the through-holes 40 of the mask layer 20 to be maintained at the precision of the shapes and the precision of the positions at the time the through-holes 40 are formed, and the definition of the through-holes 40 can be improved. In addition, the high definition of the through-holes 40 can be achieved. The vapor deposition material 82 can be attached to the vapor deposition substrate 110 with the precision of the shapes and the precision of the positions of the through-holes 40 improved. For this reason, the definition of the organic layers 130A, 130B, and 130C of the organic device 100 can be improved. In this case, the high definition of the pixels that include the elements that include the organic layers 130A, 130B, and 130C can be achieved.

According to the present embodiment, the mask substrate 15 contains silicon. In the case where the vapor deposition substrate 110 is a silicon substrate, the mask substrate 15 can be composed of the same kind of material or the same material as the vapor deposition substrate 110. This enables a difference between the thermal expansion coefficient of the mask substrate 15 and the thermal expansion coefficient of the vapor deposition substrate 110 to be reduced. For this reason, the precision reduction can be inhibited from being made. For example, in the case where the pixel density of the organic device 100 is high, it is required that the precision of the shapes and the precision of the positions of the through-holes 40 are increased. The mask substrate 15 according to the present embodiment contains silicon, and accordingly, the difference in the thermal expansion coefficient from that of the vapor deposition substrate 110 can be reduced as described above. This enables the positions of the through-holes 40 to be inhibited from being shifted with respect to the vapor deposition substrate 110 even in the case where the vapor deposition mask 10 the position of which is adjusted with precision with respect to the vapor deposition substrate 110 thermally expands. For this reason, the precision of the shapes and the precision of the positions of the organic layers 130A, 130B, and 130C that are formed on the vapor deposition substrate 110 can be improved. As a result, the organic device 100 that includes the organic layers 130A, 130B, and 130C that have high definition can be easily manufactured.

According to the present embodiment, the second surface 20b of the mask layer 20 is attached to the mask substrate 15. This enables the strength of the vapor deposition mask 10 to be further improved. In the case where the mask layer 20 is manufactured alone as a body that is separated from the mask substrate 15, the mask layer 20 is stretched to a frame of, for example, the mask substrate 15 with a tension applied thereto and is subsequently fixed, for example, by being welded. However, since the mask layer 20 is attached to the mask substrate 15, the vapor deposition mask 10 according to the present embodiment can eliminate the need for such stretching the mask layer 20. This enables the precision of the shapes and the precision of the positions of the through-holes 40 of the mask layer 20 that is attached to the mask substrate 15 to be maintained at the precision of the shapes and the precision of the positions at the time the through-holes 40 are formed. For this reason, the definition of the through-holes 40 can be further improved.

According to the present embodiment, the mask layer 20 includes the first metal layer 21 that forms the first surface 20a and the second metal layer 22 that is located between the first metal layer 21 and the mask substrate 15. This enables the second metal layer 22 to have an inherent purpose. For example, the second metal layer 22 can be composed of a material that enables adhesion between the first metal layer 21 and the mask substrate 15 to be ensured. In this case, the vapor deposition mask 10 can be attached to the mask substrate 15, and the strength of the vapor deposition mask 10 can be further improved. Alternatively, the second metal layer 22 can be composed of a material that has resistance against the etching medium that is used at the substrate etching step. In this case, the first metal layer 21 can be inhibited from being etched by the etching medium at the substrate etching step.

According to the present embodiment, the thickness of the second metal layer 22 that forms the second surface 20b of the mask layer 20 is less than the thickness of the first metal layer 21 that forms the first surface 20a. This enables the second metal layer 22 to have the inherent purpose. That is, in some cases where the second metal layer 22 has the inherent purpose, it is thought that it is difficult to reduce the thermal expansion coefficient. For example, examples of the purpose of the second metal layer 22 include a purpose to ensure the adhesion to the first metal layer 21, a purpose to ensure the adhesion to the mask substrate 15, a purpose to reduce the erosion of the etching medium that is used at the substrate etching step, and a purpose to protect the substrate-facing layer 26 from the plating solution that contains the material of the first metal layer 21. It is thought that the material for achieving the purposes has a large thermal expansion coefficient. Even in this case, however, reducing the thickness of the second metal layer 22 enables the influence of the thermal expansion of the second metal layer 22 to be reduced. For this reason, the precision reduction can be inhibited from being made.

According to the present embodiment, the first metal layer 21 contains a metal material. This enables the mask layer 20 composed of a metal material to include the through-holes 40. This enables the layer in which the through-holes 40 are located to be inhibited from absorbing a cleaning solution when the vapor deposition mask 10 is cleaned after the vapor deposition step at which the organic layers 130A, 130B, and 130C are formed on the vapor deposition substrate 110. For this reason, the through-holes 40 can be inhibited from being shifted, and the through-holes 40 can be inhibited from deforming. As a result, the definition of the through-holes 40 of the vapor deposition mask 10 after cleaning can be improved. In the case where the first metal layer 21 contains a magnetic metal material, the use of the magnet 85 enables the vapor deposition mask 10 to be brought into close contact with the vapor deposition substrate 110. In this case, the vapor deposition mask 10 can be attracted toward the magnet 85 due to the magnetic force, and adhesion between the vapor deposition mask 10 and the vapor deposition substrate 110 can be improved. For this reason, the definition of the organic layers 130A, 130B, and 130C of the organic device 100 can be improved.

According to the present embodiment, the second metal layer 22 includes the body region portion 22a that is located between the first metal layer 21 and the substrate frame body 17 and the opening region portion 22b that is located in the substrate opening 16 in a plan view. This enables the second metal layer 22 to function as the stopper layer for etching at the substrate etching step. The through-holes 40 extend through the first metal layer 21 and the opening region portion 22b. This can eliminate the need for removing the opening region portion 22b. In addition, the second metal layer 22 includes the opening region portion 22b, and consequently, the strength of the vapor deposition mask 10 can be improved.

According to the present embodiment, the opening dimension of the through-hole 40 in the predetermined direction at the second surface 20b is larger than the opening dimension of the through-hole 40 in the predetermined direction at the first surface 20a. This enables shadow to be inhibited from occurring in the case where the vapor deposition substrate 110 is brought into close contact with the first surface 20a during vapor deposition. For this reason, the precision of the shapes and the precision of the positions of the organic layers 130A, 130B, and 130C that are composed of the vapor deposition material 82 that is attached to the vapor deposition substrate 110 can be improved, and the definition of the organic device 100 can be improved.

According to the present embodiment, the two or more through-holes 40 are located in the substrate opening 16 of the mask substrate 15. This enables the mask substrate 15 to be inhibited from causing shadow to occur during vapor deposition. For this reason, the precision of the shapes and the precision of the positions of the organic layers 130A, 130B, and 130C that are composed of the vapor deposition material 82 that is attached to the vapor deposition substrate 110 can be improved, and the definition of the organic device 100 can be improved. According to the present embodiment, the multiple through-hole groups 30 are located in the substrate opening 16, and accordingly, shadow can be further inhibited from occurring.

According to the present embodiment, the first alignment marks 45 are provided on the surface of the mask substrate 15 opposite the mask layer 20. This enables the position of the vapor deposition mask 10 and the position of the vapor deposition substrate 110 to be adjusted by using the first alignment marks 45 at the position adjustment step at which the position of the vapor deposition mask 10 is adjusted with respect to the vapor deposition substrate 110. Since the first alignment marks 45 are provided on the mask substrate 15, the position of the vapor deposition mask 10 can be entirely adjusted to the position of the vapor deposition substrate 110.

According to the present embodiment, the second alignment marks 46 are provided at positions nearer than the first alignment marks 45 to the through-holes 40. This enables the position of the vapor deposition mask 10 and the position of the vapor deposition substrate 110 to be adjusted by using the second alignment marks 46 at the position adjustment step at which the position of the vapor deposition mask 10 is adjusted with respect to the vapor deposition substrate 110. The second alignment marks 46 are located at positions nearer than the first alignment marks 45 to the through-holes 40, and accordingly, the precision of the adjustment of the position of the vapor deposition mask 10 and the position of the vapor deposition substrate 110 can be improved. The second alignment marks 46 are provided on the first surface 20a of the mask layer 20, and consequently, the second alignment marks 46 can be visually recognized through the vapor deposition substrate 110 even in the case where the first metal layer 21 does not have the optical transparency.

According to the present embodiment, the second alignment marks 46 are located on the mask sash bars 28a and 28b that are provided between the through-hole groups 30 adjacent to each other. This enables the second alignment marks 46 to be provided at positions nearer to the through-holes 40. For this reason, the precision of the adjustment of the position of the vapor deposition mask 10 and the position of the vapor deposition substrate 110 can be further improved. According to the present embodiment, the second alignment marks 46 are located at the intersecting portions 29 at which the first mask sash bars 28a and the second mask sash bars 28b intersect with each other. This enables the positions of the through-holes 40 in the through-hole groups 30 close to each other to be efficiently adjusted.

According to the present embodiment, the through-holes 40 are formed by irradiating the mask layer 20 with the laser light L. This enables the precision of the shapes and the precision of the positions of the through-holes 40 to be improved. For this reason, the definition of the vapor deposition mask 10 can be improved.

According to the present embodiment, the second surface 20b of the mask layer 20 is irradiated with the laser light L via the substrate opening 16 after the substrate opening 16 is formed. This enables the opening dimension of each through-hole 40 in the predetermined direction at the second surface 20b to be easily larger than the opening dimension of each through-hole 40 in the predetermined direction at the first surface 20a. Consequently, the through-holes 40 that enable shadow to be inhibited from occurring can be easily formed in the case where the vapor deposition substrate 110 is brought into close contact with the first surface 20a during vapor deposition. For this reason, the precision of the shapes and the precision of the positions of the organic layers 130A, 130B, and 130C that are composed of the vapor deposition material 82 that is attached to the vapor deposition substrate 110 can be improved, and the definition of the organic device 100 can be improved.

According to the present embodiment, the laser light L is femtosecond laser light. This enables the laser light to be outputted to the mask layer 20 with a narrow pulse width and high intensity. For this reason, a burr can be inhibited from being formed on the first surface 20a of the mask layer 20, and the adhesion to the vapor deposition substrate 110 can be improved. For this reason, the precision of the shapes and the precision of the positions of the organic layers 130A, 130B, and 130C that are composed of the vapor deposition material 82 that is attached to the vapor deposition substrate 110 can be improved, and the definition of the organic device 100 can be improved.

An embodiment described above can be modified in various ways. Modifications will now be described with reference to the drawings as needed. In the following description and the drawings that are used for the description, a portion that can be configured in the same manner as in an embodiment described above is designated by reference characters like to the reference characters that are used for the corresponding portion according to an embodiment described above, and a duplicated description is omitted. In the case where the action and effect according to an embodiment described above are clearly achieved also according to the modifications, the description thereof is omitted in some cases.

A first modification will now be described.

In an example according to the present embodiment described above, the second metal layer 22 includes the body region portion 22a that is located between the first metal layer 21 and the substrate frame body 17 and the opening region portion 22b that is located in the substrate opening 16 in a plan view. The present disclosure, however, is not limited thereto.

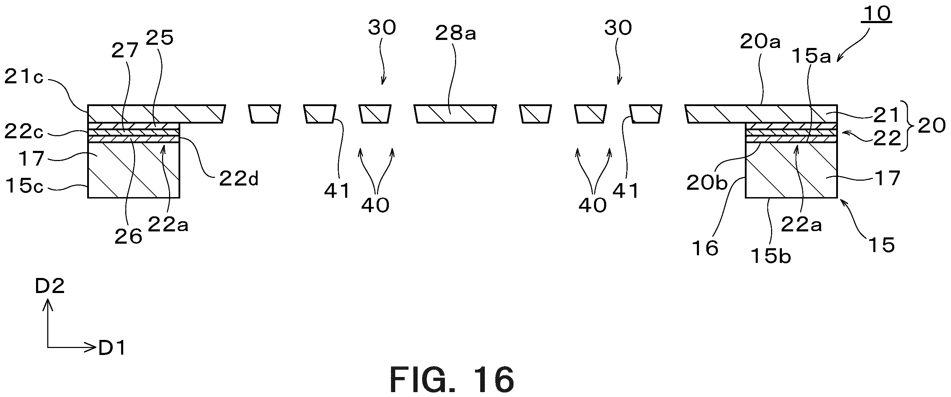

For example, as illustrated in Fig. 16, the second metal layer 22 may include the body region portion 22a and a mask layer opening 22d that is formed along the substrate opening 16 in a plan view. The mask layer opening 22d may extend through the body-facing layer 25, the substrate-facing layer 26, and the intermediate layer 27. The mask layer opening 22d may have the same planar shape as that of the substrate opening 16. In an example illustrated in Fig. 16, the through-holes 40 extend through the first metal layer 21. That is, the through-holes 40 extend from the first surface 20a to the surface of the first metal layer 21 facing the mask substrate 15 through the first metal layer 21.

The opening dimension of each through-hole 40 in the predetermined direction (such as the first direction D11 or the second direction D12) at the surface of the first metal layer 21 facing the mask substrate 15 may be larger than the opening dimension of each through-hole 40 in the predetermined direction at the first surface 20a. According to an embodiment, the sectional openings of the through-holes 40 in a direction parallel with the first surface 20a may be gradually increased in a direction from the first surface 20a toward the surface of the first metal layer 21 facing the mask substrate 15. In other words, the sectional areas of the through-holes 40 in a section parallel with the first surface 20a at positions in the normal direction of the mask layer 20 may be gradually increased in the direction from the first surface 20a toward the surface of the first metal layer 21 facing the mask substrate 15. In this case, the through-holes 40 may include the wall surfaces 41 that are gradually separated from the central axes CL of the through-holes 40 in the direction from the first surface 20a toward the surface of the first metal layer 21 facing the mask substrate 15. In the example illustrated in Fig. 16, the wall surfaces 41 of the through-holes 40 are linearly inclined with respect to the central axes CL so as to be separated from the central axes CL in the direction from the first surface 20a toward the surface of the first metal layer 21 facing the mask substrate 15. For example, the opening dimension of each through-hole 40 at the first surface 20a of the mask layer 20 may be the opening dimension illustrated in Fig. 5A by using the reference characters S1. The opening dimension of each through-hole 40 at the surface of the first metal layer 21 facing the mask substrate 15 may be the opening dimension illustrated in Fig. 5A by using the reference characters S2.

The mask layer opening 22d illustrated in Fig. 16 may be formed in the second metal layer 22 at a mask layer opening formation step after the substrate opening formation step. The mask layer opening 22d may be formed by etching the second metal layer 22. More specifically, the second metal layer 22 is etched, and consequently, a region of the second metal layer 22 that corresponds to the substrate opening 16 is removed. In this way, the mask layer opening 22d may be formed. An example of the etching solution may be N-methylpyrrolidone (NMP). The second metal layer 22 may be immersed in an etching solution, for example, a temperature of the normal temperature or more and 70°C or less for 20 minutes. As for N-methylpyrrolidone, an undiluted solution that is not diluted may be used. The body-facing layer 25, the substrate-facing layer 26, and the intermediate layer 27 may be removed by using different etching solutions.

The through-hole formation step may be performed after the mask layer opening formation step. At the through-hole formation step in this case, the second metal layer 22 includes the mask layer opening 22d. For this reason, the surface of the first metal layer 21 facing the mask substrate 15 is irradiated with the laser light L via the substrate opening 16 and the mask layer opening 22d. Consequently, the through-holes 40 that extend through the first metal layer 21 are formed in the first metal layer 21.

According to the first modification, the second metal layer 22 thus includes the mask layer opening 22d, and consequently, the thickness of a portion of the mask layer 20 at which the through-holes 40 are formed can be reduced. For this reason, shadow can be inhibited from occurring.

A second modification will now be described.

In an example according to the first modification described above, the through-holes 40 are formed by irradiating the first metal layer 21 with the laser light L. The present disclosure, however, is not limited thereto. For example, the through-holes 40 may be formed when the first metal layer 21 is plated at the first metal layer formation step.

A method of manufacturing the vapor deposition mask 10 according to the present modification may include the substrate preparation step, the mask layer formation step, the substrate opening formation step, and the mask layer opening formation step. At the mask layer formation step, the second metal layer formation step is first performed, the resist layer formation step is subsequently performed, and the first metal layer formation step is subsequently performed. At the first metal layer formation step, the through-hole formation step may be performed. After the first metal layer formation step, the resist layer removal step is performed.

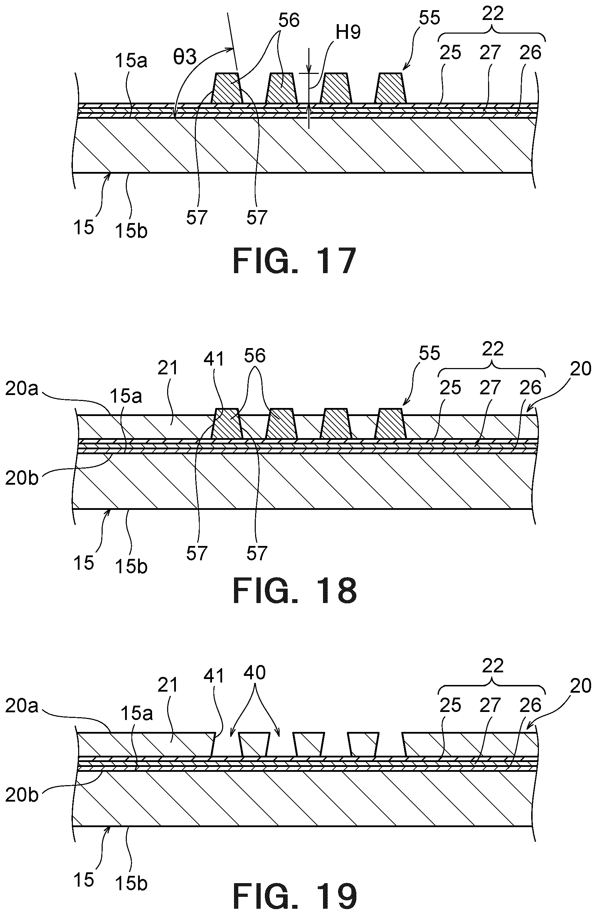

At the resist layer formation step, as illustrated in Fig. 17, a resist layer 55 is formed on the second metal layer 22. The resist layer 55 is patterned so as to correspond to the through-holes 40.

More specifically, liquid resist is first applied to the surface of the body-facing layer 25 opposite the mask substrate 15 by using a spinner. Subsequently, the liquid resist is heated, dried, and hardened. Consequently, the resist layer 55 is formed. The resist layer 55 may be entirely formed on the body-facing layer 25. The liquid resist may be heated, for example, at a temperature of 90°C for 90 seconds.

Subsequently, the resist layer 55 is patterned so as to include multiple resist lands 56 that are formed at positions that correspond to those of the through-holes 40 by performing the photolithography process. For example, in the case where the resist layer 55 is positive resist, an exposure mask (not illustrated) is disposed on the resist layer 55 such that portions of the resist layer 55 that correspond to the through-holes 40 are not irradiated with light. Subsequently, the resist layer 55 is exposed to light via the exposure mask. An i-line stepper exposure device may be used for exposure. An exposure time may be 420 m seconds. In this case, in a region irradiated with light, a focal point during the exposure may be adjusted at a position near the periphery of the region, and consequently, the amount of the emitted light may be reduced. Consequently, wall surfaces 57 of the resist lands 56 are formed so as to be inclined after development. As illustrated in Fig. 17, the wall surfaces 57 of the resist lands 56 may be inclined at an angle θ3 with respect to the second surface 20b of the mask layer 20. The angle θ3 of the wall surfaces 57 may be equal to the angle θ1 illustrated in Fig. 3. That is, the through-holes 40 are formed along the wall surfaces 57. As for the wall surfaces 41 of the through-holes 40 in this case, the same as the angle θ1 illustrated in Fig. 3 is true. For example, in the case where the angle θ3 is 70°, the angle θ1 of the wall surfaces 41 may be 70°.

Subsequently, the resist layer 55 that is exposed to light is developed. Consequently, portions of the resist layer 55 that are exposed to light are removed. For this reason, as illustrated in Fig. 17, the resist layer 55 is patterned so as to include the multiple resist lands 56 that are located at the positions that correspond to those of the through-holes 40.

After the development, the resist layer 55 may be heated. This enables the adhesion of the resist layer 55 to the body-facing layer 25 to be improved. The resist layer 55 may be heated, for example, at a temperature of 110°C for 90 seconds.

An example of the positive resist may be iP5700 made by TOKYO OHKA KOGYO CO., LTD. However, the resist layer 55 may be negative resist. Dry film resist that serves as the resist layer 55 may be stuck to the body-facing layer 25.

The thickness H9 of the resist layer 55 may be greater than the thickness H3 of the first metal layer 21 that is formed at the first metal layer formation step that is subsequently performed.

For example, the thickness H9 of the resist layer 55 may be 4.0 µm or more, may be 4.4 µm or more, may be 4.8 µm or more, or may be 5.2 µm or more. When the thickness H9 is 4.0 µm or more, thickness greater than the thickness of the first metal layer 21 can be ensured at the first metal layer formation step, and the through-holes 40 that extend through the first metal layer 21 can be formed. For example, the thickness H9 may be 5.8 µm or less, may be 6.2 µm or less, may be 6.6 µm or less, or may be 7.0 µm or less. When the thickness H9 is 7.0 µm or less, availability can be ensured in the case of the dry film resist, and the resist layer 55 can be efficiently formed in the case of the liquid resist. The range of the thickness H9 may be determined by using a first group consisting of 4.0 µm, 4.4 µm, 4.8 µm, and 5.2 µm and/or a second group consisting of 5.8 µm, 6.2 µm, 6.6 µm, and 7.0 µm. The range of the thickness H9 may be determined by using a combination of a freely selected one of values in the first group described above and a freely selected one of values in the second group described above. The range of the thickness H9 may be determined by using a combination of freely selected two of values in the first group described above. The range of the thickness H9 may be determined by using a combination of freely selected two of values in the second group described above. For example, the range may be 4.0 µm or more and 7.0 µm or less, may be 4.0 µm or more and 6.6 µm or less, may be 4.0 µm or more and 6.2 µm or less, may be 4.0 µm or more and 5.8 µm or less, may be 4.0 µm or more and 5.2 µm or less, may be 4.0 µm or more and 4.8 µm or less, may be 4.0 µm or more and 4.4 µm or less, may be 4.4 µm or more and 7.0 µm or less, may be 4.4 µm or more and 6.6 µm or less, may be 4.4 µm or more and 6.2 µm or less, may be 4.4 µm or more and 5.8 µm or less, may be 4.4 µm or more and 5.2 µm or less, may be 4.4 µm or more and 4.8 µm or less, may be 4.8 µm or more and 7.0 µm or less, may be 4.8 µm or more and 6.6 µm or less, may be 4.8 µm or more and 6.2 µm or less, may be 4.8 µm or more and 5.8 µm or less, may be 4.8 µm or more and 5.2 µm or less, may be 5.2 µm or more and 7.0 µm or less, may be 5.2 µm or more and 6.6 µm or less, may be 5.2 µm or more and 6.2 µm or less, may be 5.2 µm or more and 5.8 µm or less, may be 5.8 µm or more and 7.0 µm or less, may be 5.8 µm or more and 6.6 µm or less, may be 5.8 µm or more and 6.2 µm or less, may be 6.2 µm or more and 7.0 µm or less, may be 6.2 µm or more and 6.6 µm or less, or may be 6.6 µm or more and 7.0 µm or less.

At the first metal layer formation step, as illustrated in Fig. 18, the first metal layer 21 is formed on the surface of the second metal layer 22 opposite the mask substrate 15. The first metal layer 21 may be formed by performing the plating process in the same manner as in that at the first metal layer formation step illustrated in Fig. 8. In this case, the resist layer 55 is formed on the surface of the second metal layer 22 opposite the mask substrate 15, and accordingly, the components of the plating solution precipitate on portions of the body-facing layer 25 at which the resist lands 56 of the resist layer 55 are not formed. In this way, the precipitating components form the first metal layer 21. The through-holes 40 are formed in the first metal layer 21 formed in this way. That is, at the first metal layer formation step, the through-holes 40 are formed. The annealing treatment may be performed on the first metal layer 21 as described above.

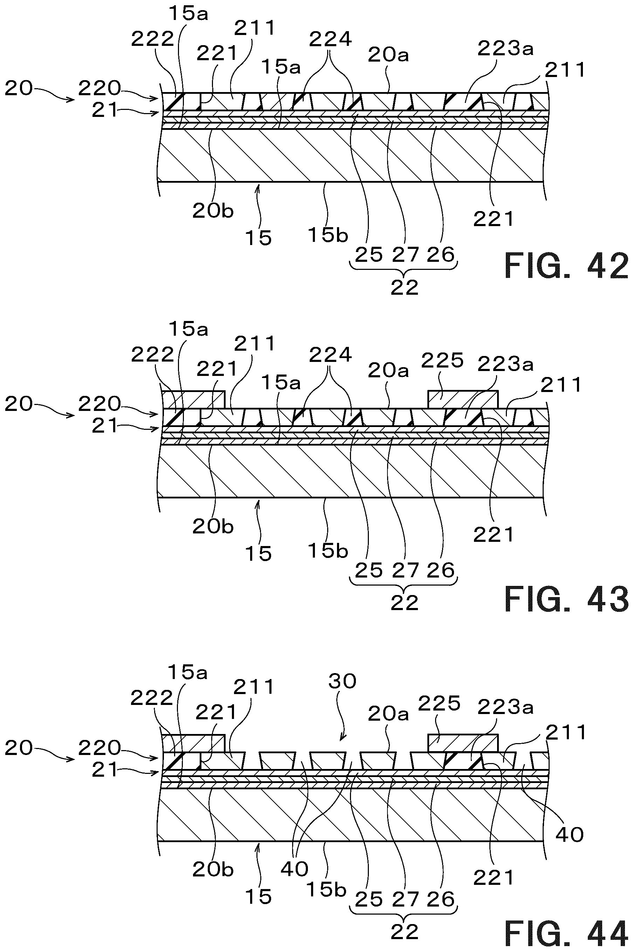

At the resist layer removal step, as illustrated in Fig. 19, the resist layer 55 is removed. For example, the resist lands 56 of the resist layer 55 may be removed from the second metal layer 22 by using an alkali stripping solution. After the resist layer 55 is removed, the first metal layer 21 may be polished by chemical mechanical polishing as illustrated in Fig. 42 described later. In this case, the uniformness of the thickness H3 of the first metal layer 21 can be improved. For this reason, the precision of the opening dimension S1 (see Fig. 5A) of the through-holes 40 can be improved, and the precision of the shapes of the through-holes 40 can be improved.

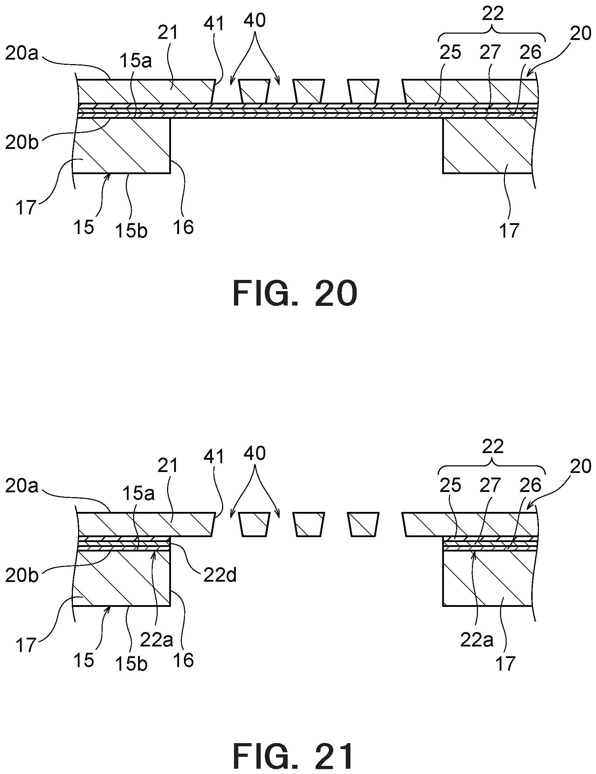

At the substrate opening formation step after the mask layer formation step, as illustrated in Fig. 20, the substrate opening 16 is formed in the mask substrate 15. The substrate opening formation step illustrated in Fig. 20 may be performed in the same manner as the substrate opening formation step illustrated in Fig. 9 to Fig. 12.

At the mask layer opening formation step after the substrate opening formation step, as illustrated in Fig. 21, the mask layer opening 22d is formed in the second metal layer 22. For example, a portion of the second metal layer 22 that is located in the substrate opening 16 in a plan view may be removed by etching. Consequently, the mask layer opening 22d can be formed. More specifically, the body-facing layer 25, the substrate-facing layer 26, and the intermediate layer 27 are etched, and consequently, the mask layer opening 22d is formed. The etching solution that is used at the mask layer opening formation step may be an etching solution that enables the first metal layer 21 to be prevented from being etched and enables the second metal layer 22 to be etched. An example of the etching solution may be a mixed acid aluminum etching solution. The body-facing layer 25, the substrate-facing layer 26, and the intermediate layer 27 may be immersed, for example, in the mixed acid aluminum etching solution at the normal temperature. For example, in the case where the thicknesses of each of the layers 25 to 27 are 100 nm, the layers 25 to 27 may be immersed in the mixed acid aluminum etching solution for 2 minutes. As for the mixed acid aluminum etching solution, an undiluted solution that is not diluted may be used. An example of the mixed acid aluminum etching solution may be a product named "mixed acid Al etching solution" made by Kanto Chemical Industry Co., Ltd.

In this way, the through-holes 40 are exposed through the substrate opening 16. Consequently, the vapor deposition mask 10 according to the present modification is obtained.

According to the second modification, the through-holes 40 can be thus formed regardless of the kind of the material of the first metal layer 21. That is, in some cases, it is difficult for laser processing to be performed by using the laser light L depending on the kind of the material of the first metal layer 21 such as nickel. However, the resist layer 55 that is patterned so as to correspond to the through-holes 40 enables the through-holes 40 to be formed in the first metal layer 21 that is formed by performing the plating process. For this reason, the through-holes 40 can be formed regardless of the kind of the material of the first metal layer 21.

A third modification will now be described.

In an example according to the present embodiment described above, the second metal layer 22 includes the body-facing layer 25, the substrate-facing layer 26, and the intermediate layer 27. The present disclosure, however, is not limited thereto.

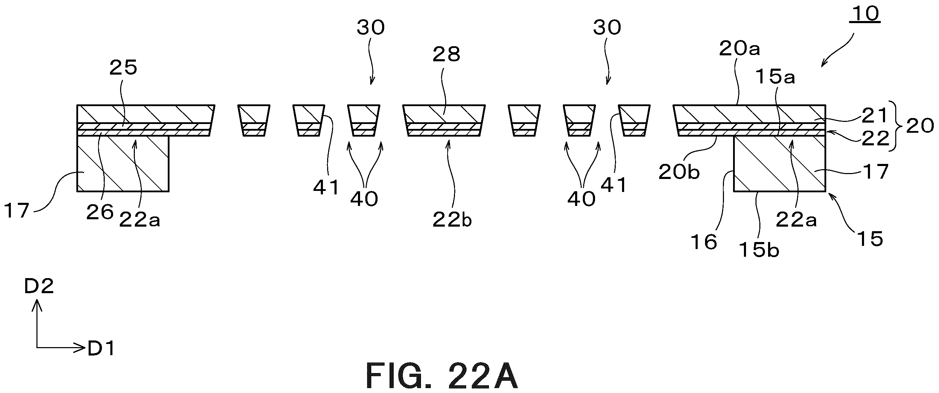

For example, as illustrated in Fig. 22A, the second metal layer 22 may include the body-facing layer 25 and the substrate-facing layer 26 and may not include the intermediate layer 27. The second metal layer 22 may have a two-layer structure. The body-facing layer 25 and the substrate-facing layer 26 may have the inherent purpose. In this case, the body-facing layer 25 and the substrate-facing layer 26 may be in direct contact with each other.

The body-facing layer 25 illustrated in Fig. 22A may contain a material that enables the adhesion to the first metal layer 21 to be ensured and may contain, for example, copper. The substrate-facing layer 26 may contain a material that enables the adhesion to the mask substrate 15 to be ensured and that enables the erosion of the etching medium that is used at the substrate etching step to be reduced and may contain, for example, an aluminum alloy such as neodymium. For example, the body-facing layer 25 and the substrate-facing layer 26 may be composed of such a material when the substrate-facing layer 26 has the resistance against the plating solution for forming the first metal layer 21. For example, the body-facing layer 25 and the substrate-facing layer 26 may be composed of such a material even in the case where the substrate-facing layer 26 does not have the resistance against the plating solution if the substrate-facing layer 26 has a sufficient thickness to remain after the first metal layer formation step.

Alternatively, the body-facing layer 25 illustrated in Fig. 22A may contain a material that enables the substrate-facing layer 26 to be protected from the plating solution that is used at the first metal layer formation step and may contain, for example, titanium. The substrate-facing layer 26 may contain a material that enables the adhesion to the mask substrate 15 to be ensured and that enables the erosion of the etching medium that is used at the substrate etching step to be reduced and may contain, for example, an aluminum alloy that contains neodymium. For example, the body-facing layer 25 and the substrate-facing layer 26 may be composed of such a material, provided that the body-facing layer 25 is capable of ensuring the adhesion to the first metal layer 21.

Alternatively, the body-facing layer 25 illustrated in Fig. 22A may contain a material that enables the adhesion to the first metal layer 21 to be ensured and may contain, for example, copper. The substrate-facing layer 26 may contain a material that has the resistance against the plating solution that is used at the first metal formation step and may contain, for example, titanium. For example, the body-facing layer 25 and the substrate-facing layer 26 may be composed of such a material, provided that the substrate-facing layer 26 is composed of a material that enables the adhesion to the mask substrate 15 to be ensured and is capable of reducing the erosion of the etching medium that is used at the substrate etching step.

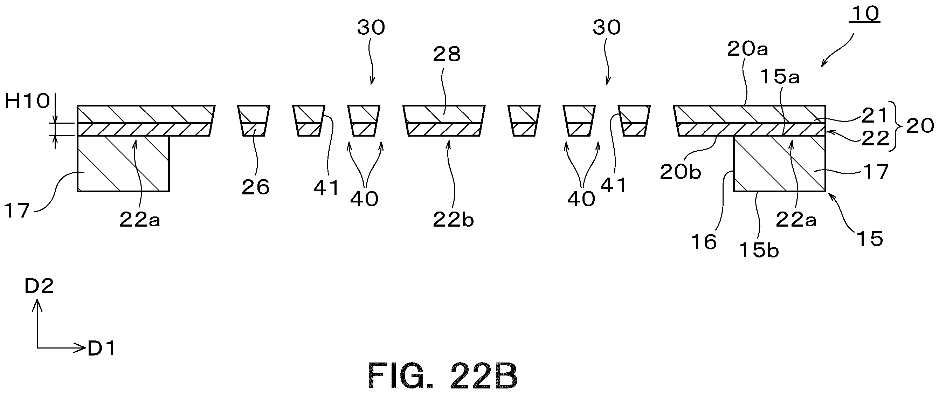

As illustrated in Fig. 22B, the second metal layer 22 may be formed by a single metal layer. The single metal layer may be composed of a material that has the adhesion to the first metal layer 21, the adhesion to the mask substrate 15, the resistance against the etching medium, and the resistance against the plating solution. In this case, the second metal layer 22 may be composed of the same material as the substrate-facing layer 26 described above. In other words, the second metal layer 22 may be formed by only the substrate-facing layer 26 described above. In this case, the substrate-facing layer 26 is in direct contact with the first metal layer 21 and is in direct contact with the mask substrate 15. When the thickness H10 of the substrate-facing layer 26 in this case is the desired thickness H10 illustrated in Fig. 22B, the adhesion to the first metal layer 21, the adhesion to the mask substrate 15, and the erosion of the etching medium can be reduced. The substrate-facing layer 26 may be formed by performing the sputtering process or may be formed by performing the vapor deposition process described later, provided that the thickness H10 can be ensured.

For example, the thickness H10 of the substrate-facing layer 26 in this case may be 0.6 µm or more, may be 0.8 µm or more, may be 1.0 µm or more, or may be 1.2 µm or more. When the thickness H10 is 0.6 µm or more, the erosion of the etching medium that is used at the substrate etching step can be reduced, and the resistance against the plating solution can be ensured. For this reason, the body-facing layer 25 and the intermediate layer 27 can be omitted. For example, the thickness H10 may be 1.4 µm or less, may be 1.6 µm or less, may be 1.8 µm or less, or may be 2.0 µm or less. When the thickness H10 is 2.0 µm or less, the substrate-facing layer 26 can be efficiently formed by performing the sputtering process. The range of the thickness H10 may be determined by using a first group consisting of 0.6 µm, 0.8 µm, 1.0 µm, and 1.2 µm and/or a second group consisting of 1.4 µm, 1.6 µm, 1.8 µm, and 2.0 µm. The range of the thickness H10 may be determined by using a combination of a freely selected one of values in the first group described above and a freely selected one of values in the second group described above. The range of the thickness H10 may be determined by using a combination of freely selected two of values in the first group described above. The range of the thickness H10 may be determined by using a combination of freely selected two of values in the second group described above. For example, the range may be 0.6 µm or more and 2.0 µm or less, may be 0.6 µm or more and 1.8 µm or less, may be 0.6 µm or more and 1.6 µm or less, may be 0.6 µm or more and 1.4 µm or less, may be 0.6 µm or more and 1.2 µm or less, may be 0.6 µm or more and 1.0 µm or less, may be 0.6 µm or more and 0.8 µm or less, may be 0.8 µm or more and 2.0 µm or less, may be 0.8 µm or more and 1.8 µm or less, may be 0.8 µm or more and 1.6 µm or less, may be 0.8 µm or more and 1.4 µm or less, may be 0.8 µm or more and 1.2 µm or less, may be 0.8 µm or more and 1.0 µm or less, may be 1.0 µm or more and 2.0 µm or less, may be 1.0 µm or more and 1.8 µm or less, may be 1.0 µm or more and 1.6 µm or less, may be 1.0 µm or more and 1.4 µm or less, may be 1.0 µm or more and 1.2 µm or less, may be 1.2 µm or more and 2.0 µm or less, may be 1.2 µm or more and 1.8 µm or less, may be 1.2 µm or more and 1.6 µm or less, may be 1.2 µm or more and 1.4 µm or less, may be 1.4 µm or more and 2.0 µm or less, may be 1.4 µm or more and 1.8 µm or less, may be 1.4 µm or more and 1.6 µm or less, may be 1.6 µm or more and 2.0 µm or less, may be 1.6 µm or more and 1.8 µm or less, or may be 1.8 µm or more and 2.0 µm or less.

A fourth modification will now be described.

In an example according to the present embodiment described above, the second metal layer 22 is formed on the mask substrate 15 by performing the sputtering process. The present disclosure, however, is not limited thereto, and the body-facing layer 25, the substrate-facing layer 26, and the intermediate layer 27 may be formed by performing the vapor deposition process such as physical vapor deposition (PVD) or chemical vapor deposition (CVD).

A fifth modification will now be described.

In an example according to the present embodiment described above, the through-hole formation step is performed after the substrate opening formation step. The present disclosure, however, is not limited thereto, and the through-hole formation step may be performed before the substrate opening formation step. In this case, the first surface 20a of the mask layer 20 may be irradiated with the laser light L. The wall surfaces 41 of the through-holes 40 may be perpendicular to the first surface 20a (the angle θ described above is 90°). The vapor deposition mask 10 may be used for a vapor deposition apparatus in the surface vapor deposition method described above.

A sixth modification will now be described.

In an example according to the present embodiment described above, the first metal layer 21 of the mask layer 20 is formed by performing the plating process. The present disclosure, however, is not limited thereto. For example, the first metal layer 21 may be formed in the sputtering process and may be attached to the second metal layer 22. In this case, the same metal layer as the substrate-facing layer 26 described above may be provided as the second metal layer between the mask substrate 15 and the first metal layer 21 formed by performing the sputtering process

A seventh modification will now be described.

In an example according to the present embodiment described above, the through-holes 40 are formed by irradiating the first metal layer 21 and the second metal layer 22 with the laser light L. The present disclosure, however, is not limited thereto, and the through-holes 40 may be formed by etching the first metal layer 21 and the second metal layer 22. In this case, for example, regions that are not covered by patterned resist (not illustrated) may be etched, and the through-holes 40 that extend through the mask layer 20 may be formed. In the case of wet etching, an example of the etching solution may be a liquid that contains a ferric chloride solution and hydrochloric acid. For example, the temperature of the etching solution is 25°C or more and 80° or less. In the case of dry etching, an example of the etching gas may be methane gas (CH₄) or carbon dioxide gas (CO₂).

An eighth modification will now be described.

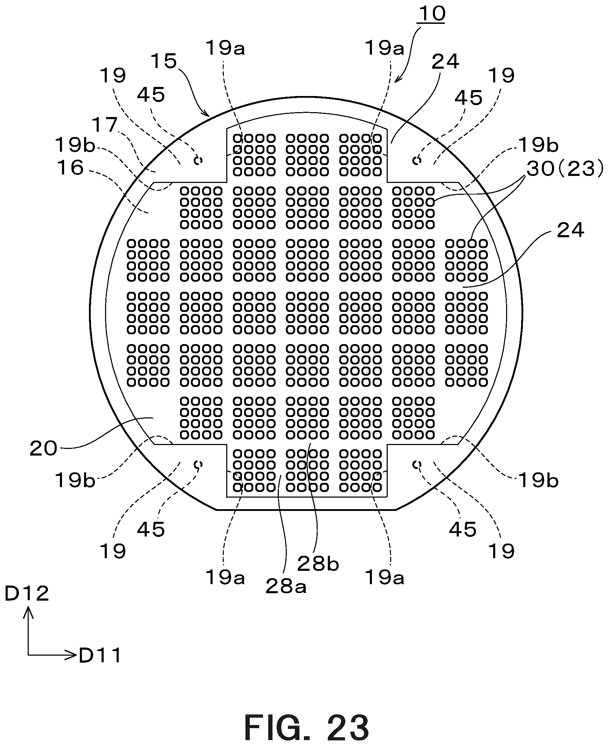

In an example according to the present embodiment described above, the first alignment marks 45 for adjusting the position of the vapor deposition substrate 110 is provided on the substrate frame body 17 of the mask substrate 15. The present disclosure, however, is not limited thereto. For example, as illustrated in Fig. 23, the mask substrate 15 may include inner projecting portions 19 that extend inward from the substrate frame body 17 in a plan view, and the first alignment marks 45 may be located on the inner projecting portions 19. Each inner projecting portion 19 may include a side wall 19a that faces the through-hole groups 30 adjacent to each other in the first direction D11 and a side wall 19b that faces the through-hole groups 30 adjacent to each other in the second direction D12. In a plan view, the side wall 19a may extend in the second direction D12, and the side wall 19b may extend in the first direction D11. The first alignment marks 45 are provided on the inner projecting portions 19, consequently, the first alignment marks 45 can be located near the through-hole groups 30, and the positions of the through-holes 40 can be adjusted with improved precision.

A ninth modification will now be described.

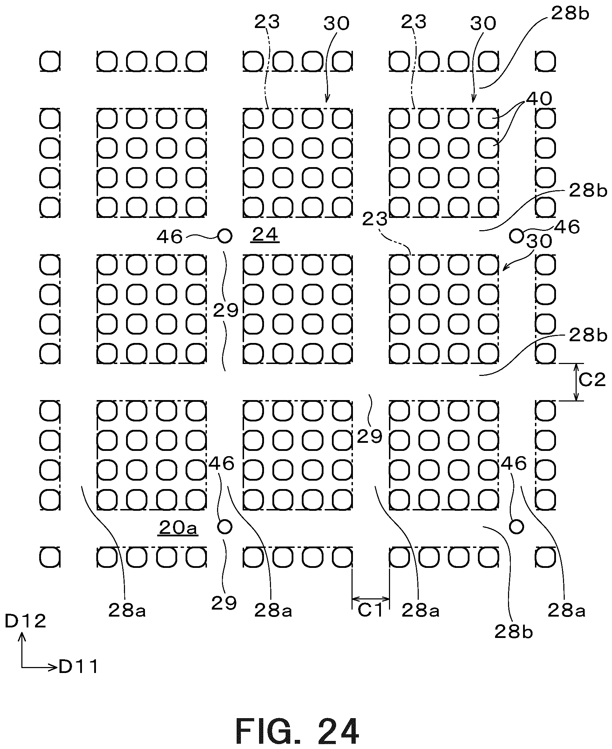

In an example according to the present embodiment described above, the second alignment marks 46 for adjusting the position of the vapor deposition substrate 110 are provided at the intersecting portions 29 at which the first mask sash bars 28a and the second mask sash bars 28b of the mask layer 20 intersect with each other. The present disclosure, however, is not limited thereto, and as illustrated in Fig. 24, the second alignment marks 46 may not be provided at all of the intersecting portions 29. For example, the second alignment marks 46 may be provided for respective sets of the multiple through-hole groups 30 in the first direction D11. In Fig. 24, the second alignment marks 46 are provided for respective two sets of the through-hole groups 30 in the first direction D11 and the second direction D12. More specifically, the second alignment marks 46 may be provided on one of two first mask sash bars 28a adjacent to each other in the first direction D11, and no second alignment marks 46 may be provided on the other of the second alignment marks 46. The second alignment marks 46 may be provided on one of two second mask sash bars 28b adjacent to each other in the second direction D12, and no second alignment marks 46 may be provided on the other of the second alignment marks 46. In this case, the second alignment mark 46 is provided at a position that corresponds to the corner portions of four through-hole groups 30.

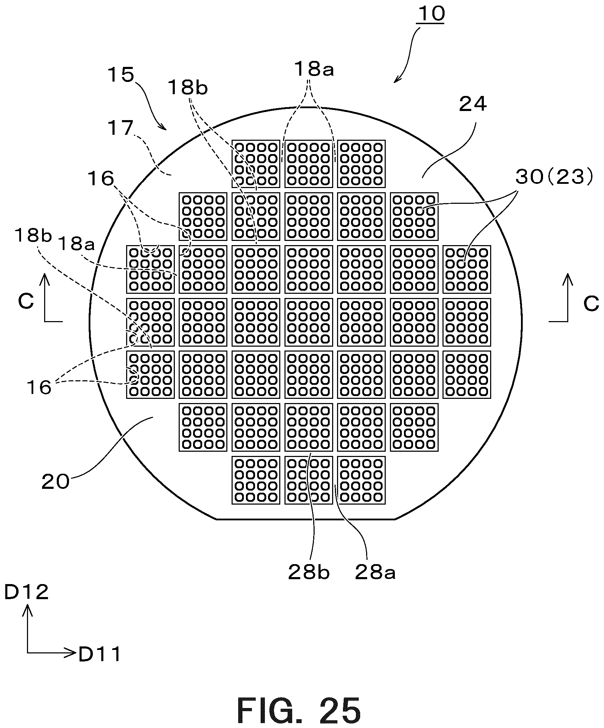

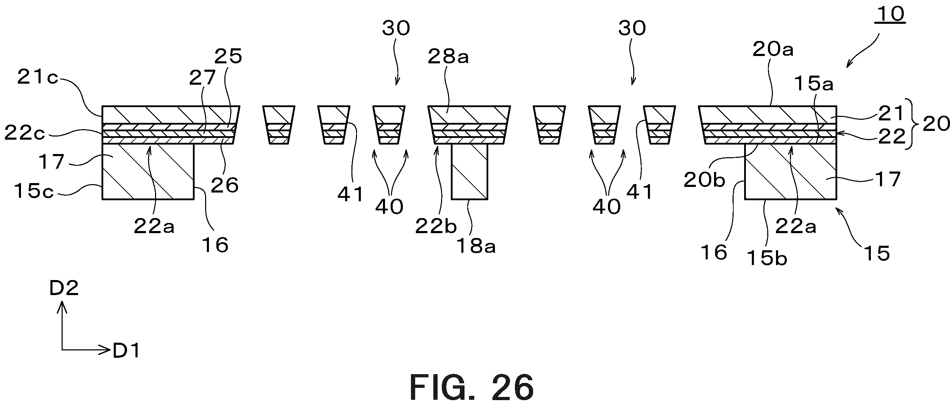

The second alignment marks 46 may not be provided on the mask layer 20 but may be provided on substrate sash bars 18a and 18b (see Fig. 25 and Fig. 26) of the mask substrate 15 described later although this is not illustrated. In the case where the second alignment marks 46 are formed in a recessed shape, the second alignment marks 46 may be formed on the second substrate surface 15b at the substrate sash bars 18a and 18b. In this case, the second alignment marks 46 can be visually recognized through the vapor deposition substrate 110 and the mask layer 20 by radiating infrared rays. In a plan view, the second alignment marks 46 may be located at the same positions as those of the second alignment marks 46 illustrated in Fig. 3 or may be located at the same positions as those of the second alignment marks 46 illustrated in Fig. 24, which is freely determined. The second alignment marks 46 in the recessed shape may be formed by etching the second substrate surface 15b at the substrate sash bars 18a and 18b at the substrate etching step.

A tenth modification will now be described.

In an example according to the present embodiment described above, all of the through-hole groups 30 are located in the single substrate opening 16 of the mask substrate 15. The present disclosure, however, is not limited thereto, and the mask substrate 15 may include multiple substrate openings 16. For example, as illustrated in Fig. 25 and Fig. 26, the substrate sash bars 18a and 18b may be provided between the substrate openings 16 adjacent to each other. The substrate sash bars 18a and 18b may include first substrate sash bars 18a that are arranged in the first direction D11 and second substrate sash bars 18b that are arranged in the second direction D12. The first substrate sash bars 18a may extend in the second direction D12. The first substrate sash bars 18a may overlap the first mask sash bars 28a described above in a plan view. The second substrate sash bars 18b may extend in the first direction D11. The second substrate sash bars 18b may overlap the second mask sash bars 28b described above in a plan view. Fig. 26 schematically illustrates a section taken along a line C-C in Fig. 25 where the number of the through-hole groups 30 and the number of the through-holes 40 are reduced to make the figure easy to understand.

In an example illustrated in Fig. 25 and Fig. 26, a corresponding one of the through-hole groups 30 (or the effective regions 23) is located in each substrate opening 16. The substrate openings 16 illustrated in Fig. 25 and Fig. 26 may have shapes that is formed along the contours of the respective through-hole groups 30 (or the respective effective regions 23). The substrate sash bars 18a and 18b are connected to the substrate frame body 17 and are located between the through-hole groups 30 adjacent to each other in a plan view. Fig. 26 illustrates the first substrate sash bars 18a, and the first substrate sash bars 18a extend in a direction perpendicular to the paper. Both ends of each first substrate sash bar 18a are connected to the substrate frame body 17 so as to be continuous thereto. The second substrate sash bars 18b extend in a left-right direction in Fig. 26 although this is not illustrated in Fig. 26. Both ends of each second substrate sash bar 18b are connected to the substrate frame body 17 so as to be continuous thereto. In this way, the multiple substrate openings 16 are defined by the first substrate sash bars 18a that extend in the second direction D12 and the second substrate sash bars 18b that extend in the first direction D11 in a plan view.

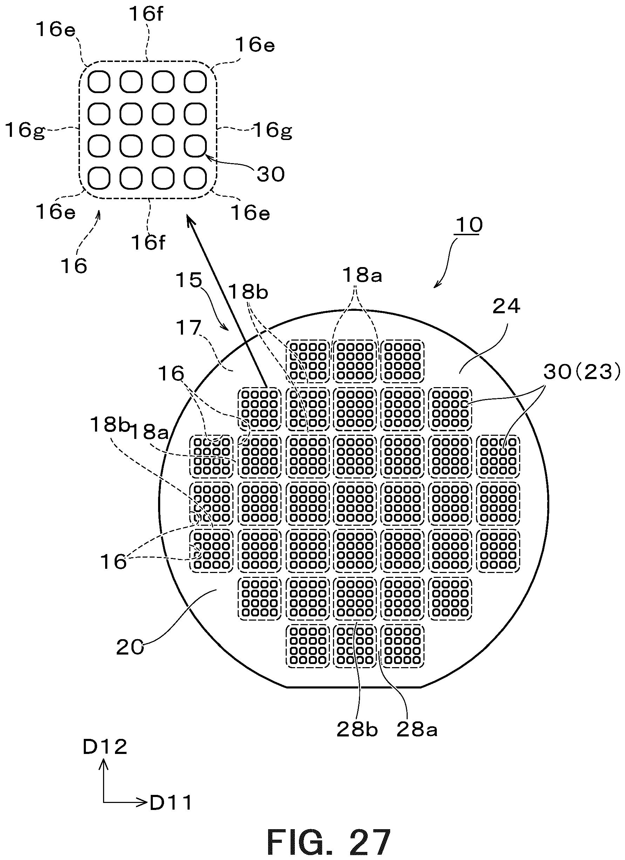

In the example illustrated in Fig. 25, the substrate openings 16 have a contour that has a substantially rectangular shape in a plan view. The four corners of the contour of each substrate opening 16 may be formed in a manner in which sides 16f (see Fig. 27) that extend in the first direction D11 and sides 16g that extends in the second direction D12, which form the contour of the substrate opening 16, directly intersect with each other. However, a contour that has a small, curved shape and that is unintentionally formed may be interposed between the sides. The present disclosure, however, is not limited thereto.

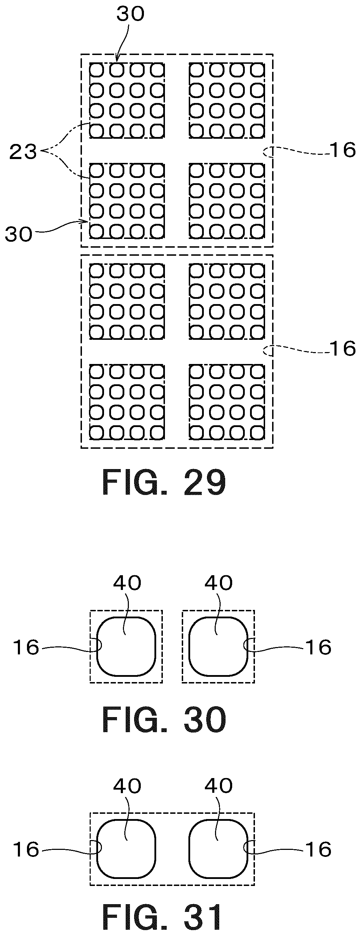

For example, as for each substrate opening 16, as illustrated in, Fig. 27, curved portions 16e may be provided at the four corners of the contour of the substrate opening 16 that has a substantially rectangular shape in a plan view. The curved portions 16e connect the sides 16f that extend in the first direction D11 and the sides 16g that extend in the second direction D12 in the contour of the substrate opening 16 to each other into rounded shapes. The curved portions 16e may be intentionally formed so as to form a contour that has a curved shape. For example, the curved portions 16e may be formed in an arc shape. The curved portions 16e may be included in the substrate openings 16 illustrated in Fig. 29 to Fig. 31.

For example, the radius R of each curved portion 16e illustrated in Fig. 27 may be 0.3 mm or more, may be 0.6 mm or more, may be 0.9 mm or more, or may be 1.2 mm or more. When the radius R is 0.3 mm or more, stress can be inhibited from being concentrated on the four corners of each substrate opening 16. For example, the radius R may be 1.5 mm or less, may be 2.0 mm or less, may be 2.5 mm or less, or may be 3.0 mm or less. When the radius R is 3.0 mm or less, the number of the through-holes 40 that can be located in the substrate opening 16 can be inhibited from being limited. The range of the radius R may be determined by using a first group consisting of 0.3 mm, 0.6 mm, 0.9 mm, and 1.2 mm and/or a second group consisting of 1.5 mm, 2.0 mm, 2.5 mm, and 3.0 mm. The range of the radius R may be determined by using a combination of a freely selected one of values in the first group described above and a freely selected one of values in the second group described above. The range of the radius R may be determined by using a combination of freely selected two of values in the first group described above. The range of the radius R may be determined by using a combination of freely selected two of values in the second group described above. For example, the range may be 0.3 mm or more and 3.0 mm or less, may be 0.3 mm or more and 2.5 mm or less, may be 0.3 mm or more and 2.0 mm or less, may be 0.3 mm or more and 1.5 mm or less, may be 0.3 mm or more and 1.2 mm or less, may be 0.3 mm or more and 0.9 mm or less, may be 0.3 mm or more and 0.6 mm or less, may be 0.6 mm or more and 3.0 mm or less, may be 0.6 mm or more and 2.5 mm or less, may be 0.6 mm or more and 2.0 mm or less, may be 0.6 mm or more and 1.5 mm or less, may be 0.6 mm or more and 1.2 mm or less, may be 0.6 mm or more and 0.9 mm or less, may be 0.9 mm or more and 3.0 mm or less, may be 0.9 mm or more and 2.5 mm or less, may be 0.9 mm or more and 2.0 mm or less, may be 0.9 mm or more and 1.5 mm or less, may be 0.9 mm or more and 1.2 mm or less, may be 1.2 mm or more and 3.0 mm or less, may be 1.2 mm or more and 2.5 mm or less, may be 1.2 mm or more and 2.0 mm or less, may be 1.2 mm or more and 1.5 mm or less, may be 1.5 mm or more and 3.0 mm or less, may be 1.5 mm or more and 2.5 mm or less, may be 1.5 mm or more and 2.0 mm or less, may be 2.0 mm or more and 3.0 mm or less, may be 2.0 mm or more and 2.5 mm or less, or may be 2.5 mm or more and 3.0 mm or less.

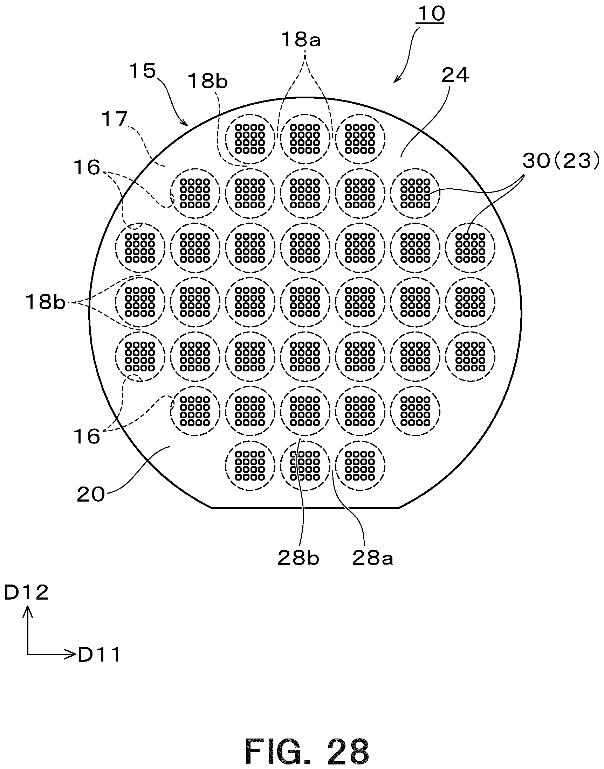

As illustrated in Fig. 28, the substrate openings 16 may have a contour that has a circular shape in a plan view. At the substrate etching step illustrated in Fig. 10, portions of the mask substrate 15 that correspond to the substrate sash bars 18a and 18b are not etched but remain, and consequently, the substrate sash bars 18a and 18b can be formed.

The mask substrate 15 thus has the multiple substrate openings 16, and consequently, the mask layer 20 can be supported by the material (the substrate sash bars 18a and 18b) of the mask substrate 15 that remains between the substrate openings 16. For this reason, the mechanical strength of the vapor deposition mask 10 can be improved.

In the case where the mask substrate 15 has the multiple substrate openings 16, as illustrated in Fig. 25 to Fig. 27, it is not limited that one of the through-hole groups 30 is located in one of the substrate openings 16. For example, as illustrated in Fig. 29, two or more through-hole groups 30 (or the effective regions 23) may be located in one of the substrate openings 16. In an example illustrated in Fig. 29, the four through-hole groups 30 are located in one of the substrate openings 16. Alternatively, it is not limited that all of the through-holes 40 that form one of the through-hole groups 30 are located in the one of the substrate opening 16. For example, one of the through-hole groups 30 may be across two or more substrate openings 16 in a plan view. For example, as illustrated in Fig. 30, one of the through-holes 40 may be located in one of the substrate openings 16. In an example illustrated in Fig. 30, the substrate openings 16 are provided for the respective through-holes 40. As illustrated in Fig. 31, two or more through-holes 40 may be located in one of the substrate openings 16. In an example illustrated in Fig. 31, two through-holes 40 are located in one of the substrate openings 16.

An eleventh modification will now be described.

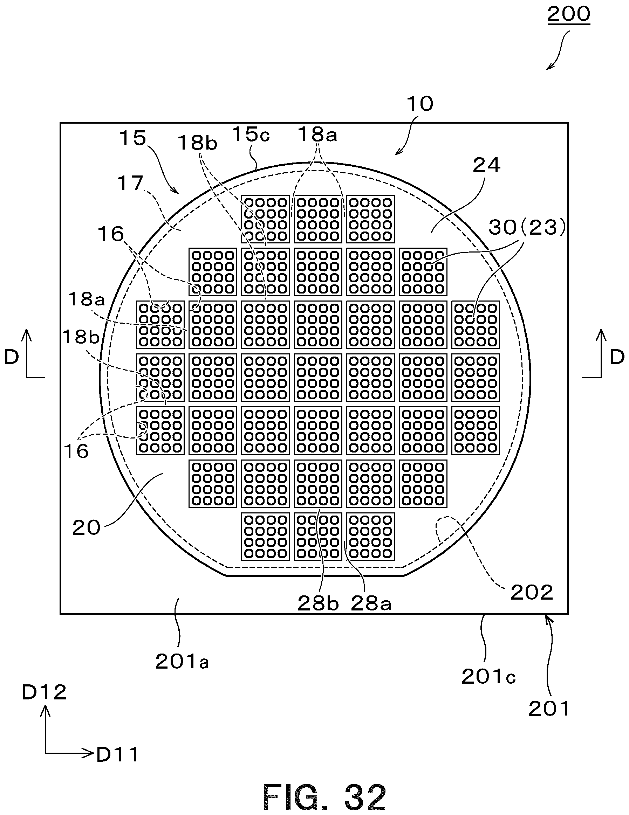

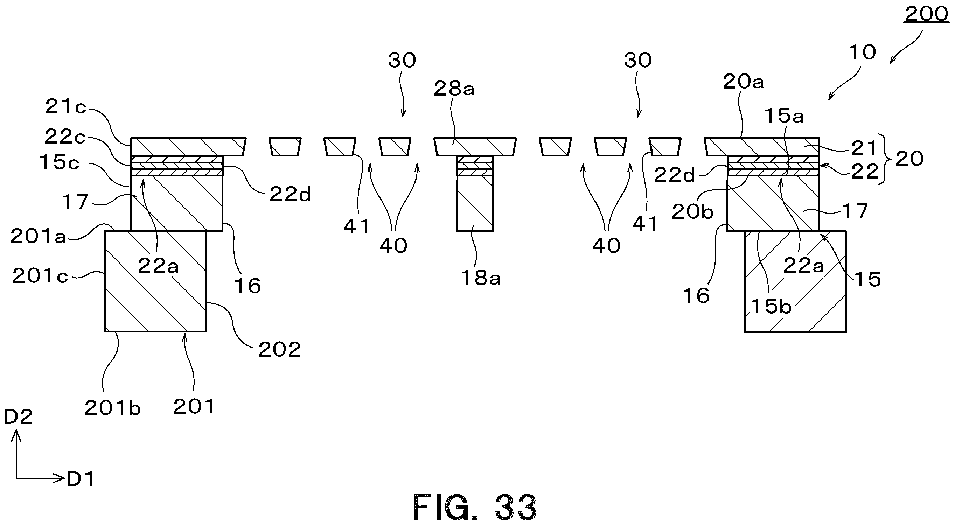

In an example according to the present embodiment described above, the vapor deposition mask 10 includes the mask layer 20 and the mask substrate 15. The present disclosure, however, is not limited thereto. For example, as illustrated in Fig. 32 and Fig. 33, the mask substrate 15 may be supported by a frame 201. In this case, a framed vapor deposition mask 200 may include the vapor deposition mask 10 and the frame 201.

More specifically, the framed vapor deposition mask 200 includes the vapor deposition mask 10 and the frame 201 that supports the mask substrate 15 of the vapor deposition mask 10. The frame 201 may be attached to the mask substrate 15 of the vapor deposition mask 10 when the vapor deposition mask 10 is used, for example, in order to hold the vapor deposition mask 10 when the vapor deposition mask 10 is moved. Consequently, the vapor deposition mask 10 can be used while the frame 201 is held, and the vapor deposition mask 10 can be inhibited from being damaged. As a result, handling of the vapor deposition mask 10 can be improved.

The frame 201 may include a first frame surface 201a and a second frame surface 201b. The first frame surface 201a faces the mask substrate 15 and faces the second substrate surface 15b of the mask substrate 15. The second frame surface 201b is located opposite the first frame surface 201a. The first frame surface 201a is connected to the substrate frame body 17 of the mask substrate 15. The frame 201 does not overlap the substrate openings 16 in a plan view. At least a portion of the frame 201 extends outward beyond the outer edge 15c of the mask substrate 15 in a plan view. Consequently, a region for holding the frame 201 when the vapor deposition mask 10 is used is formed. In an example illustrated in Fig. 32, the frame 201 entirely extends outward beyond the outer edge 15c of the mask substrate 15.

The frame 201 may contain a glass material or a metal material. Examples of the glass material may include quartz glass, borosilicate glass, alkali-free glass or soda glass. Examples of the metal material may include an invar material, aluminum, and stainless steel such as SUS430 or SUS304. The use of the material for the frame 201 enables the rigidity of the frame 201 to be greater than that of the mask substrate 15. The frame 201 may contain a silicon or resin material. The material of the frame 201 may be determined such that the frame 201 has the required rigidity in consideration of holding force of an operator who uses the framed vapor deposition mask 200 or a robot hand.

The thermal expansion coefficient of the frame 201 may be equal or close to the thermal expansion coefficient of the mask substrate 15. This enables the expansion rates of the frame 201 and the mask substrate 15 to be equal to each other when the framed vapor deposition mask 200 is heated. As a result, the mask substrate 15 can be inhibited from being damaged. In addition, the precision of the positions of the through-holes 40 can be improved, and the precision of vapor deposition can be improved. More specifically, the absolute value of a difference between the thermal expansion coefficient of the frame 201 and the thermal expansion coefficient of the mask substrate 15 may be 15 ppm/°C or less, may be 10 ppm/°C or less, or may be 5.0 ppm/°C or less. The material of the frame 201 may be a material that has high thermal conductivity. In this case, the vapor deposition mask 10 can be efficiently cooled.

In an illustrated example, the frame 201 has an annular shape. A portion of the frame 201 that is located outside the outer edge 15c of the mask substrate 15 in a plan view can have an annular shape. This enables the substrate frame body 17 of the mask substrate 15 to be effectively inhibited from being damaged when the vapor deposition mask 10 is used. More specifically, a frame opening 202 that extends from the first frame surface 201a to the second frame surface 201b through the frame 201 is formed at the center of the frame 201. In the illustrated example, the planar shape of the frame opening 202 is similar to the planar shape of the outer edge 15c of the mask substrate 15. The frame opening 202 overlaps the substrate openings 16 of the mask substrate 15 in a plan view. In the illustrated example, the mask substrate 15 includes the first substrate sash bars 18a and the second substrate sash bars 18b described above, and the substrate sash bars 18a and 18b define the multiple substrate openings 16 as in the example illustrated in Fig. 25 and Fig. 26. The frame opening 202 overlaps the first substrate sash bars 18a and the second substrate sash bars 18b of the mask substrate 15 in a plan view.

The planar shape of an outer edge 201c of the frame 201 is freely determined. In the illustrated example, in a plan view, the outer edge 201c of the frame 201 has a rectangular shape but may have another polygonal shape or a circular shape.

In an example according to the eleventh modification described above, the mask substrate 15 of the vapor deposition mask 10 according to the tenth modification illustrated in Fig. 25 and Fig. 26 is supported by the frame 201. The present disclosure, however, is not limited thereto. The mask substrate 15 of the vapor deposition mask 10 illustrated in Fig. 3 may be supported by the frame 201, or the mask substrate 15 of the vapor deposition mask 10 according to another modification may be supported by the frame 201. For example, the second metal layer 22 illustrated in Fig. 33 may not include the mask layer opening 22d, but the second metal layer 22 may include the opening region portion 22b (see Fig. 3).

A twelfth modification will now be described.

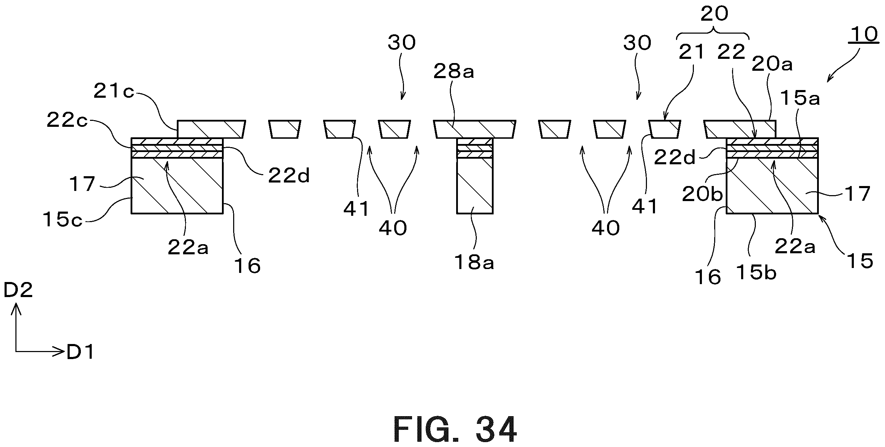

In an example according to the present embodiment described above, the outer edge 21c of the first metal layer 21 overlaps the outer edge 22c of the second metal layer 22 in a plan view. The present disclosure, however, is not limited thereto. For example, as illustrated in Fig. 34, the outer edge 21c of the first metal layer 21 may be located inside the outer edge 22c of the second metal layer 22. In other words, the second metal layer 22 extends outward beyond the outer edge 21c of the first metal layer 21 and is exposed. This enables a step to be formed by the first metal layer 21 and the second metal layer 22 and enables the thickness H3 (see Fig. 3) of the first metal layer 21 to be easily measured. A portion of the second metal layer 22 may extend outward beyond the outer edge 21c of the first metal layer 21 in a plan view. In this case, the step can be formed at a portion of the outer edge 21c of the first metal layer 21 in a plan view. However, the second metal layer 22 may entirely extend outward beyond the outer edge 21c of the first metal layer 21 in a plan view. In this case, the step can be formed over the entire circumference of the outer edge 21c of the first metal layer 21 in a plan view.

At the first metal layer formation step at which the first metal layer 21 is formed, a resist layer, not illustrated, may be formed on the surface of the second metal layer 22 opposite the mask substrate 15 in advance. The resist layer is located in a region close to the outer edge 22c of the second metal layer 22. This enables the first metal layer 21 that includes the outer edge 21c described above to be formed.

The outer edge 21c of the first metal layer 21 is thus located inside the outer edge 22c of the second metal layer 22, and consequently, the thickness H3 of the first metal layer 21 can be easily measured.

In an example according to the twelfth modification described above, the outer edge 21c of the first metal layer 21 of the vapor deposition mask 10 according to the tenth modification illustrated in Fig. 25 and Fig. 26 is located inside the outer edge 22c of the second metal layer 22. The present disclosure, however, is not limited thereto. For example, the outer edge 21c of the first metal layer 21 of the vapor deposition mask 10 illustrated in Fig. 3 may be located inside the outer edge 22c of the second metal layer 22, and the outer edge 21c of the first metal layer 21 of the vapor deposition mask 10 according to another modification may be located inside the outer edge 22c of the second metal layer 22. For example, the second metal layer 22 illustrated in Fig. 34 may not include the mask layer opening 22d, but the second metal layer 22 may include the opening region portion 22b (see Fig. 3).

A thirteenth modification will now be described.

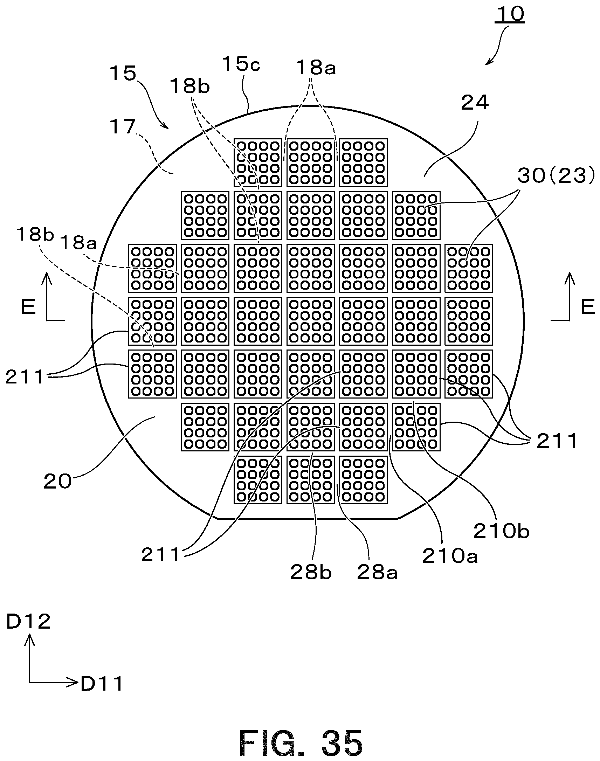

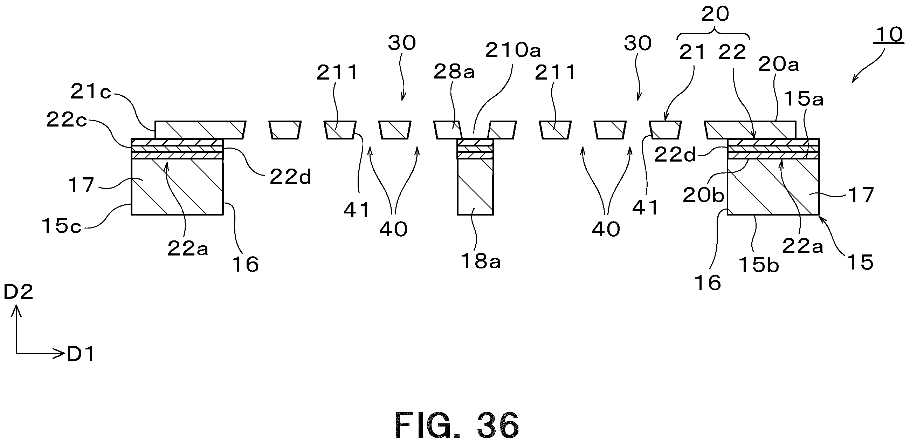

In an example according to the present embodiment described above, the mask sash bars 28a and 28b of the first metal layer 21 are formed on the first substrate sash bars 18a and the second substrate sash bars 18b of the mask substrate 15. The present disclosure, however, is not limited thereto. For example, as illustrated in Fig. 35 and Fig. 36, metal grooves 210a and 210b may be formed in the mask sash bars 28a and 28b of the first metal layer 21. The metal grooves 210a and 210b may extend through the first metal layer 21. The metal grooves 210a and 210b may not be formed in the second metal layer 22.

As illustrated in Fig. 35 and Fig. 36, multiple first metal grooves 210a and multiple second metal grooves 210b may be formed in the first metal layer 21. The first metal grooves 210a may be formed in the first mask sash bars 28a and may overlap the first substrate sash bars 18a in a plan view. The first metal grooves 210a may extend in the second direction D12 and may be arranged in the first direction D11. The second metal grooves 210b may be formed in the second mask sash bars 28b and may overlap the second substrate sash bars 18b in a plan view. The second metal grooves 210b may extend in the first direction D11 and may be arranged in the second direction D12.

In an example illustrated in Fig. 35 and Fig. 36, the first metal layer 21 may include multiple metal islands 211. The metal islands 211 are examples of a body island. The metal islands 211 may be defined by the first metal grooves 210a and the second metal grooves 210b. The metal islands 211 may be formed for every one of the through-hole groups 30 (or the effective regions 23). One of the through-hole groups 30 may be formed on one of the metal islands 211. Alternatively, two or more through-hole groups 30 may be formed on one of the metal islands 211. The metal islands 211 may have a rectangular shape in a plan view. In an example illustrated in Fig. 35, the multiple metal islands 211 are formed on the second metal layer 22. The first metal layer 21 may not be formed outside the metal island 211 that is located at the outermost position in a plan view among the multiple metal islands 211. In this case, the second metal layer 22 is exposed, and the same step as that in Fig. 34 is formed by the first metal layer 21 and the second metal layer 22.

The metal grooves 210a and 210b may be formed in the first metal layer 21 by etching. Alternatively, the metal grooves 210a and 210b may be formed by irradiating the first metal layer 21 with laser light.

The metal grooves 210a and 210b are thus formed in the first metal layer 21, and consequently, the first metal layer 21 can be divided. For this reason, a warp that is generated on the first metal layer 21 can be divided, and the vapor deposition mask 10 can be inhibited from warping.

In an example according to the thirteenth modification described above, the metal grooves 210a and 210b are formed in the first metal layer 21 of the vapor deposition mask 10 according to the tenth modification illustrated in Fig. 25 and Fig. 26. The present disclosure, however, is not limited thereto. For example, the metal grooves 210a and 210b may be formed in the first metal layer 21 of the vapor deposition mask 10 illustrated in Fig. 3, or the metal grooves 210a and 210b may be formed in the first metal layer 21 of the vapor deposition mask 10 according to another modification. For example, the second metal layer 22 illustrated in Fig. 36 may not include the mask layer opening 22d, but the second metal layer 22 may include the opening region portion 22b (see Fig. 3).

A fourteenth modification will now be described.

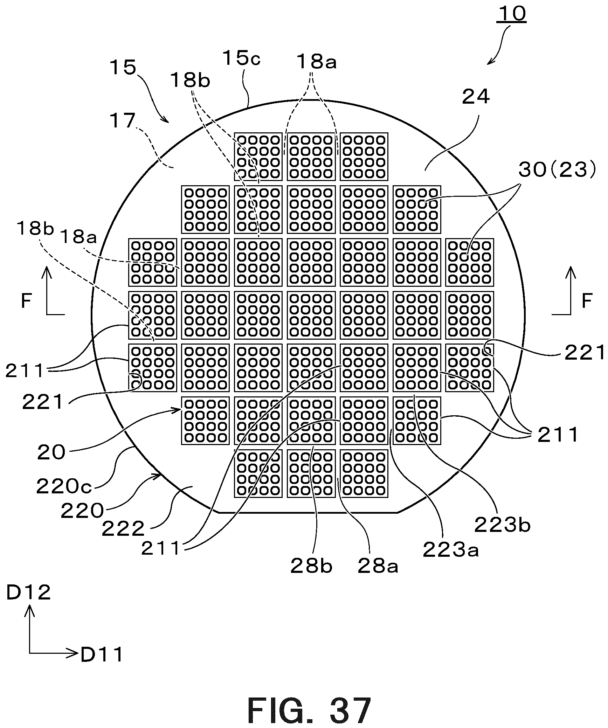

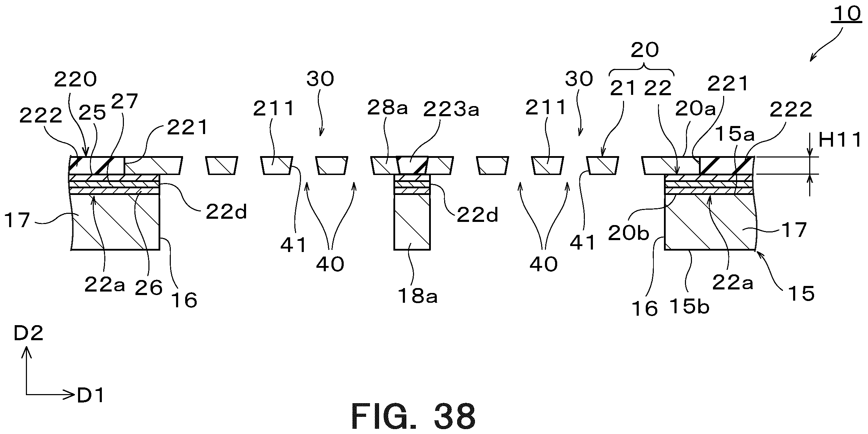

In an example according to the thirteenth modification described above, the metal grooves 210a and 210b are formed in the first metal layer 21. The present disclosure, however, is not limited thereto. For example, as illustrated in Fig. 37 and Fig. 38, a mask insulating layer 220 may be formed in the metal grooves 210a and 210b.

More specifically, the mask layer 20 of the vapor deposition mask 10 illustrated in Fig. 37 and Fig. 38 may include the mask insulating layer 220. The mask insulating layer 220 is near the first surface 20a of the mask layer 20. The mask insulating layer 220 may form the first surface 20a. The mask insulating layer 220 may be located between two metal islands 211 adjacent to each other. In other words, the mask insulating layer 220 may be located between two through-hole groups 30 (or the effective regions 23) adjacent to each other. The mask insulating layer 220 may extend through the first metal layer 21.

More specifically, the mask insulating layer 220 is formed in the first metal grooves 210a of the first metal layer 21 and is formed in the second metal grooves 210b. In other words, the mask insulating layer 220 is formed between the two metal islands 211 adjacent to each other described above. The mask insulating layer 220 is formed also outside the metal island 211 that is located at the outermost position in a plan view among the multiple metal islands 211. In this way, the mask insulating layer 220 is formed around the metal islands 211. The mask insulating layer 220 may not be divided but may be continuously formed.

The thickness H11 of the mask insulating layer 220 may be equal to the thickness H3 (see Fig. 3) of the first metal layer 21 described above, and a difference from the thickness H3 may be 1.0 µm or less.

The mask insulating layer 220 may have characteristics regarding stress different from those of the first metal layer 21. For example, in the case where the first metal layer 21 applies tensile stress to the mask substrate 15, the mask insulating layer 220 may be configured to apply compressive stress to the mask substrate 15. In this case, force that is applied by the first metal layer 21 to the mask substrate 15 can be at least partly canceled by the mask insulating layer 220. For this reason, the vapor deposition mask 10 can be inhibited from warping. The material of the mask insulating layer 220 may have insulating properties. For example, the mask insulating layer 220 may contain an insulating oxide. An example of the oxide may be a silicon oxide or a silicon dioxide.

A method of manufacturing the vapor deposition mask 10 illustrated in Fig. 37 and Fig. 38 will now be described.

The mask substrate 15 on which the second metal layer 22 is formed is first prepared by performing the second metal layer formation step illustrated in Fig. 7 as described above.

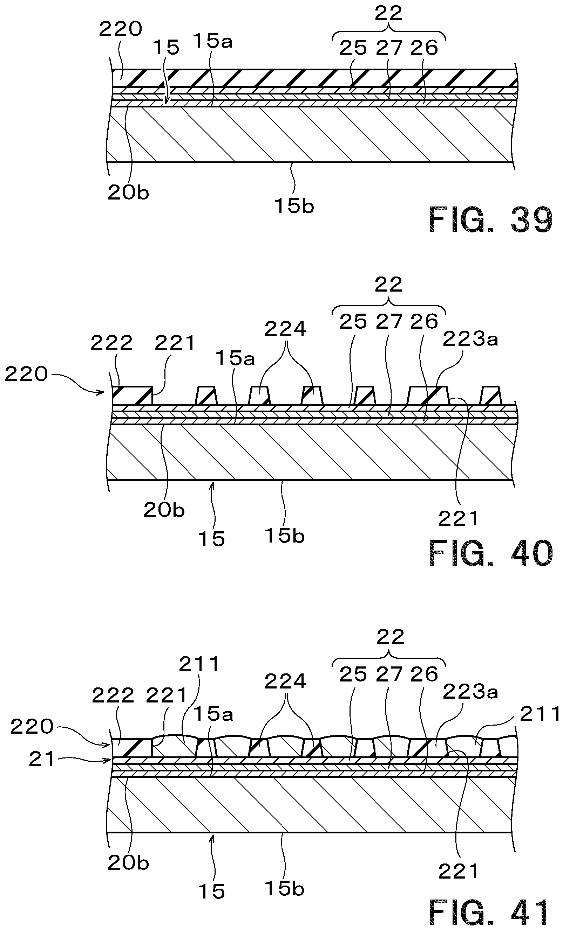

Subsequently, as illustrated in Fig. 39, the mask insulating layer 220 is formed on the second metal layer 22 at an insulating layer formation step. The mask insulating layer 220 may be formed on the whole of the surface of the second metal layer 22 opposite the mask substrate 15. The mask insulating layer 220 may be formed by using a chemical vapor deposition method. For example, the mask insulating layer 220 is formed by using the chemical vapor deposition method in which tetraethyl orthosilicate Si (OC₂H₅)₄ is used as a material. Tetraethyl orthosilicate is also referred to as TEOS.

At an insulating opening formation step after the insulating layer formation step, as illustrated in Fig. 40, multiple insulating openings 221 are formed in the mask insulating layer 220. The multiple insulating openings 221 may be arranged in the first direction D11 and the second direction D12. The multiple insulating openings 221 have contours that correspond to the metal islands 211 of the first metal layer 21 described above in a plan view. The planar shape of the contour of each insulating opening 221 may be a rectangular shape. Four corners of the contour of the insulating opening 221 may curve although this is not illustrated. The contour of the insulating opening 221 may be another shape such as a circular shape. The contour of the insulating opening 221 may surround the contour of the substrate opening 16 that is formed at a subsequent step. The planar shape of the contour of the insulating opening 221 may be similar to the planar shape of the contour of the substrate opening 16.

The mask insulating layer 220 may include an insulating frame body 222 that has a planar shape that is formed along an outer edge 220c of the mask insulating layer 220 and insulating sash bars 223a and 223b that define the contours of the insulating openings 221. The insulating frame body 222 is an example of an insulating body. The insulating openings 221 may be defined inside the insulating frame body 222.

The insulating sash bars 223a and 223b may include first insulating sash bars 223a that are arranged in the first direction D11 and second insulating sash bars 223b that are arranged in the second direction D12. The first insulating sash bars 223a may extend in the second direction D12. The first insulating sash bars 223a may overlap the first substrate sash bars 18a described above in a plan view. The second insulating sash bars 223b may extend in the first direction D11. The second insulating sash bars 223b may overlap the second substrate sash bars 18b described above in a plan view. The insulating sash bars 223a and 223b may extend through the first metal layer 21.

The insulating sash bars 223a and 223b are connected to the insulating frame body 222. The insulating sash bars 223a and 223b are located between the insulating openings 221 adjacent to each other in a plan view. Fig. 38 illustrates the first insulating sash bars 223a, and the first insulating sash bars 223a extend in the direction perpendicular to the paper. Both ends of each first insulating sash bar 223a are connected to the insulating frame body 222 so as to be continuous thereto. The second insulating sash bars 223b extend in a left-right direction in Fig. 38 although this is not illustrated in Fig. 38. Both ends of each second insulating sash bar 223b are connected to the insulating frame body 222 so as to be continuous. In this way, the multiple insulating openings 221 are defined by the first insulating sash bars 223a that extend in the second direction D12 and the second insulating sash bars 223b that extend in the first direction D11 in a plan view.

As illustrated in Fig. 40, the mask insulating layer 220 may include multiple insulating islands 224 that are located in the insulating openings 221. The through-holes 40 of the mask layer 20 described above are formed at the positions of the insulating islands 224. A method of forming the insulating openings 221 in the mask insulating layer 220 is not particularly limited. For example, the insulating openings 221 may be formed by dry etching in which etching gas is used. The dry etching may be reactive-ion etching.

At the first metal layer formation step after the insulating layer formation step, as illustrated in Fig. 41, the first metal layer 21 is formed in the insulating openings 221. More specifically, the first metal layer 21 is formed on the surface of the second metal layer 22 opposite the mask substrate 15. The first metal layer 21 may be formed by performing the plating process in the same manner as in that at the first metal layer formation step illustrated in Fig. 8 and Fig. 18. In this case, the components of the plating solution precipitate on portions of the insulating openings 221 of the mask insulating layer 220 at which the insulating islands 224 are not formed. In this way, the precipitating components form the metal islands 211 of the first metal layer 21 on the second metal layer 22. The through-holes 40 are formed in the metal islands 211 that are formed in this way so as to correspond to the insulating islands 224. That is, at the first metal layer formation step, the through-holes 40 are formed. The metal islands 211 of the first metal layer 21 may project upward from the insulating openings 221 in the thickness direction D2 of the mask layer 20.

After the first metal layer 21 is formed, the annealing treatment may be performed on the first metal layer 21 in the same manner as in that at the first metal layer formation step illustrated in Fig. 8.

At a polishing step after the first metal layer formation step, as illustrated in Fig. 42, the first metal layer 21 may be polished by performing the chemical mechanical polishing. The polishing step may be performed until the polishing surface of a polisher reaches the surface of the mask insulating layer 220 opposite the second metal layer 22 in the thickness direction D2. This enables the surface of the first metal layer 21 opposite the second metal layer 22 to be flush with the surface of the mask insulating layer 220 opposite the second metal layer 22. The uniformness of the thickness H3 of the first metal layer 21 can be improved, and the flatness of the first surface 20a of the mask layer 20 can be improved.

At an insulating layer removal step after the polishing step, a portion of the mask insulating layer 220 is removed. At the insulating layer removal step, as illustrated in Fig. 43, a first mask protection layer 225 that covers the insulating frame body 222 and the insulating sash bars 223a and 223b in the mask insulating layer 220 may be formed at a first mask protection layer formation step. The first mask protection layer 225 may not cover the insulating islands 224. The first mask protection layer 225 may not cover the first metal layer 21 that surrounds the multiple insulating islands 224.

The first mask protection layer 225 may have resistance against the etching solution for removing the mask insulating layer 220. For example, in the case where the etching solution contains buffered hydrofluoric acid, the first mask protection layer 225 may contain resin that has resistance against hydrofluoric acid. For example, the first mask protection layer 225 may contain photoresist that has resistance against hydrofluoric acid. For example, the photoresist may contain polyimide. A buffered hydrofluoric acid solution may be a solution that contains hydrofluoric acid and ammonium fluoride.

Subsequently, the mask insulating layer 220 is immersed in the etching solution such as the buffered hydrofluoric acid solution at the insulating layer removal step. Consequently, as illustrated in Fig. 44, the multiple insulating islands 224 that are not covered by the first mask protection layer 225 are removed. Subsequently, the first mask protection layer 225 may be removed.

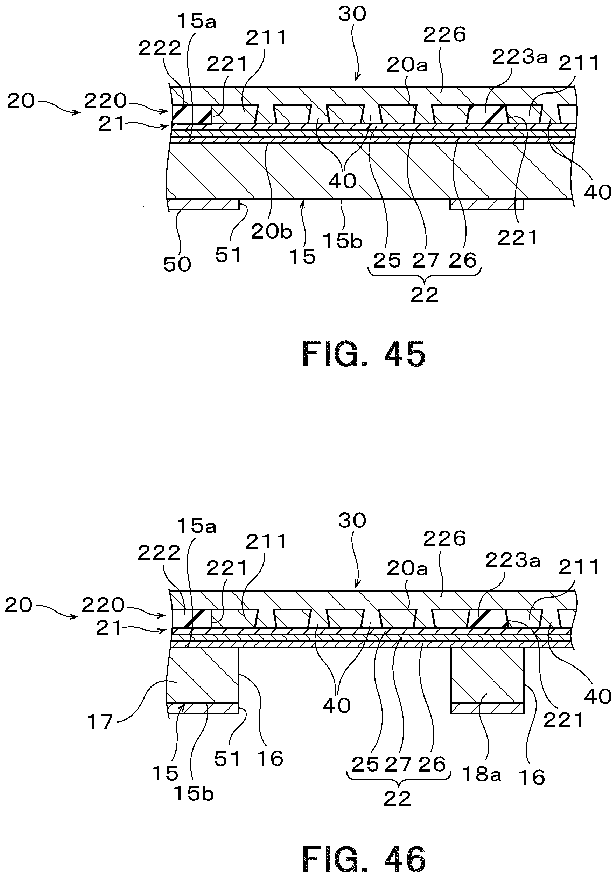

At the substrate opening formation step after the insulating layer removal step, the substrate opening 16 is formed in the mask substrate 15. At the substrate opening formation step, as illustrated in Fig. 45, the resist layer 50 may be formed on the second substrate surface 15b of the mask substrate 15 in the same manner as in that at the resist layer formation step illustrated in Fig. 9. At a second mask protection layer formation step, as illustrated in Fig. 45, a second mask protection layer 226 that covers the first metal layer 21 and the mask insulating layer 220 may be formed.

Subsequently, at the substrate opening formation step, as illustrated in Fig. 46, the mask substrate 15 may be etched in the same manner as in that at the substrate etching step illustrated in Fig. 10, and the substrate opening 16 may be formed.

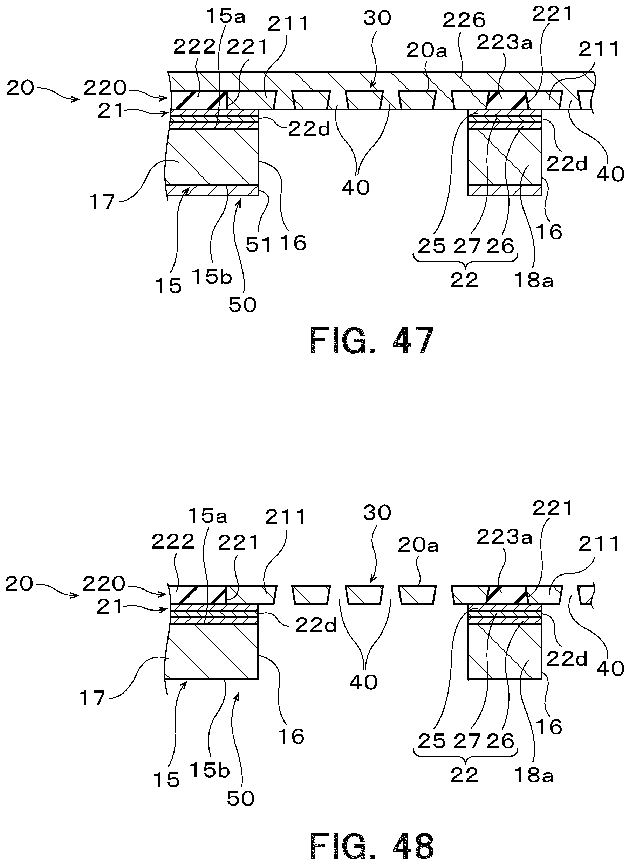

At the mask layer opening formation step after the substrate opening formation step, as illustrated in Fig. 47, the mask layer opening 22d is formed in the second metal layer 22. At the mask layer opening formation step, the second metal layer 22 may be etched in the same manner as in that at the mask layer opening formation step illustrated in Fig. 21, and the mask layer opening 22d may be formed.

At a second protection layer removal step after the mask layer opening formation step, as illustrated in Fig. 48, the resist layer 50 and the second mask protection layer 226 may be removed.

In this way, the vapor deposition mask 10 illustrated in Fig. 37 and Fig. 38 is obtained.

In some cases, the first metal layer 21 is formed above the mask substrate 15 in an environment at a temperature higher than the room temperature. For example, a plating step or an annealing step is performed in an environment at a temperature higher than the room temperature. When the temperatures of the mask substrate 15 and the first metal layer 21 reduce to the room temperature, the mask substrate 15 and the first metal layer 21 contract. In the case where the thermal expansion coefficient of the first metal layer 21 is higher than the thermal expansion coefficient of the mask substrate 15, the degree of the contraction of the first metal layer 21 is higher than the degree of the contraction of the mask substrate 15. For this reason, the first metal layer 21 applies tensile stress to the mask substrate 15.

The mask insulating layer 220 is formed above the mask substrate 15 in an environment at a temperature higher than the room temperature. For example, a chemical vapor deposition step is performed in an environment at a temperature higher than the room temperature. When the temperatures of the mask substrate 15 and the mask insulating layer 220 reduce to the room temperature, the mask substrate 15 and the mask insulating layer 220 contract. In the case where the thermal expansion coefficient of the mask insulating layer 220 is lower than the thermal expansion coefficient of the mask substrate 15, the degree of the contraction of the mask insulating layer 220 is lower than the degree of the contraction of the mask substrate 15. For this reason, the mask insulating layer 220 applies compressive stress to the mask substrate 15.

As for the vapor deposition mask 10 illustrated in Fig. 37 and Fig. 38, the first metal layer 21 and the mask insulating layer 220 are formed above the mask substrate 15. For this reason, the compressive stress that is applied by the mask insulating layer 220 to the mask substrate 15 can partly cancel out the tensile stress that is applied by the first metal layer 21 to the mask substrate 15. As a result, the vapor deposition mask 10 can be inhibited from warping.

At the first metal layer formation step illustrated in Fig. 41 described above, the first metal layer 21 may be formed by performing another process other than the plating process. For example, the first metal layer 21 may be formed by using a physical film formation method. Examples of the physical film formation method may include the spattering method, the vapor deposition method, and an ion plating method. At a physical film formation step, the first metal layer 21 may be formed not only in the insulating openings 221 but also on the insulating frame body 222 of the mask insulating layer 220 and the insulating sash bars 223a and 223b.

An oxide film may be formed on the first substrate surface 15a and the second substrate surface 15b of the mask substrate 15 that is prepared before the insulating layer formation step illustrated in Fig. 39 described above. The oxide film may be formed by performing a thermal oxidation treatment on the mask substrate 15. In the thermal oxidation treatment, the mask substrate 15 is heated, and consequently, the first substrate surface 15a and the second substrate surface 15b of the mask substrate 15 are oxidized. The oxide film that is formed on the second substrate surface 15b may be removed after the first metal layer formation step.

A fifteenth modification will now be described.

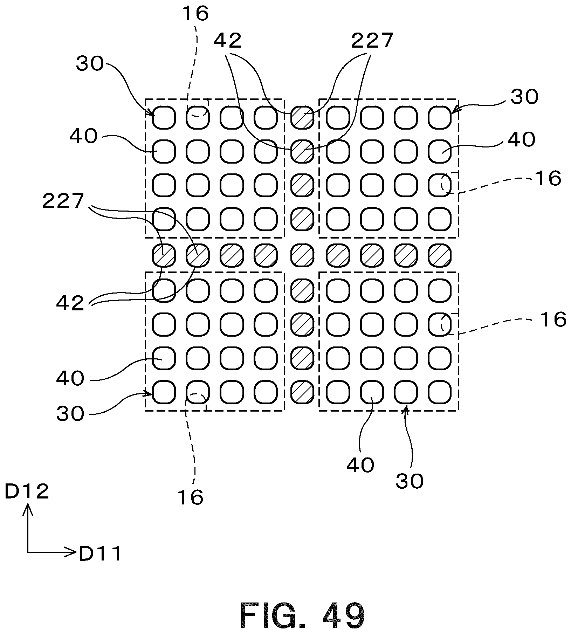

In an example according to the fourteenth modification described above, the mask insulating layer 220 includes the first insulating sash bars 223a and the second insulating sash bars 223b. The present disclosure, however, is not limited thereto. For example, as illustrated in Fig. 49, the mask insulating layer 220 may not include the first insulating sash bars 223a or the second insulating sash bars 223b. The mask insulating layer 220 may not include the insulating frame body 222 or may include the insulating frame body 222.

More specifically, as illustrated in Fig. 49, sash bar through-holes 42 that are located above the substrate sash bars 18a and 18b of the mask substrate 15 may be formed in the first metal layer 21. The sash bar through-holes 42 may not overlap the substrate opening 16 of the mask substrate 15 in a plan view. The sash bar through-holes 42 may be located between two through-hole groups 30 (or the effective regions 23) adjacent to each other. The sash bar through-holes 42 may be formed in the same manner as the through-holes 40. The sash bar through-holes 42 may extend through the first metal layer 21.

The mask insulating layer 220 may include multiple insulating sash bar islands 227 that are located in the respective sash bar through-holes 42 described above. The insulating sash bar islands 227 may be imbedded in the sash bar through-holes 42. The insulating sash bar islands 227 may be located between two metal islands 211 adjacent to each other. The insulating sash bar islands 227 may extend through the first metal layer 21.

The insulating sash bar islands 227 are formed at positions that correspond to those of the substrate sash bars 18a and 18b of the mask substrate 15 at the insulating layer formation step illustrated in Fig. 40 described above. The insulating sash bar islands 227 may have the same shape as those of the insulating islands 224 described above. At the first mask protection layer formation step illustrated in Fig. 43, the first mask protection layer 225 is formed on the insulating sash bar islands 227. Subsequently, steps illustrated in Fig. 44 to Fig. 48 are performed, and consequently, the vapor deposition mask 10 that includes the insulating sash bar islands 227 that are located on the substrate sash bars 18a and 18b is obtained.

According to the present modification, the sash bar through-holes 42 that are located above the substrate sash bars 18a and 18b of the mask substrate 15 are formed in the first metal layer 21. This enables a region of the first metal layer 21 between two through-hole groups 30 adjacent to each other can have the same structure as that of the first metal layer 21 in the through-hole groups 30 (or the effective regions 23). For this reason, the uniformness of the structure of the first metal layer 21 can be improved. As a result, the uniformness of an electric current that is supplied for plating can be improved, and the uniformness of the thickness H3 of the first metal layer 21 can be improved. At the polishing step described above, the uniformness of chemical mechanical polishing on the first metal layer 21 can be improved.

A sixteenth modification will now be described.

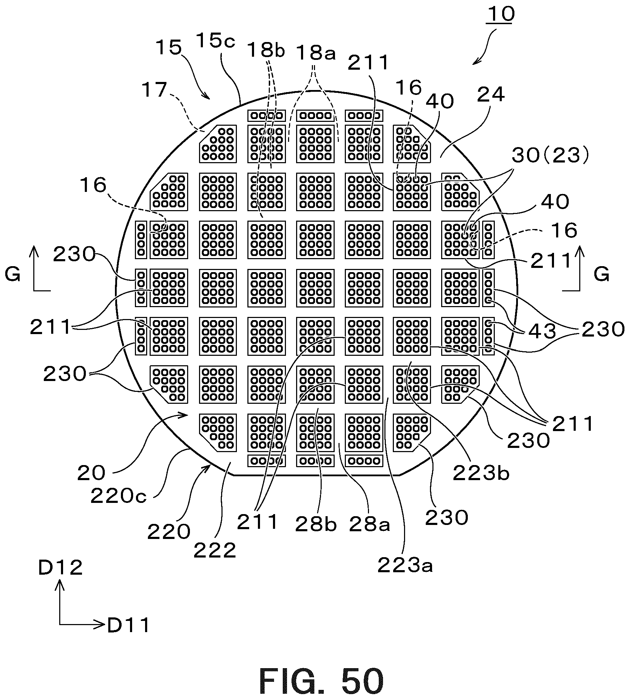

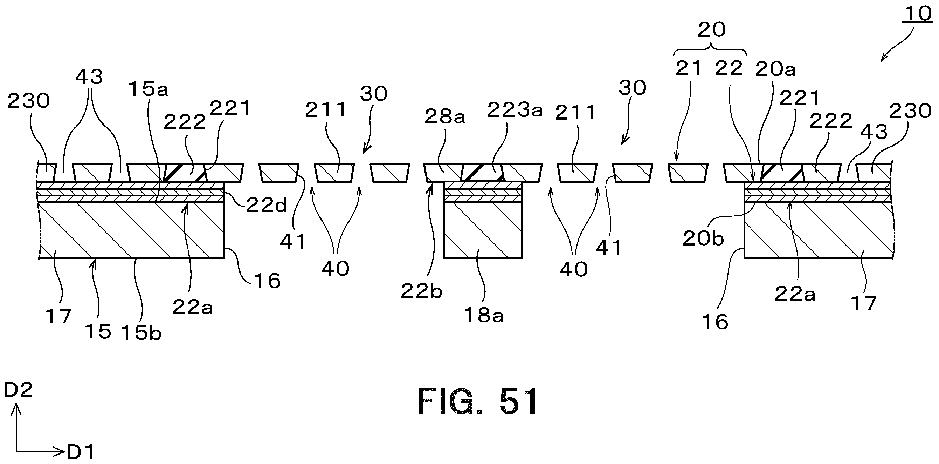

In an example according to the fourteenth modification described above, the first metal layer 21 includes the multiple metal islands 211. The present disclosure, however, is not limited thereto. For example, as illustrated in Fig. 50 and Fig. 51, the first metal layer 21 may include dummy metal islands 230.

More specifically, in an example illustrated in Fig. 50 and Fig. 51, the first metal layer 21 includes the multiple metal islands 211 and the multiple dummy metal islands 230. The through-holes 40 that are located at the metal islands 211 overlap the substrate openings 16. The dummy metal islands 230 are examples of a dummy body island. The dummy metal islands 230 are located between the metal islands 211 and the outer edge 15c of the mask substrate 15 in a plan view. The dummy metal islands 230 may not overlap the substrate openings 16 of the mask substrate 15 in a plan view. The dummy metal islands 230 may overlap the substrate frame body 17 of the mask substrate 15.

Dummy through-holes 43 that extend through the first metal layer 21 may be formed in the dummy metal islands 230. In a plan view, the dummy through-holes 43 may overlap the substrate openings 16 of the mask substrate 15 or may overlap the substrate frame body 17.

The dummy metal islands 230 may be separated from the metal islands 211 adjacent to each other in a plan view. The mask insulating layer 220 may be located between the dummy metal islands 230 and the metal islands 211. However, the dummy metal islands 230 and the metal islands 211 adjacent to each other may be connected to each other or may be formed so as to be continuous.

In the case where the first metal layer 21 is polished by chemical mechanical polishing as in that at the polishing step illustrated in Fig. 42 described above, the thickness H3 of the first metal layer 21 after polishing is not uniform depending on the position in some cases. For example, in the case where the multiple metal islands 211 are formed on the mask substrate 15, the thicknesses of the metal islands 211 close to the outer edge 15c of the mask substrate 15 can be greater than the thicknesses of the metal islands 211 close to the center of the mask substrate 15. In other words, the metal islands 211 close to the outer edge 15c of the mask substrate 15 are not sufficiently polished in some cases.

According to the present modification, the dummy metal islands 230 are located outside the metal islands 211 in a plan view. Consequently, a region that is not sufficiently polished is more likely to remain at the dummy metal islands 230 than the metal islands 211. For this reason, according to the present modification, the metal islands 211 can be inhibited from being insufficiently polished. In addition, at the first metal layer formation step described above, the first metal layer 21 can be formed also in a region that overlaps the substrate frame body 17 of the mask substrate 15. For this reason, the first metal layer 21 can be formed in a wide region on the surface of the second metal layer 22 opposite the mask substrate 15. In this case, the uniformness of the electric current that is supplied for plating can be improved, and the uniformness of the thickness H3 of the first metal layer 21 can be improved. At the polishing step described above, the uniformness of chemical mechanical polishing on the first metal layer 21 can be improved.

The modifications to the embodiment described above are described, and the multiple modifications can naturally be appropriately combined and used.

## Claims

1. A vapor deposition mask comprising:
a mask substrate that contains silicon;
a mask layer that includes a first surface and a second surface that is located opposite the first surface and that faces the mask substrate; and
a through-hole that extends through the mask layer,
wherein the mask substrate includes a substrate opening,
wherein the through-hole is located in the substrate opening in a plan view,
wherein the mask layer includes a mask body layer that forms the first surface and a mask intermediate layer that is located between the mask body layer and the mask substrate, and
wherein the mask body layer contains a metal material.

2. The vapor deposition mask according to claim 1, wherein a thickness of the mask intermediate layer is less than a thickness of the mask body layer.

3. The vapor deposition mask according to claim 1 or 2, wherein the mask intermediate layer includes a substrate-facing layer that contains gold, aluminum, chromium, nickel, titanium, titanium nitride, an aluminum alloy that contains neodymium, a silicon oxide, or a silicon dioxide, and
wherein the substrate-facing layer is in contact with the mask body layer and is in contact with the mask substrate.

4. The vapor deposition mask according to claim 1 or 2, wherein the mask intermediate layer includes a body-facing layer that faces the mask body layer and a substrate-facing layer that faces the mask substrate, and
wherein the body-facing layer and the substrate-facing layer are composed of different metal materials.

5. The vapor deposition mask according to claim 4, wherein the substrate-facing layer contains gold, aluminum, chromium, nickel, titanium, titanium nitride, an aluminum alloy that contains neodymium, a silicon oxide, or a silicon dioxide.

6. The vapor deposition mask according to claim 4, wherein the body-facing layer contains titanium, copper, nickel, or gold.

7. The vapor deposition mask according to claim 4, wherein the mask intermediate layer includes an intermediate layer that is located between the substrate-facing layer and the body-facing layer, and
wherein the intermediate layer is composed of a metal material that differs from those of the body-facing layer and the substrate-facing layer.

8. The vapor deposition mask according to claim 7, wherein the intermediate layer contains titanium, titanium nitride, aluminum, an aluminum alloy that contains neodymium, a silicon oxide, a silicon dioxide, nickel, copper, chromium, or gold.

9. The vapor deposition mask according to claim 1 or 2, wherein the metal material of the mask body layer is a magnetic metal material.

10. The vapor deposition mask according to claim 1 or 2, wherein the mask substrate includes a substrate body that defines the substrate opening,
wherein the mask intermediate layer includes a body region portion that is located between the mask body layer and the substrate body and an opening region portion that is located in the substrate opening in a plan view, and
wherein the through-hole extends through the mask body layer and the opening region portion.

11. The vapor deposition mask according to claim 10, wherein an opening dimension of the through-hole in a predetermined direction at the second surface is larger than an opening dimension of the through-hole in the predetermined direction at the first surface.

12. The vapor deposition mask according to claim 1 or 2, wherein the mask substrate includes a substrate body that defines the substrate opening,
wherein the mask intermediate layer includes a body region portion that is located between the mask body layer and the substrate body and a mask layer opening that is formed along the substrate opening in a plan view, and
wherein the through-hole extends through the mask body layer.

13. The vapor deposition mask according to claim 12, wherein an opening dimension of the through-hole in a predetermined direction at a surface of the mask body layer facing the mask substrate is larger than an opening dimension of the through-hole in the predetermined direction at the first surface.

14. The vapor deposition mask according to claim 1 or 2, wherein the mask layer includes two or more of the through-holes, and
wherein the two or more of the through-holes are located in the substrate opening in a plan view.

15. The vapor deposition mask according to claim 14, wherein the mask layer includes two or more through-hole groups that are formed by the two or more of the through-holes, and
wherein the two or more through-hole groups are located in the substrate opening in a plan view.

16. The vapor deposition mask according to claim 14, wherein the mask substrate includes two or more of the substrate openings,
wherein the mask layer includes two or more through-hole groups that are formed by the two or more of the through-holes, and
wherein the two or more through-hole groups are located in each substrate opening in a plan view.

17. The vapor deposition mask according to claim 14, wherein the mask substrate includes two or more of the substrate openings,
wherein the mask layer includes two or more through-hole groups that are formed by the two or more of the through-holes, and
wherein a corresponding one of the through-hole groups is located in each substrate opening in a plan view.

18. The vapor deposition mask according to claim 1 or 2, wherein the substrate opening has a rectangular shape in a plan view, and
wherein curved portions are provided at four corners of a contour of the substrate opening in a plan view.

19. The vapor deposition mask according to claim 1 or 2, wherein a first alignment mark is provided on a surface of the mask substrate opposite the mask layer.

20. The vapor deposition mask according to claim 19, wherein the mask substrate includes a substrate body that defines the substrate opening and an inner projecting portion that projects inward from the substrate body in a plan view, and
wherein the first alignment mark is located on the inner projecting portion.

21. The vapor deposition mask according to claim 19, wherein a second alignment mark is provided at a position nearer than the first alignment mark to the through-hole.

22. The vapor deposition mask according to claim 21, wherein the mask layer includes two or more of the through-holes, two or more through-hole groups that are formed by the two or more of the through-holes and a mask sash bar that is provided between the through-hole groups adjacent to each other, and
wherein the second alignment mark is located on the mask sash bar.

23. The vapor deposition mask according to claim 22, wherein the mask sash bar includes a first mask sash bar and a second mask sash bar that extend in respective directions perpendicular to each other in a plan view, and
wherein the second alignment mark is located at an intersecting portion at which the first mask sash bar and the second mask sash bar intersect with each other.

24. The vapor deposition mask according to claim 1 or 2, wherein an outer edge of the mask body layer is located inside an outer edge of the mask intermediate layer in a plan view.

25. The vapor deposition mask according to claim 1 or 2, wherein the mask body layer includes two or more body islands, and
wherein a groove that extends through the mask body layer is located between two of the body islands adjacent to each other.

26. The vapor deposition mask according to claim 1 or 2, wherein the mask layer includes a mask insulating layer that forms the first surface,
wherein the mask body layer includes two or more body islands, and
wherein the mask insulating layer is located between two of the body islands adjacent to each other.

27. The vapor deposition mask according to claim 14, wherein the mask layer includes two or more through-hole groups that are formed by the two or more of the through-holes,
wherein the mask layer includes a mask insulating layer that forms the first surface, and
wherein the mask insulating layer is located between two of the through-hole groups adjacent to each other.

28. The vapor deposition mask according to claim 1 or 2, wherein the mask body layer includes a dummy body island that does not overlap the substrate opening in a plan view.

29. A framed vapor deposition mask comprising:
the vapor deposition mask according to claim 1 or 2; and
a frame that supports the mask substrate of the vapor deposition mask.

30. A method of manufacturing a vapor deposition mask, the method comprising:
a substrate preparation step of preparing a mask substrate that contains silicon;
a mask layer formation step of forming a mask layer that includes a first surface and a second surface that is located opposite the first surface and that faces the mask substrate on the mask substrate;
a substrate opening formation step of forming a substrate opening in the mask substrate; and
a through-hole formation step of forming a through-hole that extends through the mask layer,
wherein the through-hole is located in the substrate opening in a plan view,
wherein the mask layer formation step includes a mask intermediate layer formation step of forming a mask intermediate layer on a surface of the mask substrate facing the mask layer and a mask body layer formation step of forming a mask body layer on a surface of the mask intermediate layer opposite the mask substrate, and
wherein the mask body layer contains a metal material.

31. The method according to claim 30, wherein at the through-hole formation step, the through-hole is formed by irradiating the mask layer with laser light.

32. The method according to claim 31, wherein the through-hole formation step is performed after the substrate opening formation step, and
wherein the second surface of the mask layer is irradiated with the laser light via the substrate opening.

33. The method according to claim 31 or 32, wherein the laser light is femtosecond laser light.

34. The method according to claim 31 or 32, wherein at the through-hole formation step, the mask layer is irradiated with the laser light via a mask hole that corresponds to the through-hole of a photo mask.

35. The method according to claim 34, wherein the photo mask includes a plurality of the mask holes, and
wherein at the through-hole formation step, the mask layer is irradiated with the laser light via the plurality of the mask holes of the photo mask.

36. The method according to claim 30 or 31, wherein the mask substrate includes a substrate body that defines the substrate opening,
wherein the mask intermediate layer includes a body region portion that is located between the mask body layer and the substrate body and an opening region portion that is located in the substrate opening in a plan view, and
wherein at the through-hole formation step, the through-hole is formed so as to extend through the mask body layer and the opening region portion.

37. The method according to claim 36, wherein an opening dimension of the through-hole in a predetermined direction at the second surface is larger than an opening dimension of the through-hole in the predetermined direction at the first surface.

38. The method according to claim 30 or 31, further comprising: a mask layer opening formation step of forming a mask layer opening in the mask intermediate layer along the substrate opening in a plan view after the substrate opening formation step, and
wherein at the through-hole formation step, the through-hole is formed so as to extend through the mask body layer.

39. The method according to claim 38, wherein an opening dimension of the through-hole in a predetermined direction at a surface of the mask body layer facing the mask substrate is larger than an opening dimension of the through-hole in the predetermined direction at the first surface.

40. A method of manufacturing a vapor deposition mask, the method comprising:
a substrate preparation step of preparing a mask substrate that contains silicon;
a mask layer formation step of forming a mask layer that includes a first surface and a second surface that is located opposite the first surface and that faces the mask substrate on the mask substrate;
a substrate opening formation step of forming a substrate opening in the mask substrate; and
a mask layer opening formation step of forming a mask layer opening in the mask layer along the substrate opening in a plan view,
wherein the mask layer formation step includes a mask intermediate layer formation step of forming a mask intermediate layer on a surface of the mask substrate facing the mask layer and a mask body layer formation step of forming a mask body layer on a surface of the mask intermediate layer opposite the mask substrate and of forming a through-hole that extends through the mask body layer,
wherein at the mask layer opening formation step, the mask layer opening is formed in the mask intermediate layer,
wherein the through-hole is located in the substrate opening in a plan view, and
wherein the mask body layer contains a metal material.

41. The method according to claim 40, wherein at the mask body layer formation step, a resist layer is patterned on the surface of the mask intermediate layer opposite the mask substrate so as to correspond to the through-hole.

42. The method according to claim 40 or 41, wherein an opening dimension of the through-hole in a predetermined direction at a surface of the mask body layer facing the mask substrate is larger than an opening dimension of the through-hole in the predetermined direction at the first surface.

43. The method according to claim 40, wherein at the mask body layer formation step, a mask insulating layer is patterned on the surface of the mask intermediate layer opposite the mask substrate so as to correspond to the through-hole,
wherein the mask body layer includes two or more body islands, and
wherein the mask insulating layer is located between two of the body islands adjacent to each other.

44. The method according to claim 30 or 40, wherein the metal material of the mask body layer is a magnetic metal material.

45. The method according to claim 30 or 40, wherein a thickness of the mask intermediate layer is less than a thickness of the mask body layer.

46. The method according to claim 30 or 40, wherein the substrate opening formation step includes a resist layer formation step of forming a resist layer that includes a resist opening on a surface of the mask substrate opposite the mask layer and a substrate etching step of forming the substrate opening by etching the mask substrate through the resist opening.

47. The method according to claim 46, wherein the mask intermediate layer includes a substrate-facing layer containing a material that is capable of ensuring adhesion to the mask substrate and that has resistance against an etching medium that is used at the substrate etching step.

48. The method according to claim 47, wherein the mask intermediate layer includes a body-facing layer that faces the mask body layer and that contains a material that is capable of ensuring adhesion to the mask body layer.

49. The method according to claim 48, wherein at the mask layer formation step, the mask body layer is formed by performing a plating process, and
wherein the mask intermediate layer includes an intermediate layer that is located between the substrate-facing layer and the body-facing layer and that contains a material that is capable of protecting the substrate-facing layer from a plating solution for forming the mask body layer.

50. The method according to claim 47, wherein the substrate-facing layer is in contact with the mask body layer and is in contact with the mask substrate.

51. The method according to claim 30 or 40, wherein at the mask layer formation step, the mask intermediate layer is formed by performing a sputtering process.

52. The method according to claim 30 or 40, wherein at the mask layer formation step, the mask intermediate layer is formed by performing a vapor deposition process.

53. The method according to claim 30 or 40, wherein the mask layer includes two or more of the through-holes, and
wherein the two or more of the through-holes are located in the substrate opening in a plan view.

54. The method according to claim 53, wherein the mask layer includes two or more through-hole groups that are formed by the two or more of the through-holes, and
wherein the two or more through-hole groups are located in the substrate opening in a plan view.

55. The method according to claim 53, wherein the mask substrate includes two or more of the substrate openings,
wherein the mask layer includes two or more through-hole groups that are formed by the two or more of the through-holes, and
wherein the two or more through-hole groups are located in each substrate opening in a plan view.

56. The method according to claim 53, wherein the mask substrate includes two or more of the substrate openings,
wherein the mask layer includes two or more through-hole groups that are formed by the two or more of the through-holes, and
wherein a corresponding one of the through-hole groups is located in each substrate opening in a plan view.

57. The method according to claim 30 or 40, wherein the substrate opening has a rectangular shape in a plan view, and
wherein curved portions are provided at four corners of a contour of the substrate opening in a plan view.

58. The method according to claim 30 or 40, further comprising: a step of forming a first alignment mark on a surface of the mask substrate opposite the mask layer.

59. The method according to claim 58, wherein the mask substrate includes a substrate body that defines the substrate opening and an inner projecting portion that projects inward from the substrate body in a plan view, and
wherein the first alignment mark is located on the inner projecting portion.

60. The method according to claim 58, further comprising: a step of forming a second alignment mark at a position nearer than the first alignment mark to the through-hole.

61. The method according to claim 60, wherein the mask layer includes two or more of the through-holes, two or more through-hole groups that are formed by the two or more of the through-holes and a mask sash bar that is provided between the through-hole groups adjacent to each other, and
wherein the second alignment mark is located on the mask sash bar.

62. The method according to claim 61, wherein the mask sash bar includes a first mask sash bar and a second mask sash bar that extend in respective directions perpendicular to each other in a plan view, and
wherein the second alignment mark is located at an intersecting portion at which the first mask sash bar and the second mask sash bar intersect with each other.

63. The method according to claim 30 or 40, wherein an outer edge of the mask body layer is located inside an outer edge of the mask intermediate layer in a plan view.

64. The method according to claim 30 or 40, wherein the mask body layer includes two or more body islands, and
wherein a groove that extends through the mask body layer is located between two of the body islands adjacent to each other.

65. The method according to claim 53, wherein the mask layer includes two or more through-hole groups that are formed by the two or more of the through-holes,
wherein the mask layer includes a mask insulating layer that forms the first surface, and
wherein the mask insulating layer is located between two of the through-hole groups adjacent to each other.

66. The method according to claim 30 or 40, wherein the mask body layer includes a dummy body island that does not overlap the substrate opening in a plan view.

67. A method of manufacturing an organic device, the method comprising:
a vapor deposition mask preparation step of preparing the vapor deposition mask by using the method according to claim 30 or 40;
a close contact step of causing the first surface of the mask layer of the vapor deposition mask to come into close contact with a vapor deposition substrate; and
a vapor deposition step of forming a vapor deposition layer in a manner in which a vapor deposition material is deposited on the vapor deposition substrate via the through-hole of the vapor deposition mask.

68. A method of manufacturing a framed vapor deposition mask, the method comprising:
a vapor deposition mask preparation step of preparing the vapor deposition mask by using the method according to claim 30 or 40; and
a frame attachment step of attaching a frame to the mask substrate of the vapor deposition mask.
